# EUROPÄISCHE PATENTSCHRIFT

(11) **EP 3 197 982 B1**
(45) Veröffentlichungstag und Bekanntmachung des Hinweises auf die Patenterteilung: **06.05.2020**
(21) Anmeldenummer: 15762485.9
(22) Anmeldetag: 25.08.2015
(51) Int. Cl.: C09K 11/06, H01L 51/50

(54) **MATERIALIEN FÜR ORGANISCHE ELEKTROLUMINESZENZVORRICHTUNGEN**
MATERIALS FOR ORGANIC ELECTROLUMINESCENT DEVICES
MATIÈRES POUR DISPOSITIFS ÉLECTROLUMINESCENTS ORGANIQUES

(30) Priorität: 24.09.2014 EP 14003299
(43) Veröffentlichungstag der Anmeldung: 02.08.2017
(73) Patentinhaber: Merck Patent GmbH, 64293 Darmstadt (DE)
(72) Erfinder: PARHAM, Amir Hossain, 60486 Frankfurt am Main (DE); PFLUMM, Christof, 64291 Darmstadt (DE); JATSCH, Anja, 60489 Frankfurt am Main (DE); EBERLE, Thomas, 76829 Landau (DE); KROEBER, Jonas Valentin, 60311 Frankfurt am Main (DE); LINGE, Rouven, 64291 Darmstadt (DE)
(86) Internationale Anmeldenummer: PCT/EP2015/001733
(87) Internationale Veröffentlichungsnummer: WO 2016/045765

(56) Entgegenhaltungen:
- JP-A- 2001 250 689
- US-A- 3 740 402
- US-A1- 2004 219 390
- US-A1- 2012 217 485
- EMILIYA V. NOSOVA ET AL: "3-Phenyl/Pyridinyl Derivatives of <i>Trans</i>-2-(aryl/heteryl)vinyl-3<i>H</ i>-quinazolin-4-ones: Synthesis and Fluorescent Properties", INTERNATIONAL JOURNAL OF ORGANIC CHEMISTRY, Bd. 02, Nr. 01, 1. März 2012 (2012-03-01), Seiten 56-63, XP055231215, US ISSN: 2161-4687, DOI: 10.4236/ijoc.2012.21010

## Beschreibung

Die vorliegende Erfindung beschreibt Mischungen von Quinazolinon-Derivaten und phosphoreszierende Dotanden, sowie die Verwendung von Quinazolinon-Derivaten und Triplettmatrixmaterialien in organischen Elektrolumineszenzvorrichtungen. Die Erfindung betrifft ferner ein Verfahren zur Herstellung der erfindungsgemäßen Verbindungen sowie elektronische Vorrichtungen enthaltend diese Verbindungen.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden häufig metallorganische Komplexe eingesetzt, die Phosphoreszenz statt Fluoreszenz zeigen. Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, insbesondere auch bei OLEDs, die Triplettemission (Phosphoreszenz) zeigen, immer noch Verbesserungsbedarf, beispielsweise im Hinblick auf Effizienz, Betriebsspannung und Lebensdauer.

Die Eigenschaften von phosphoreszierenden OLEDs werden nicht nur von den eingesetzten Triplettemittern bestimmt. Hier sind insbesondere auch die anderen verwendeten Materialien wie zum Beispiel Matrixmaterialien von besonderer Bedeutung. Verbesserungen dieser Materialien können somit auch zu deutlichen Verbesserungen der OLED-Eigenschaften führen.

Gemäß dem Stand der Technik werden unter anderem Indolocarbazolderivate (z. B. gemäß WO 2007/063754 oder WO 2008/056746) oder Indenocarbazolderivate (z. B. gemäß WO 2010/136109 oder WO 2011/000455), insbesondere solche, die mit elektronenarmen Heteroaromaten wie Triazin substituiert sind, als Matrixmaterialien für phosphoreszierende Emitter verwendet. Weiterhin werden beispielsweise Bisdibenzofuranderivate (z. B. gemäß EP 2301926) als Matrixmaterialien für phosphoreszierende Emitter verwendet. Allerdings besteht bei Verwendung dieser Matrixmaterialien noch Verbesserungsbedarf, insbesondere in Bezug auf die Effizienz, die Lebensdauer und die Betriebsspannung der Vorrichtung.

Die Verwendung von Quinazolinonderivate als Materialien für fluoreszierende OLEDs wird in JP2001250689A beschrieben.

Aufgabe der vorliegenden Erfindung ist die Bereitstellung von Verbindungen, welche sich für den Einsatz in phosphoreszierenden OLED eignen, insbesondere als Matrixmaterial. Insbesondere ist es die Aufgabe der vorliegenden Erfindung, Matrixmaterialien bereitzustellen, welche sich auch für grün und blau phosphoreszierende OLEDs eignen.

Es wurde überraschend gefunden, dass eine Mischung umfassend mindestens einen phosphoreszierenden Dotanden, welche Kupfer, Molybdän, Wolfram, Rhenium, Ruthenium, Osmium, Rhodium, Iridium, Palladium, Platin, Silber, Gold und/oder Europium enthält, und mindestens eine Verbindung gemäß der folgenden Formeln (3), Verbesserungen gegenüber dem Stand der Technik aufweist, insbesondere beim Einsatz in organischen Elektrolumineszenz-vorrichtungen: 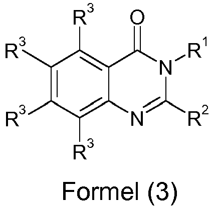 wobei für die verwendeten Symbole und Indizes gilt:
- R¹, R²: sind bei jedem Auftreten verschieden ausgewählt aus den Gruppen mit den folgenden Formeln (Ar-1) bis (Ar-27) 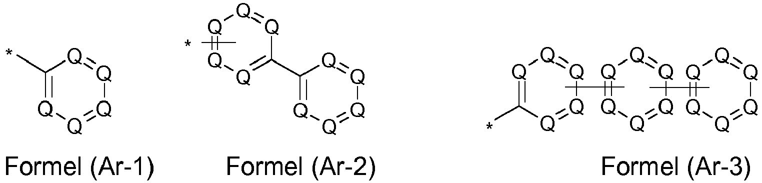 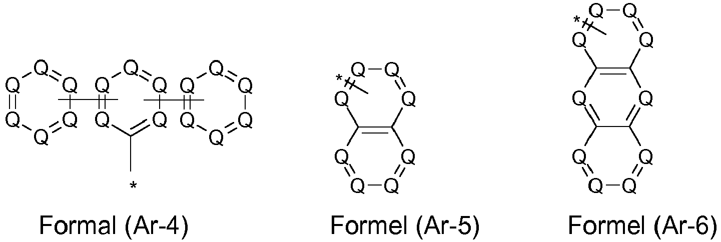 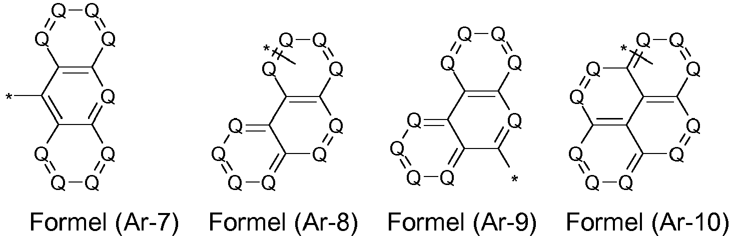 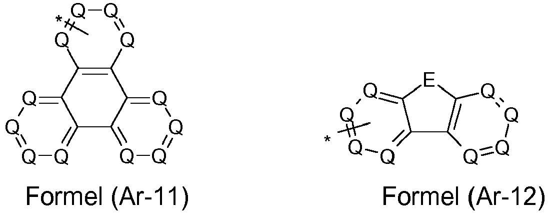 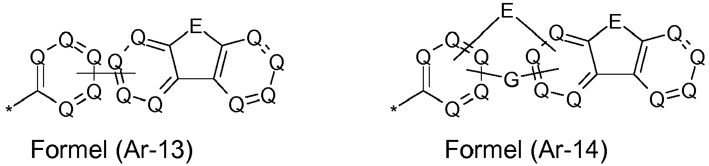 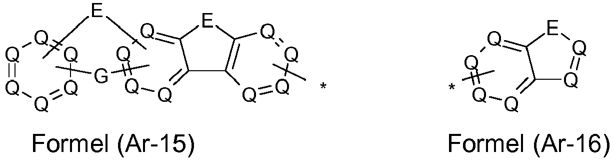 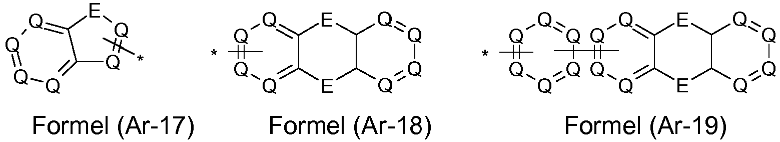 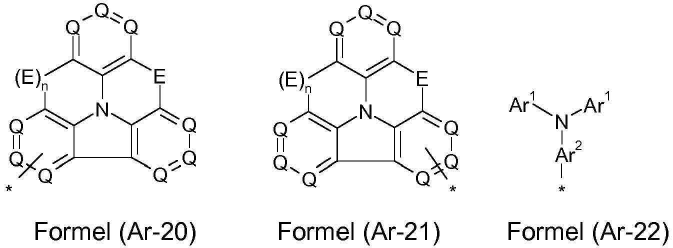 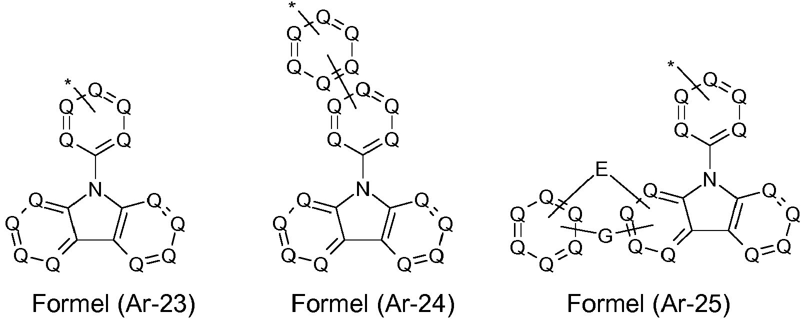 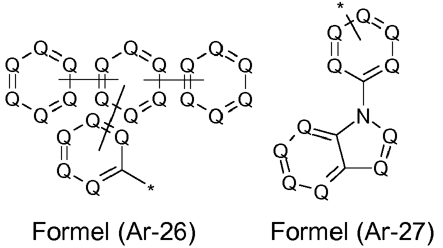
wobei:
- Q: ist bei jedem Auftreten gleich oder verschieden CR⁴ oder N, wobei maximal 3 Symbole Q pro Cyclus für N stehen;
- E: ist bei jedem Auftreten gleich oder verschieden (CR⁴)₂, NR⁴, O, S oder C=O;
- G: ist bei jedem Auftreten eine Einfachbindung, (CR⁴)₂, NR⁴, O, S oder C=O;
- Ar²: ist bei jedem Auftreten gleich oder verschieden ein bivalentes aromatisches oder heteroaromatisches Ringsystem mit 5 bis 60
- Ar¹: aromatischen Ringatomen, welches durch einen oder mehrere Reste R⁴ substituiert sein kann; sind bei jedem Auftreten gleich oder verschieden ein aromatisches oder heteroaromatisches Ringsystem mit 6 bis 60 aromatischen Ringatomen, das jeweils auch mit einem oder mehreren Reste R⁴ substituiert sein kann, wobei beide Ar¹ und/oder Ar¹ mit Ar² über je mindestens eine Brücke K verbunden sein können;
- K: ist bei jedem Auftreten gleich oder verschieden gleich eine Einfachbindung oder eine bivalente Brücke, ausgewählt aus N(R⁴), B(R⁴), O,C=O, C(R⁴)₂, Si(R⁴)₂, und S; und
- *: die Bindung zum Quinazolinon-Grundgerüst darstellt.
- R³: ist bei jedem Auftreten gleich oder verschieden H, D, F, eine geradkettige Alkylgruppe mit 1 bis 10 C-Atomen oder eine verzweigte oder cyclische Alkylgruppe mit 3 bis 10 C-Atomen, die jeweils mit einem oder mehreren Resten R⁴ substituiert sein kann, oder ein aromatisches oder heteroaromatisches Ringsystem mit 6 bis 60 aromatischen Ringatomen, das jeweils durch einen oder mehrere Reste R⁴ substituiert sein kann;
- Ar: ist bei jedem Auftreten gleich oder verschieden, ein aromatisches oder heteroaromatisches Ringsystem mit 6 bis 60 aromatischen Ringatomen, das jeweils auch mit einem oder mehreren Resten R⁴ substituiert sein kann,
- R⁴: ist bei jedem Auftreten gleich oder verschieden H, D, F, Cl, Br, I, CHO, C(=O)R⁵, P(=O)(R⁵)₂, S(=O)R⁵, S(=O)₂R⁵, CN, NO₂, Si(R⁵)₃, B(OR⁵)₂, OSO₂R⁵, N(R⁵)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁵ substituiert sein kann, wobei eine oder mehrere nicht benachbarte CH₂-Gruppen durch C=C , Si(R⁵)₂, Ge(R⁵)₂, Sn(R⁵)₂, C=O, C=S, C=Se, P(=O)(R⁵), SO, SO₂, O, S oder CONR⁵ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁵ substituiert sein kann, oder eine Aryloxy- oder Heteroaryloxygruppe mit 5 bis 60 aromatischen Ringatomen, die durch einen oder mehrere Reste R⁵ substituiert sein kann, oder eine Kombination dieser Systeme; dabei können zwei oder mehrere benachbarte Substituenten R⁴ auch miteinander ein mono- oder polycyclisches, aliphatisches oder aromatisches Ringsystem bilden;
- R⁵: ist bei jedem Auftreten gleich oder verschieden H, D, F, Cl, Br, I, N(R⁶)₂, C(=O)R⁶, P(=O)(R⁶)₂, S(=O)R⁶, S(=O)₂R⁶, CR⁶=C(R⁶)₂, CN, NO₂, Si(R⁶)₃, B(OR⁶)₂, OSO₂R⁶, N(R⁶)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁶ substituiert sein kann, wobei eine oder mehrere nicht benachbarte CH₂-Gruppen durch R⁶C=CR⁶, C≡C, Si(R⁶)₂, C=O, C=NR⁶, P(=O)(R⁶), SO, SO₂, NR⁶, O, S oder CONR⁶ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁶ substituiert sein kann, oder eine Aryloxy- oder Heteroaryloxygruppe mit 5 bis 60 aromatischen Ringatomen, die durch einen oder mehrere Reste R⁶ substituiert sein kann, oder eine Aralkyl- oder Heteroaralkylgruppe mit 5 bis 60 aromatischen Ringatomen, die durch einen oder mehrere Reste R⁶ substituiert sein kann, oder eine Kombination dieser Systeme; dabei können zwei oder mehrere benachbarte Substituenten R⁵ auch miteinander ein mono- oder polycyclisches, aliphatisches oder aromatisches Ringsystem bilden.

Der Bicyclus in Formel (3) wird auch als das Quinazolinon-Grundgerüst bezeichnet, an das R¹, R² oder R³ binden.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Thiophen, etc., oder eine kondensierte (anellierte) Aryl- oder Heteroarylgruppe, beispielsweise Naphthalin, Anthracen, Phenanthren, Dibenzofuran, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind. Weiterhin werden miteinander durch Einfachbindung verknüpfte Aromaten, wie zum Beispiel Biphenyl, als aromatisches Ringsystem im Sinne dieser Anmeldung bezeichnet.

Eine elektronenarme Heteroarylgruppe im Sinne der vorliegenden Erfindung ist definiert als 5-Ring-Heteroarylgruppe mit mindestens zwei Heteroatomen, beispielsweise Imidazol, Oxazol, Oxadiazol, etc., oder als 6-Ring-Heteroarylgruppe mit mindestens einem Heteroatom, beispielsweise Pyridin, Pyrimidin, Pyrazin, Triazin, etc.. Dabei können an diese Gruppen auch noch weitere 6-Ring-Aryl- oder 6-Ring-Heteroarylgruppen ankondensiert sein, wie beispielsweise in Benzimidazol oder Chinolin.

Im Rahmen der vorliegenden Erfindung werden unter einem aliphatischen Kohlenwasserstoffrest bzw. einer Alkylgruppe bzw. einer Alkenyl- oder Alkinylgruppe, die typischerweise 1 bis 40 oder auch 1 bis 20 C-Atome enthalten kann, und in der auch einzelne H-Atome oder CH₂-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkenyl-, Alkinyl-, Alkoxy- oder Thioalkylgruppen gemäß der vorliegenden Erfindung geradkettig, verzweigt oder cyclisch sein, wobei eine oder mehrere nicht-benachbarte CH₂-Gruppen durch die oben genannten Gruppen ersetzt sein können; weiterhin können auch ein oder mehrere H-Atome durch D, F, Cl, Br, I, CN oder NO₂, bevorzugt F, Cl oder CN, weiter bevorzugt F oder CN, besonders bevorzugt CN ersetzt sein.

Unter einem aromatischen oder heteroaromatischen Ringsystem mit 5 - 80 aromatischen Ringatomen, welches noch jeweils mit den oben genannten Resten substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombinationen dieser Systeme. Dabei können diese Gruppen jeweils durch die oben genannten Reste substituiert sein.

Unter einer Aryloxygruppe gemäß der Definition der vorliegenden Erfindung wird eine Arylgruppe, wie oben definiert, verstanden, welche über ein Sauerstoffatom gebunden ist. Eine analoge Definition gilt für Heteroaryloxygruppen.

Eine elektronenarme Heteroarylgruppe im Sinne der vorliegenden Erfindung ist definiert als 5-Ring-Heteroarylgruppe mit mindestens zwei Heteroatomen, beispielsweise Imidazol, Oxazol, Oxadiazol, etc., oder als 6-Ring-Heteroarylgruppe mit mindestens einem Heteroatom, beispielsweise Pyridin, Pyrimidin, Pyrazin, Triazin, etc. Dabei können an diese Gruppen auch noch weitere 6-Ring-Aryl- oder 6-Ring-Heteroarylgruppen ankondensiert sein, wie beispielsweise in Benzimidazol oder Chinolin.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung verknüpft sind. Dies wird durch das folgende Schema verdeutlicht.

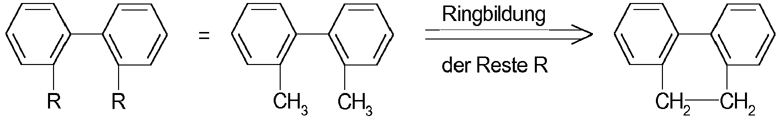

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

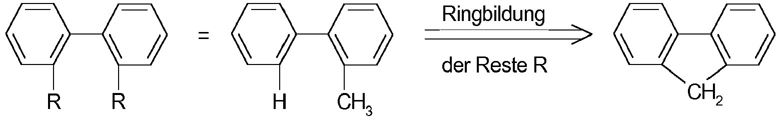

In einer weiteren Ausführungsform der Erfindung stehen maximal 1 X in Formel (1) oder in einem Quinazolinon-Grundgerüst in Formel (2) für N. Besonders bevorzugt steht kein X in Formel (1) oder Formel (2) für N.

In einer bevorzugten Ausführungsform der Erfindung umfasst die Verbindung kein Arylgruppe oder Heteroarylgruppe mit mehr als 22 aromatischen Ringatomen.

In einer bevorzugten Ausführungsform der Erfindung sind die Gruppen R¹, R² und R³ bei jedem Auftreten gleich oder verschieden und im Falle eines aromatischen oder heteroaromatischen Ringsystems bei jedem Auftreten ausgewählt aus den Gruppen mit den folgenden Formeln (Ar-1) bis (Ar-27) 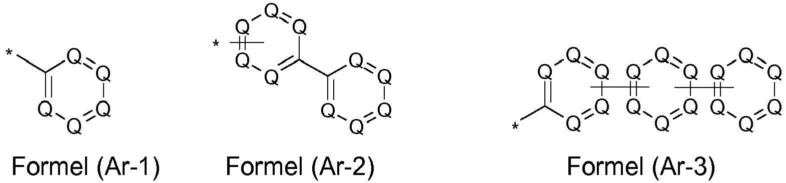 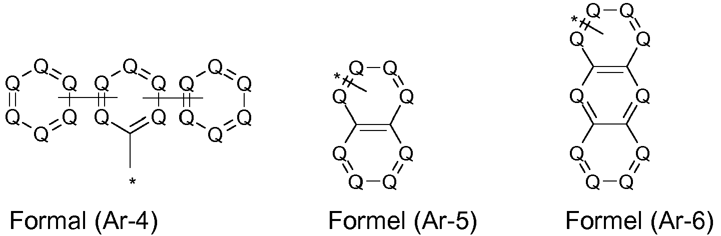 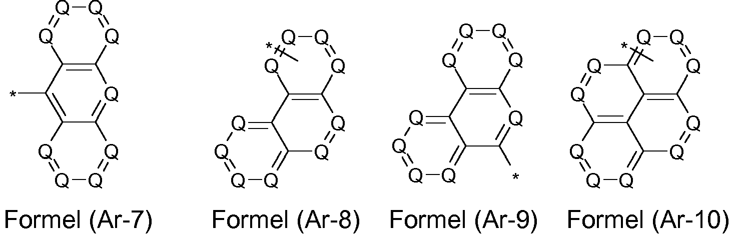 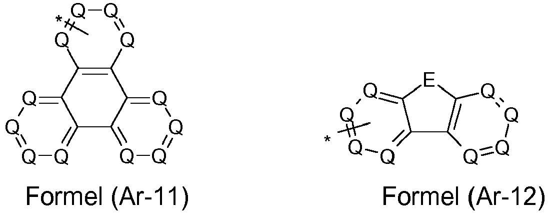 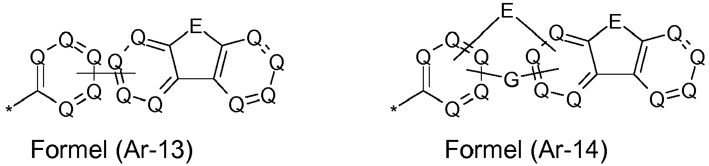 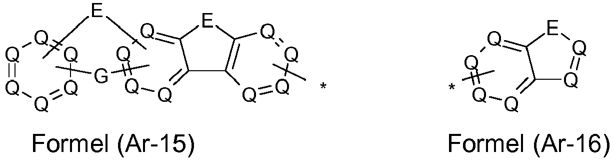 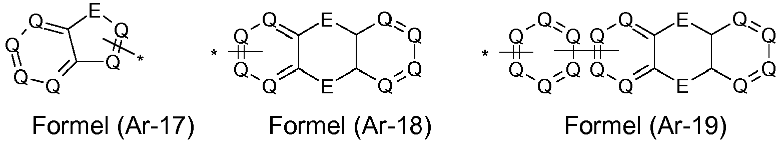 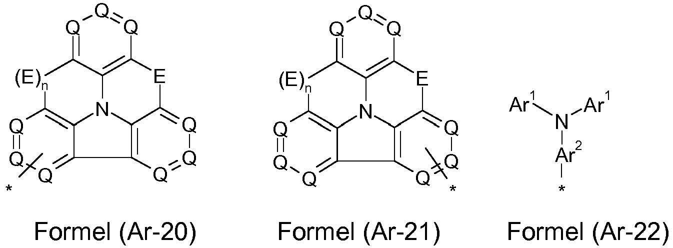 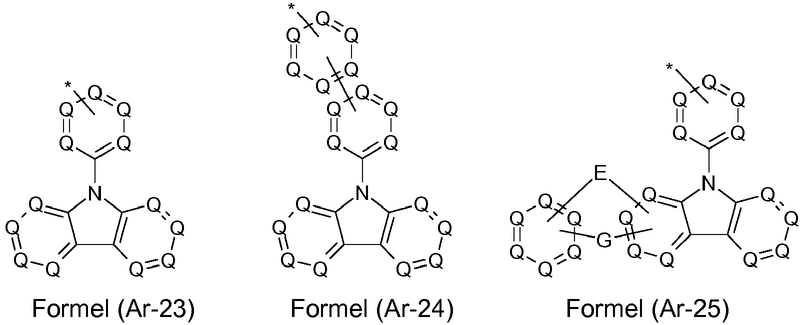 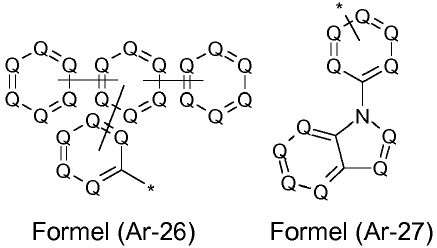 wobei die Symbole und Indizes wie oben beschrieben sind.

Außerdem sind die Gruppen R³ ausgewählt aus den Gruppen einer der folgenden Formeln (Ar1-1) bis (Ar1-7): 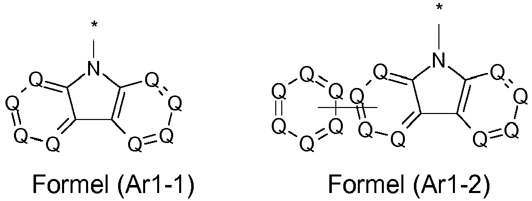 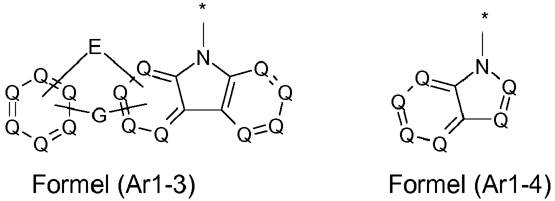 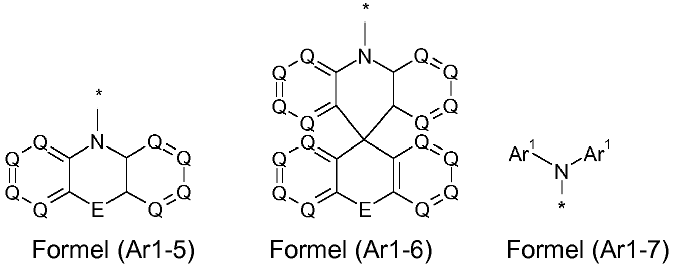 wobei die Symbole und Indizes den Symbolen und Indizes der Formel (3) entsprechen und zusätzlich für die Formeln (Ar1-1) bis (Ar1-7) gilt:
- Q: ist bei jedem Auftreten gleich oder verschieden CR⁴ oder N, wobei maximal 2 Symbole Q pro Cyclus für N stehen;
- E: ist bei jedem Auftreten gleich oder verschieden (CR⁴)₂, NR⁴, O, S oder C=O;
- G: ist bei jedem Auftreten eine Einfachbindung, (CR⁴)₂, NR⁴, O, S oder C=O;
- n: ist 0 oder 1, wobei n gleich 0 bedeutet, dass an dieser Position keine Gruppe E gebunden ist und an den entsprechenden Kohlenstoffatomen statt dessen Reste R⁴ gebunden sind;
- Ar¹: sind bei jedem Auftreten gleich oder verschieden ein aromatisches oder heteroaromatisches Ringsystem mit 6 bis 60 aromatischen Ringatomen, das jeweils auch mit einem oder mehreren Reste R⁴ substituiert sein kann, wobei beide Ar¹ über je mindestens eine Brücke K verbunden sein können;
- K: ist bei jedem Auftreten gleich oder verschieden gleich eine Einfachbindung oder eine bivalente Brücke, ausgewählt aus N(R⁴), B(R⁴), O,C=O, C(R⁴)₂, Si(R⁴)₂, und S; und
- *: die Bindung zum Quinazolinon-Grundgerüst darstellt.

In einer weiteren bevorzugten Ausführungsform stehen in der Formel (Ar-1) 0, 1, 2 oder 3 Symbole Q für N.

Bevorzugte Ausführungsformen der Formel (Ar-15) zeigen die folgenden Formeln (Ar-15-1) bis (Ar-15-7): 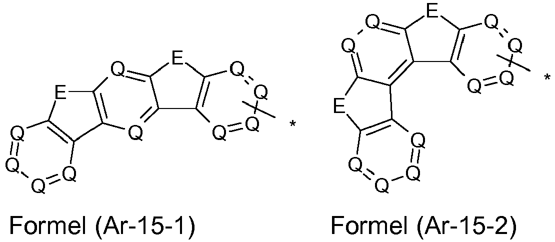 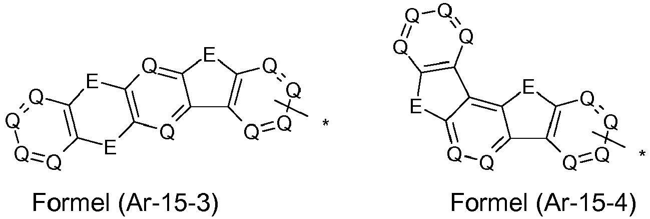 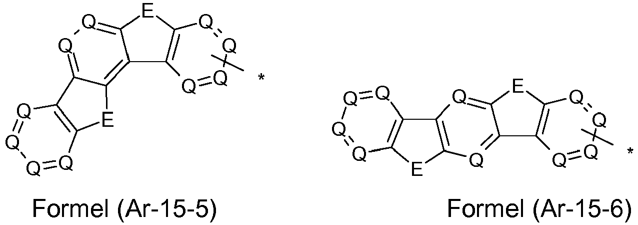 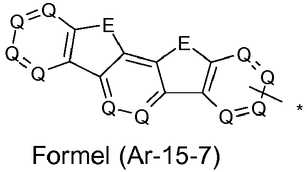 wobei die Symbole den Symbolen der Formel (Ar-15) entsprechen. Besonders bevorzugt ist Q immer CR⁴.

In einer weiteren bevorzugten Ausführungsform ist die Gruppen R¹, R² und R³ bei jedem Auftreten gleich oder verschieden und im Falle eines aromatischen oder heteroaromatischen Ringsystems bei jedem Auftreten ausgewählt ausgewählt aus den Gruppen mit den Strukturen der Formeln (Ar-1) bis (Ar-24), wobei die allgemeinen Formeln durch die besonders bevorzugten Ausführungsformen jeweils gemäß der folgenden Formeln (Ar-1-1) bis (Ar-21-1) ersetzt werden (z. B. wird Formel (Ar-1) durch eine der Formeln (Ar-1-1) bis (Ar-1-9) ersetzt): 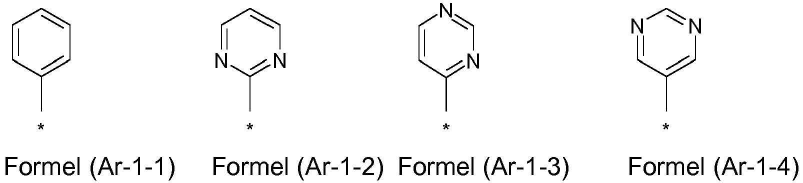 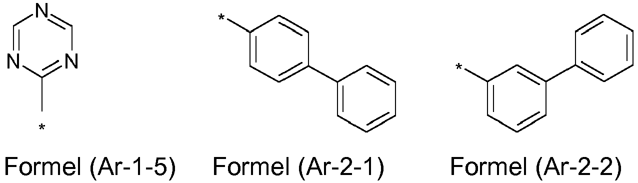 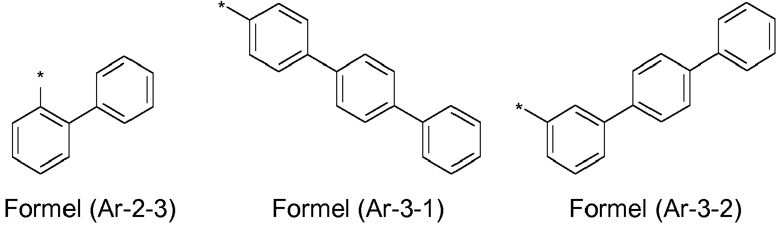 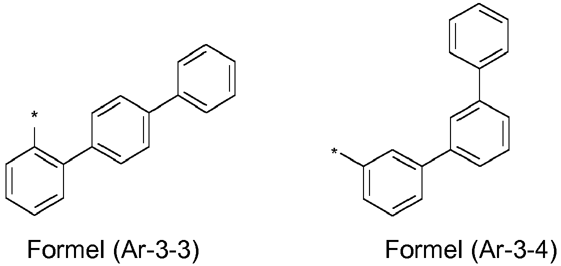 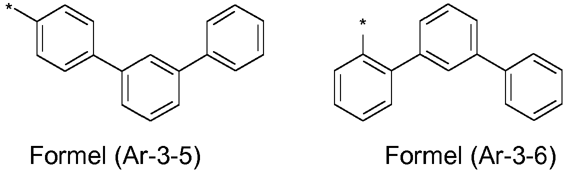 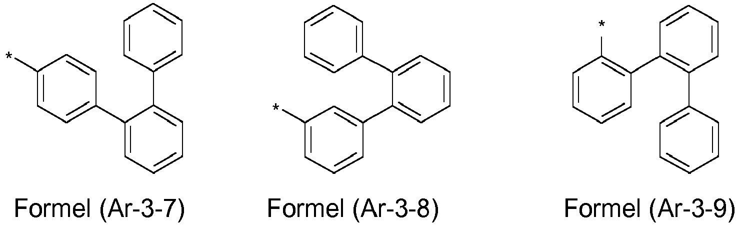 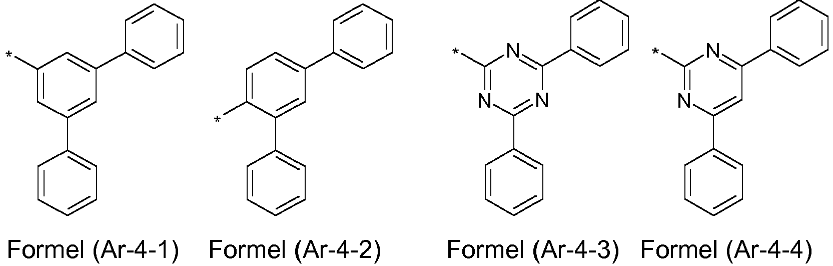 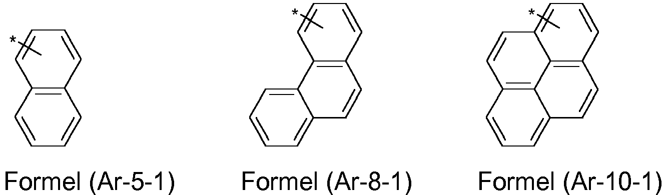 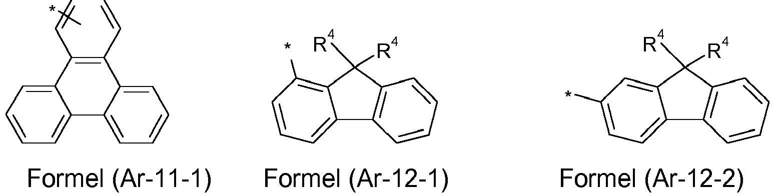 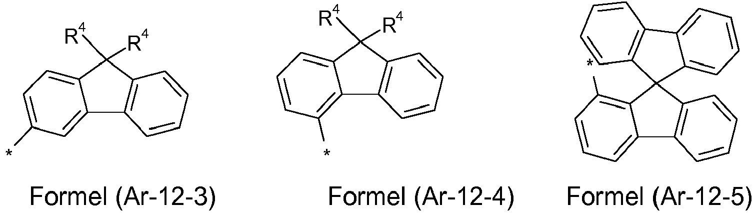 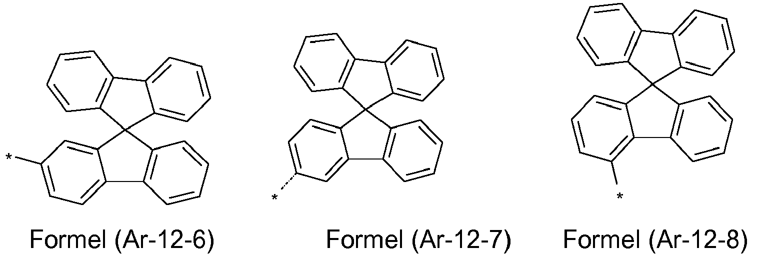 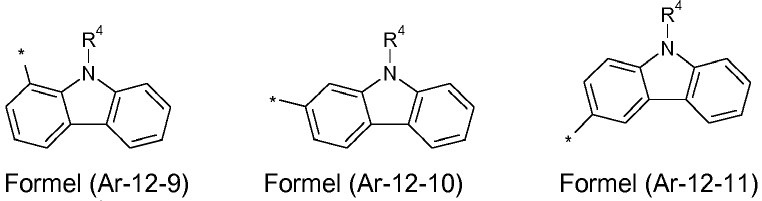 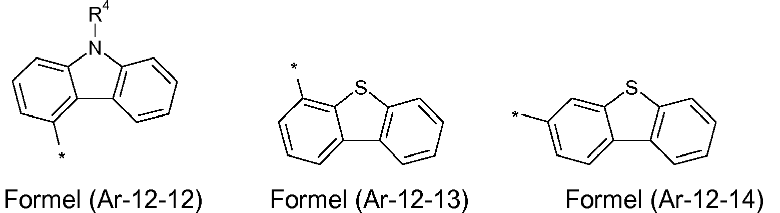 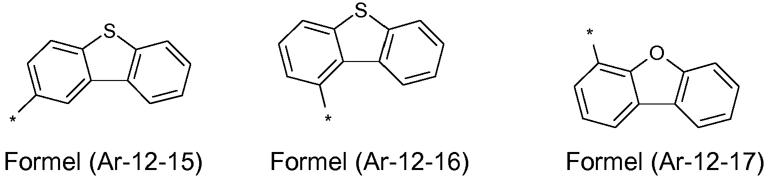 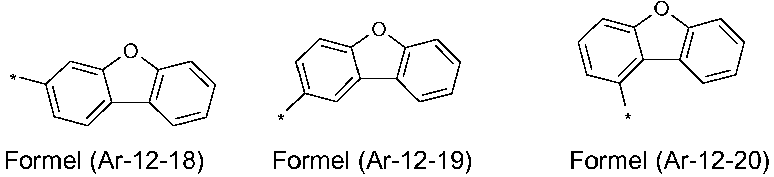 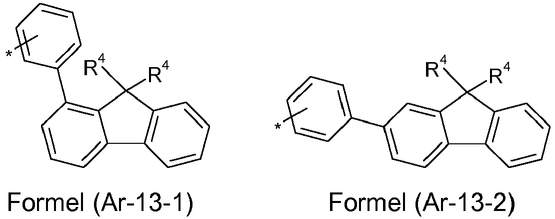 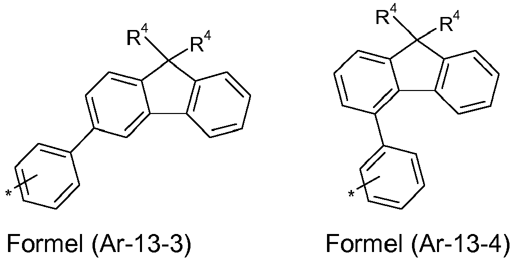 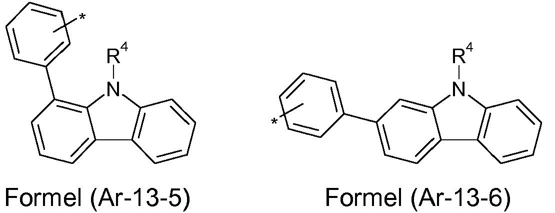 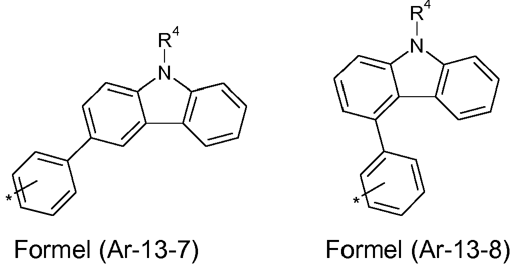 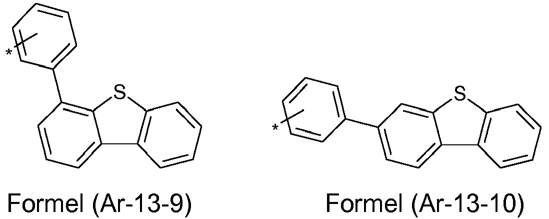 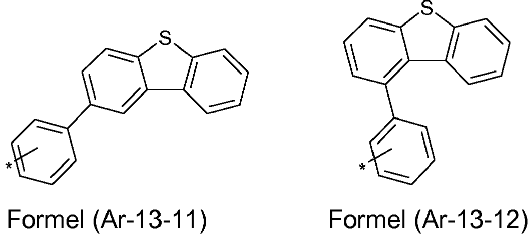 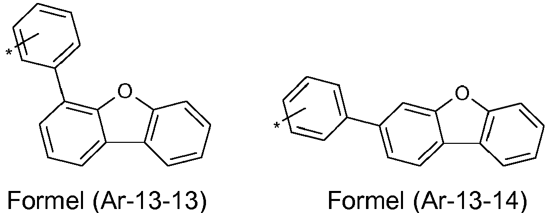 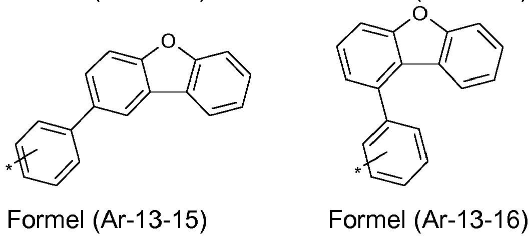 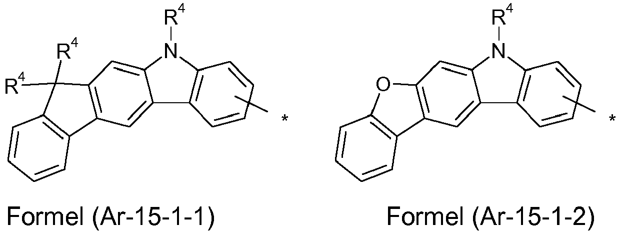 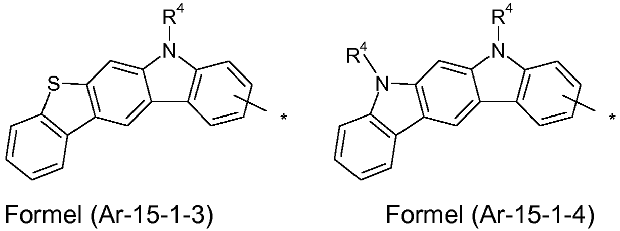 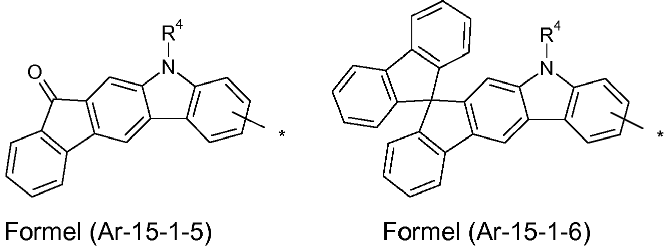 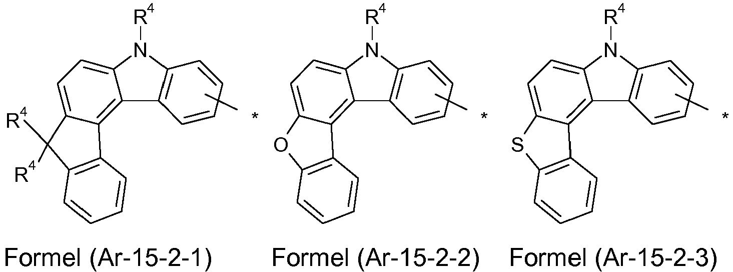 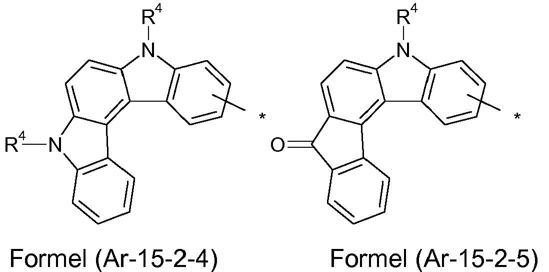 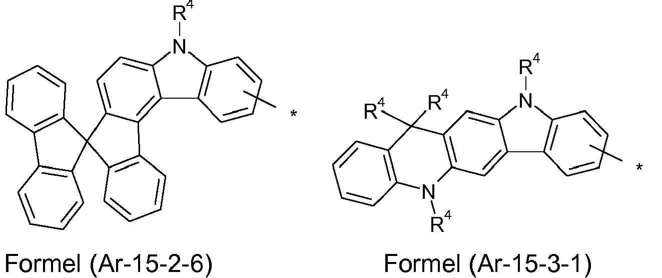 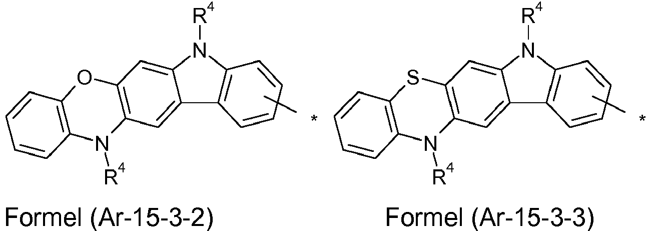 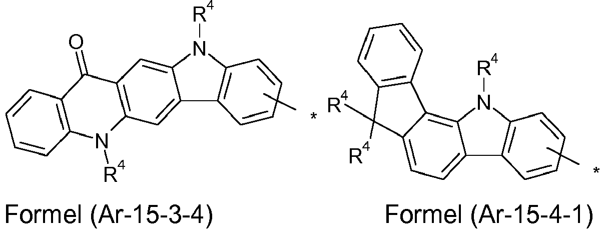 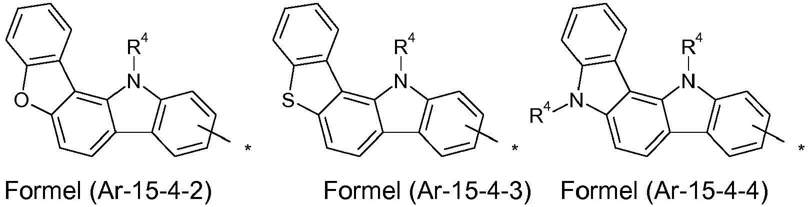 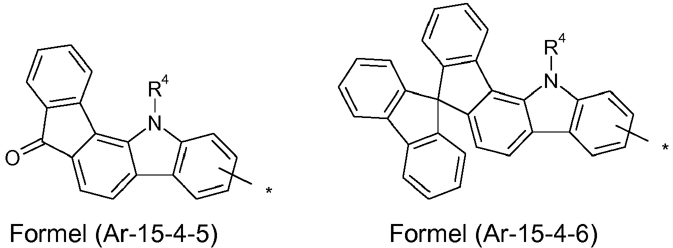 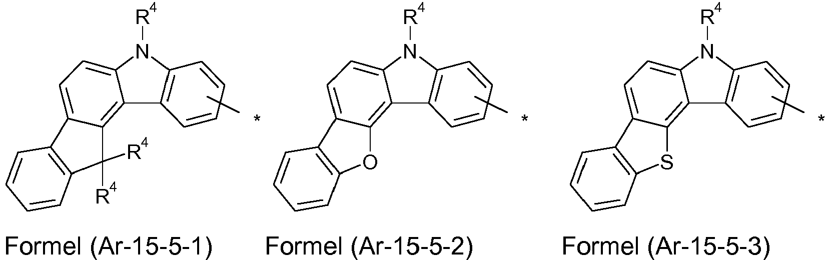 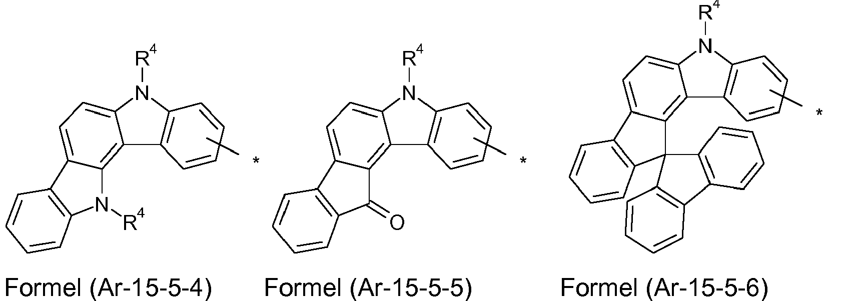 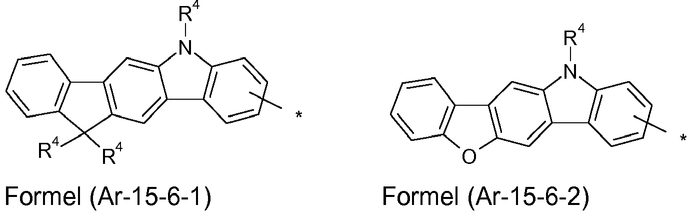 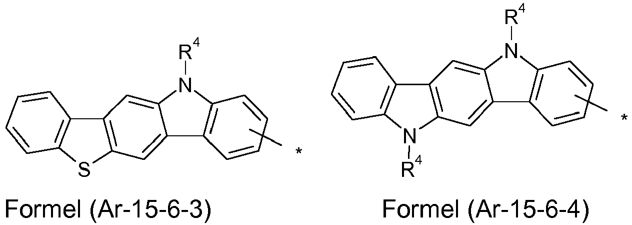 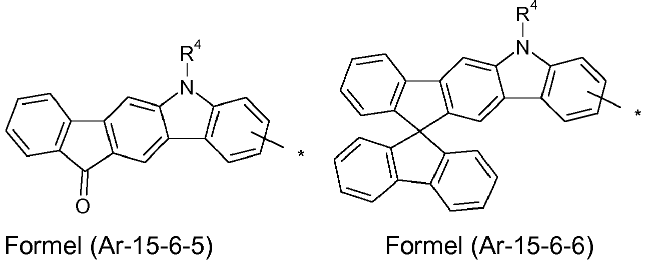 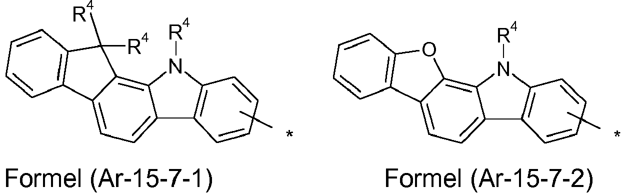 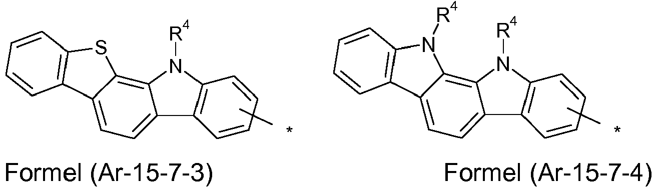 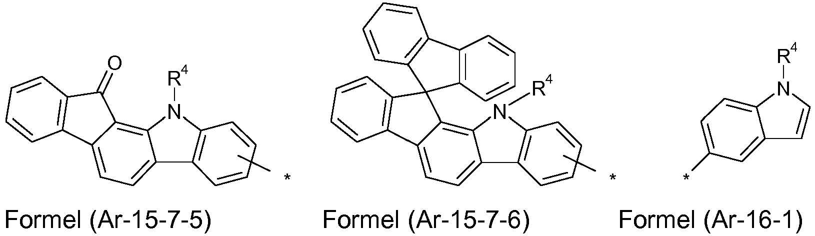 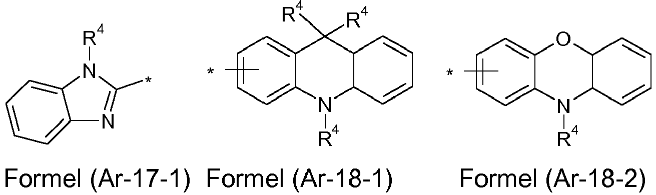 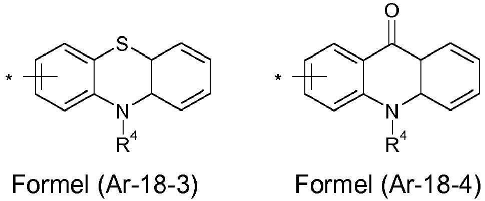 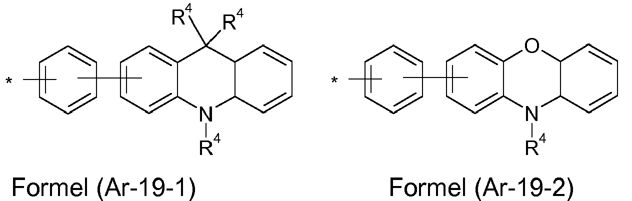 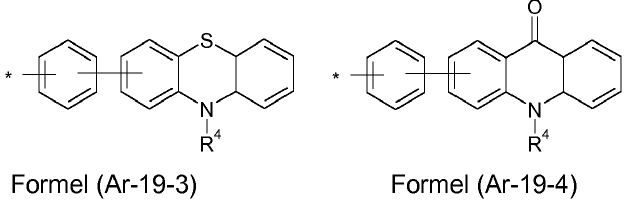 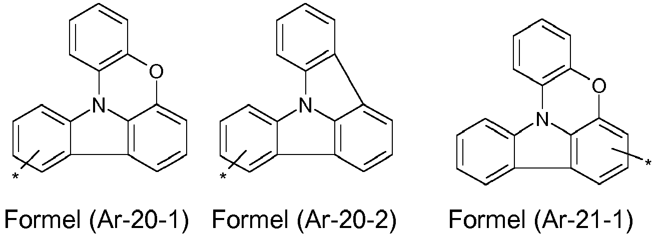 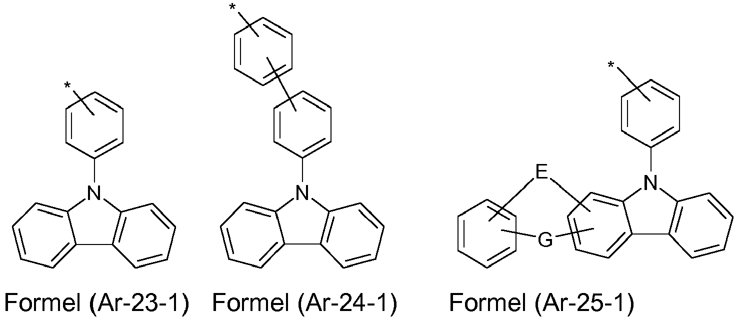 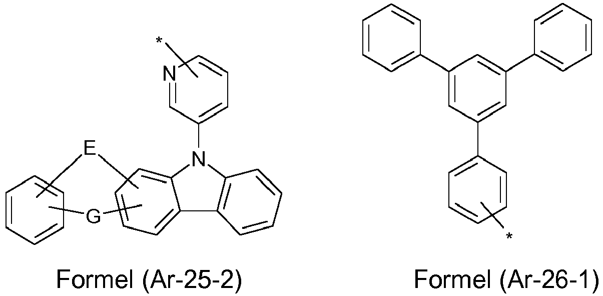 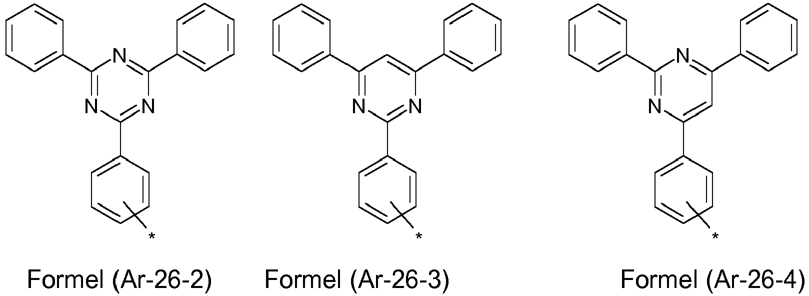 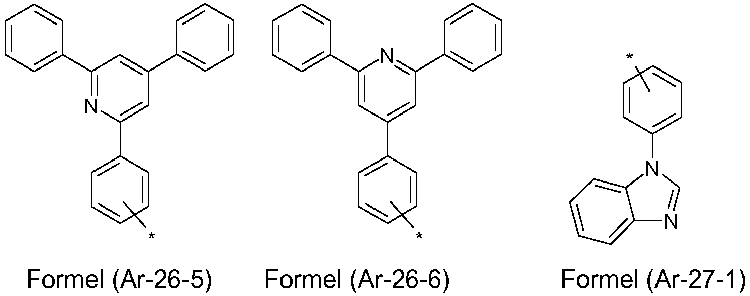 wobei die Symbole den Symbolen in Formel (Ar-1) bis (Ar-26) entsprechen. Die Formeln können an den freien Positionen mit R⁴ substituiert sein.

In einer weiteren Ausführungsform der Erfindung sind die Gruppen R³ ausgewählt aus den Gruppen einer der folgenden Formeln (Ar1-1) bis (Ar1-7), wobei die allgemeinen Formeln durch die besonders bevorzugten Ausführungsformen jeweils gemäß der folgenden Formeln (Ar1-1-1) bis (Ar1-6-1) ersetzt werden (z. B. wird Formel (Ar1-1) durch die Formeln (Ar1-1-1) ersetzt): 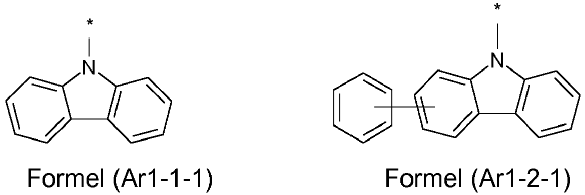 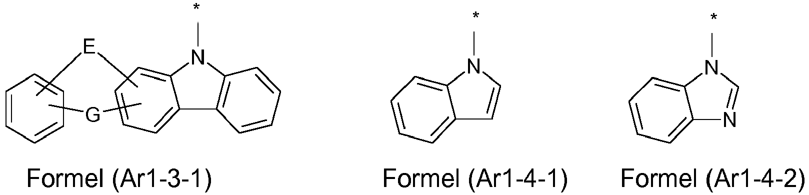 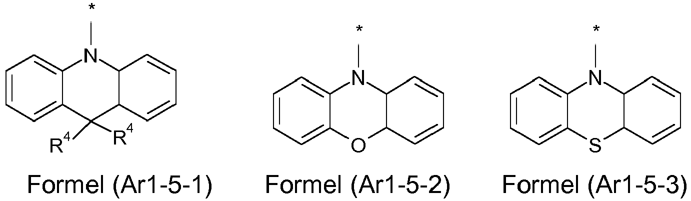 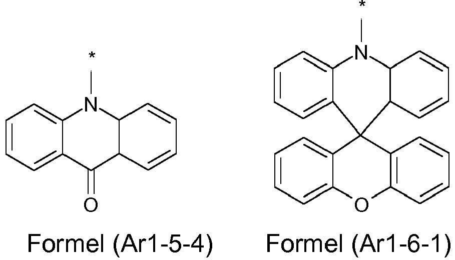 wobei die Symbole den Symbolen in den Formeln (Ar1-1) bis (Ar1-5) entsprechen. Die Formeln können an den freien Positionen mit R⁴ substituiert sein.

In einer weiteren Ausführungsform der Erfindung sind die Gruppen gemäß Formel (Ar-15), bzw. deren bevorzugte Ausführungsformen ausgewählt aus den Gruppen gemäß eine der Formeln (Ar-15-1-1a) bis (Ar-15-7-6a) 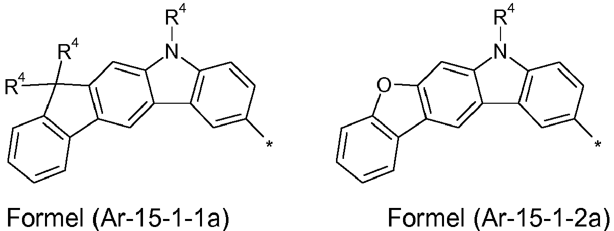 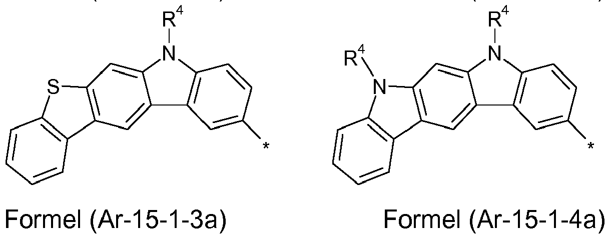 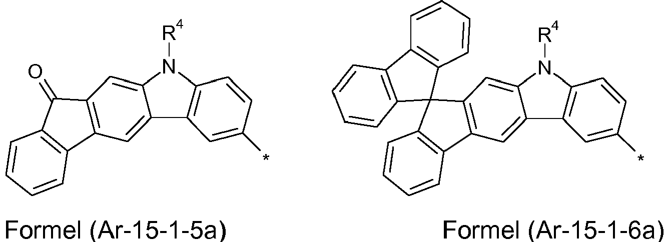 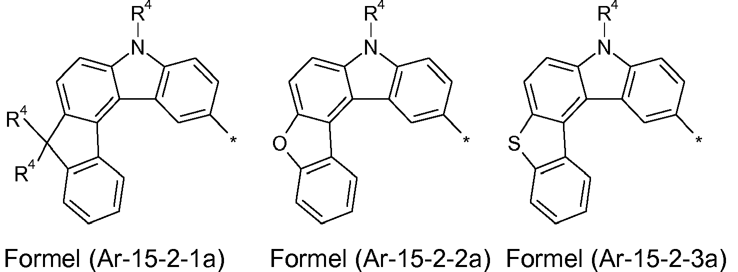 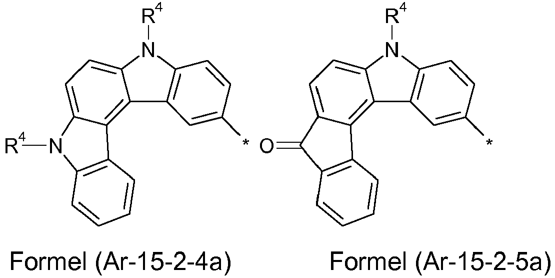 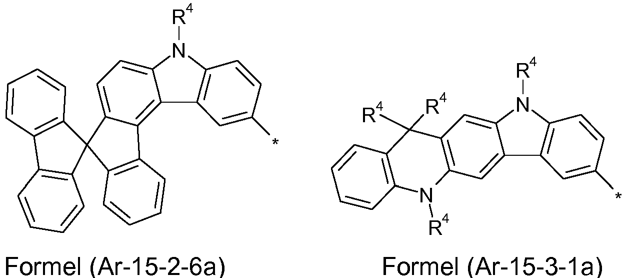 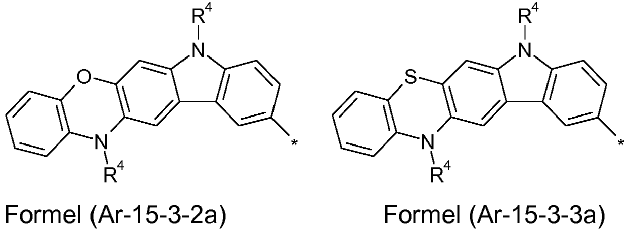 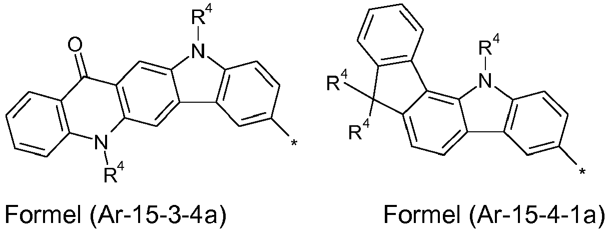 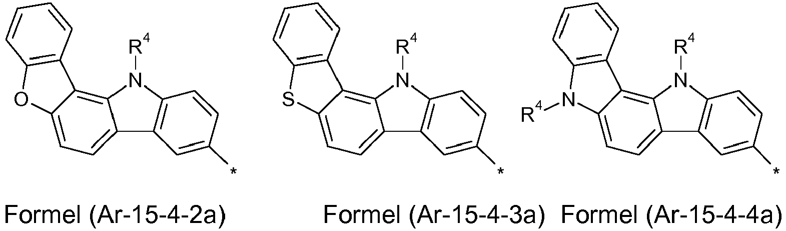 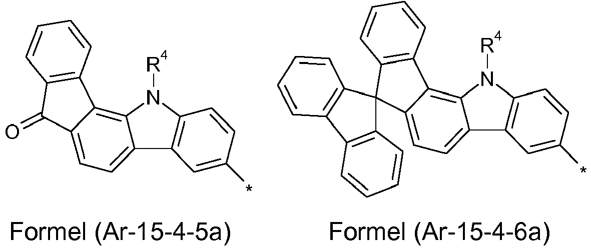 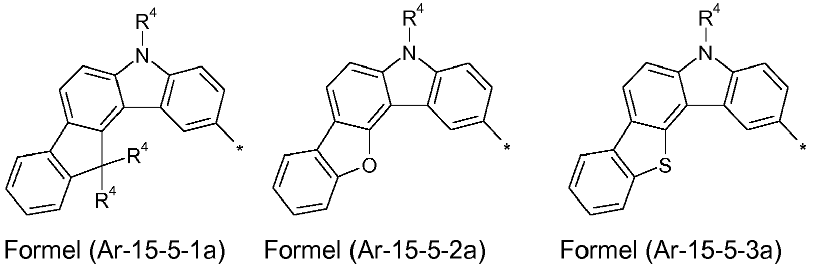 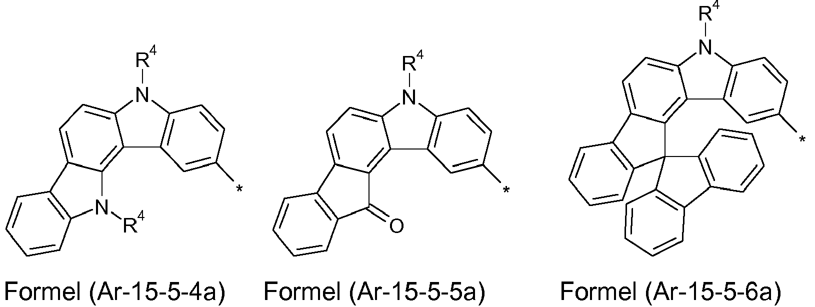 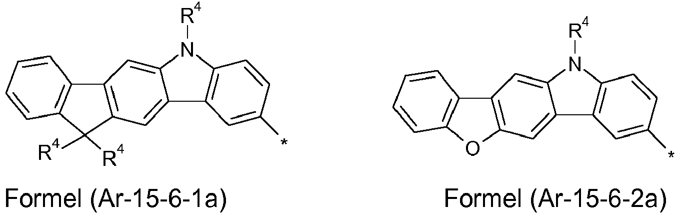 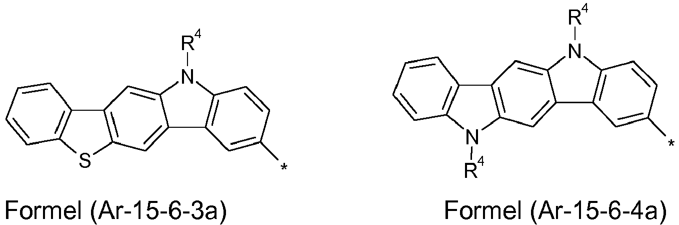 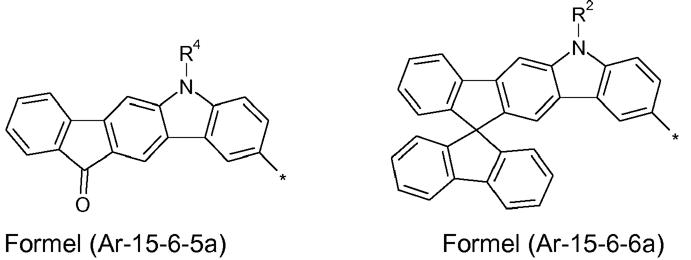 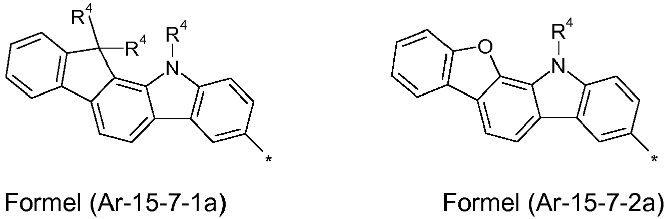 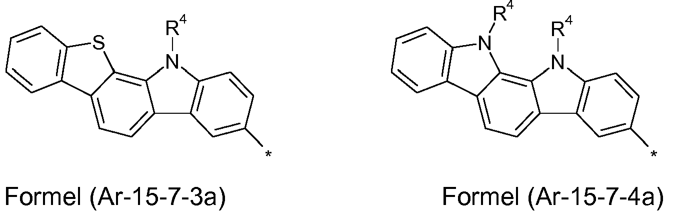 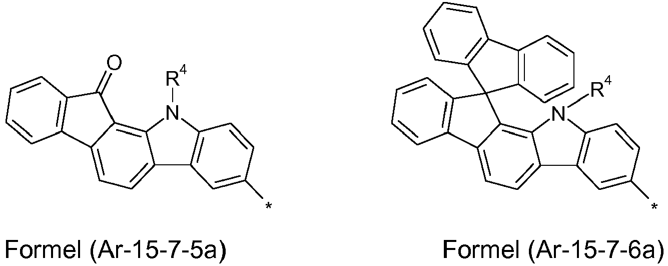 wobei die Symbole den Symbolen in Formel (Ar-15) entsprechen. Die Formeln können an den freien Positionen mit R⁴ substituiert sein.

In einer weiteren Ausführungsform der Erfindung sind die Gruppen gemäß Formel (Ar-26-1), bzw. deren bevorzugte Ausführungsformen ausgewählt aus den Gruppen gemäß einer der Formeln (Ar-26-1-1) bis (Ar-26-1-6) 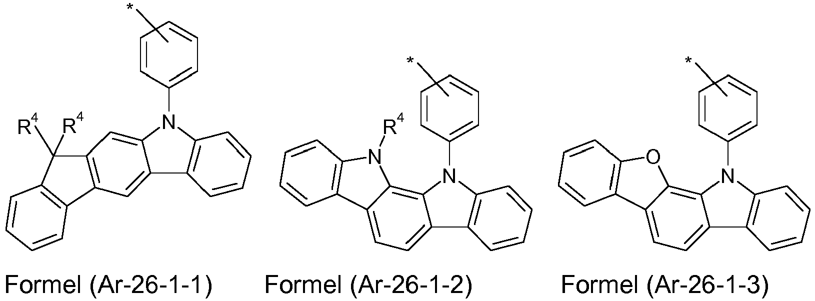 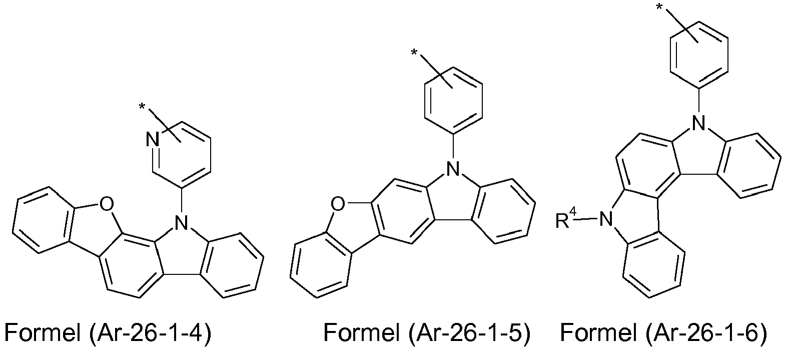 wobei die Symbole den Symbolen in Formel (Ar-26) entsprechen. Die Formeln können an den freien Positionen mit R⁴ substituiert sein.

In einer weiteren Ausführungsform der Erfindung umfasst die Gruppe Ar² in Formel (Ar-22) eine oder mehrere der Strukturen der Formeln (Ar2-1) bis (Ar2-15), wie unten beschrieben, bevorzugt (Ar2-1) bis (Ar2-14), oder ihren bevorzugten Ausführungsformen, wobei die Symbole und Indizes den Symbolen und Indizes der Formeln (Ar2-1) bis (Ar2-15) entsprechen, und im Falle von mehreren Strukturen diese über eine oder mehrere Einfachbindungen oder Heteroarome, wie O, NR⁴ oder S miteinander verbunden sind. Die Strukturen können an freien Positionen mit R⁴ substituiert sein. Ar² ist dabei eine bivalente Gruppe. Dies bedeutet, dass sie eine Einfachbindung zum Quinazolinon-Grundgerüst und eine Bindung zum N der Formel (Ar-22) aufweist. Dabei ist die Bindung zum N der Formel (Ar-22) bevorzugt eine C-N-Einfachbindung: 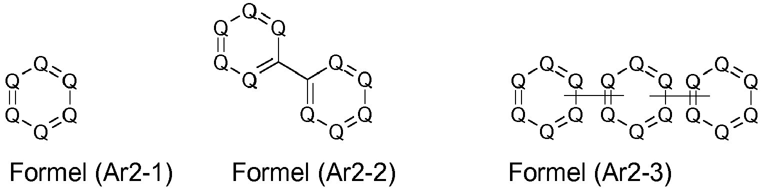 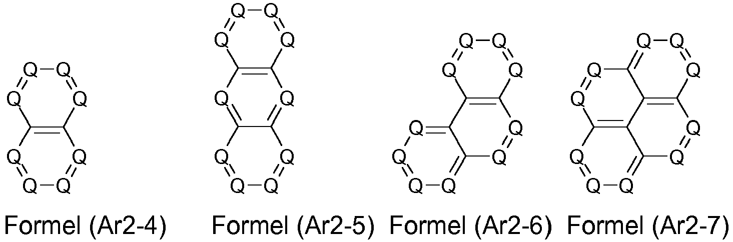 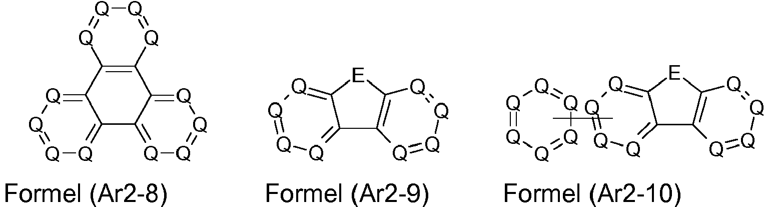 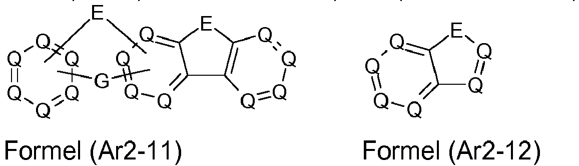 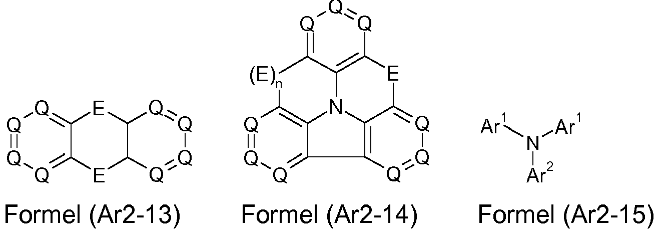 wobei die Symbole und Indizes den Symbolen und Indizes der Formel (2) entsprechen und zusätzlich gilt:
- Q: ist bei jedem Auftreten gleich oder verschieden CR⁴ oder N, wobei maximal 3 Symbole Q pro Cyclus für N stehen;
- E: ist bei jedem Auftreten gleich oder verschieden (CR⁴)₂, NR⁴, O, S oder C=O;
- G: ist bei jedem Auftreten eine Einfachbindung, (CR⁴)₂, NR⁴, O, S oder C=O;
- n: ist 0 oder 1, wobei n gleich 0 bedeutet, dass an dieser Position keine Gruppe E gebunden ist und an den entsprechenden Kohlenstoffatomen stattdessen Reste R⁴ gebunden sind;
- Ar²: ist bei jedem Auftreten gleich oder verschieden ein bivalentes aromatisches oder heteroaromatisches Ringsystem mit 5 bis 40 aromatischen Ringatomen, welches durch einen oder mehrere Reste R⁴ substituiert sein kann;
- Ar¹: sind bei jedem Auftreten gleich oder verschieden ein aromatisches oder heteroaromatisches Ringsystem mit 6 bis 60 aromatischen Ringatomen, das jeweils auch mit einem oder mehreren Reste R⁴ substituiert sein kann, wobei beide Ar¹ und/oder Ar¹ mit Ar² über je mindestens eine Brücke K verbunden sein können;
- K: ist bei jedem Auftreten gleich oder verschieden gleich eine Einfachbindung oder eine bivalente Brücke, ausgewählt aus N(R⁴), B(R⁴), O,C=O, C(R⁴)₂, Si(R⁴)₂, und S; und
wobei, soweit mehrere Strukturen vorhanden sind, die einzelnen Strukturen durch eine oder mehrere Einfachbindungen, NR⁴, O oder S, miteinander verbunden sind.

In einer weiteren Ausführungsform der Erfindung sind die Formeln (Ar2-1) bis (Ar2-15) ersetzt durch ihre bevorzugten Ausführungsformen aus den Formeln (Ar2-1-1) bis (Ar2-9-5): 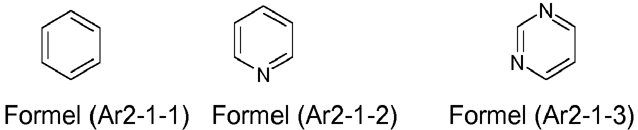 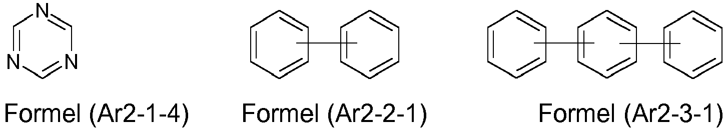 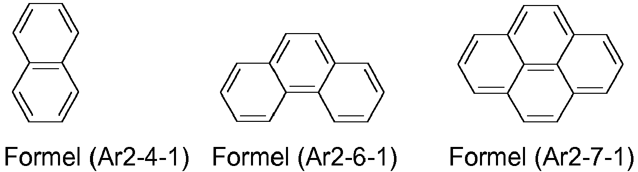 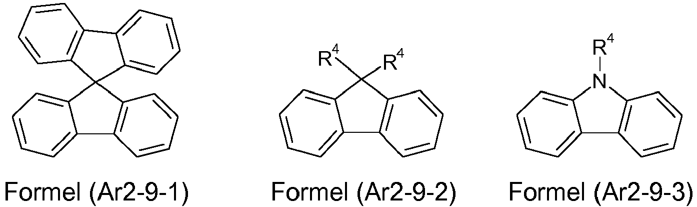 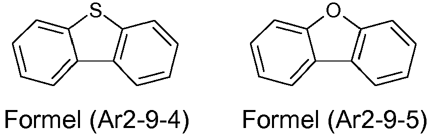 wobei die verwendeten Symbole den Symbolen für die Formeln (Ar2-1) bis (Ar2-15) entsprechen. Die Gruppen können dabei an den freien Positionen mit R⁴ substituiert sein. Bevorzugt sind sie unsubstituiert.

In einer weiteren Ausführungsform der Erfindung sind die Gruppen Ar¹ in Formel (Ar-22) ausgewählt aus einer der Strukturen der Formel (Ar-1) bis (Ar-25) oder ihrere bevorzugten Ausführungsformen, wobei die Symbole und Indizes den Symbolen und Indizes der Formeln (Ar-1) bis (Ar-25) entsprechen, wobei zusätzlich gilt, dass * für die Bindung zum N der Formel (Ar-22) steht.

In einer bevorzugten Ausführungsform der Erfindung ist R³ im Fall eines aromatischen oder heteroaromatischen Ringsystems eine Struktur ausgewählt aus den Formeln (Ar-1) bis (Ar-27) und (Ar1-1) bis (Ar1-7) oder den jeweiligen bevorzugten Ausführungsformen.

In einer bevorzugten Ausführungsform der Erfindung ist R⁴ im Fall eines aromatischen oder heteroaromatischen Ringsystems eine Struktur ausgewählt aus den Formeln (Ar-1) bis (Ar-27) und (Ar1-1) bis (Ar1-7) oder den jeweiligen bevorzugten Ausführungsformen, wobei zusätzlich gilt:
- Q: ist bei jedem Auftreten gleich oder verschieden CR⁵ oder N, wobei maximal 3 Symbole Q pro Cyclus für N stehen;
- E: ist bei jedem Auftreten gleich oder verschieden (CR⁵)₂, NR⁵, O, S oder C=O;
- G: ist bei jedem Auftreten eine Einfachbindung, (CR⁵)₂, NR⁵, O, S oder C=O;
- n: ist 0 oder 1, wobei n gleich 0 bedeutet, dass an dieser Position keine Gruppe E gebunden ist und an den entsprechenden Kohlenstoffatomen stattdessen Reste R⁵ gebunden sind;
- Ar²: ist bei jedem Auftreten gleich oder verschieden ein bivalentes aromatisches oder heteroaromatisches Ringsystem mit 5 bis 60 aromatischen Ringatomen, welches durch einen oder mehrere Reste R⁵ substituiert sein kann;
- Ar¹: sind bei jedem Auftreten gleich oder verschieden ein aromatisches oder heteroaromatisches Ringsystem mit 6 bis 60 aromatischen Ringatomen, das jeweils auch mit einem oder mehreren Reste R⁵ substituiert sein kann, wobei beide Ar¹ und/oder Ar¹ mit Ar² über je mindestens eine Brücke K verbunden sein können;
- K: ist bei jedem Auftreten gleich oder verschieden gleich eine Einfachbindung oder eine bivalente Brücke, ausgewählt aus N(R⁵), B(R⁵), O,C=O, C(R⁵)₂, Si(R⁵)₂, und S; und
- *: die Bindung zur substituierten Position darstellt.

In einer weiteren bevorzugten Ausführungsform ist R⁴, welcher an eine Kohlenstoffbrücke in einem aromatischen oder heteroaromatischen Ringsystem bindet, wie beispielsweise in den Formeln (Ar-12-1), (Ar-12-2), (Ar-12-3), (Ar-12-4), (Ar-13-1), (Ar-13-2), (Ar-13-3), (Ar-13-4), (Ar1-1-5-1), (Ar-15-3-1 a) oder (Ar2-9-2), gleich oder verschieden bei jedem Auftreten ausgewählt aus der Gruppe bestehend aus einer geradkettigen Alkylgruppe mit 1 bis 10 C-Atomen, einer verzweigten oder cyclischen Alkylgruppe mit 3 bis 10 C-Atomen oder einem aromatischen Ringsystem mit 6 bis 30 C-Atomen, das wie oben definiert ist und das mit einem oder mehreren Resten R⁵ substituiert sein kann. Dabei können die beiden Gruppen R⁴ auch miteinander ein Ringsystem bilden, welches aliphatisch oder zusätzlich zur oben gegebenen Definition von R⁴ auch aromatisch sein kann. Durch Ringbildung wird ein Spiro-System aufgespannt.

In einer weiteren bevorzugten Ausführungsform ist R⁴, welcher an ein Stickstoffatom bindet, ausgewählt aus der Gruppe bestehend aus einer geradkettigen Alkylgruppe mit 1 bis 10 C-Atomen, einer verzweigten oder cyclischen Alkylgruppe mit 3 bis 10 C-Atomen oder einem aromatischen Ringsystem mit 6 bis 60 C-Atomen, insbesondere ein aromatisches Ringsystem mit 6 bis 60 C-Atomen, das wie oben definiert ist, und das mit einem oder mehreren Resten R⁵ substituiert sein kann.

Bevorzugte Kombinationen der Reste R¹ und R² für die Formeln (3) gibt die folgende Tabelle an:

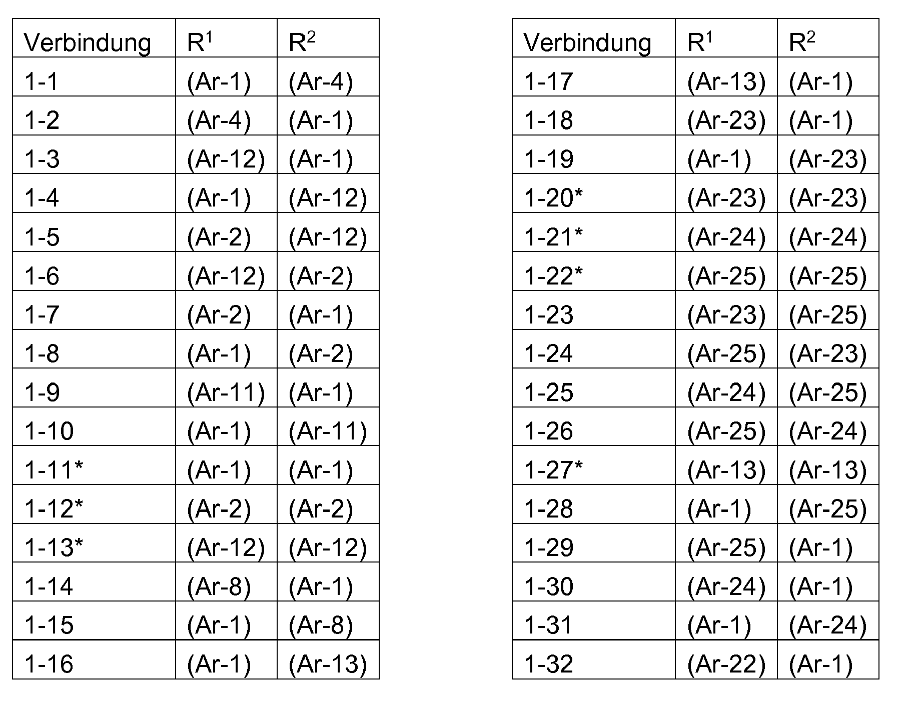

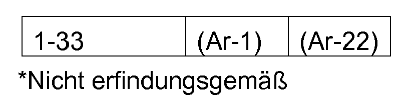

Die oben genannten Ausführungsformen können beliebig miteinander kombiniert werden. Insbesondere ist es bevorzugt, die oben aufgeführten bevorzugten Ausführungsformen miteinander zu kombinieren.

Beispiele für bevorzugte Verbindungen gemäß den oben aufgeführten Ausführungsformen, wie sie bevorzugt in organischen elektronischen Vorrichtungen eingesetzt werden können, sind die folgenden Verbindungen:

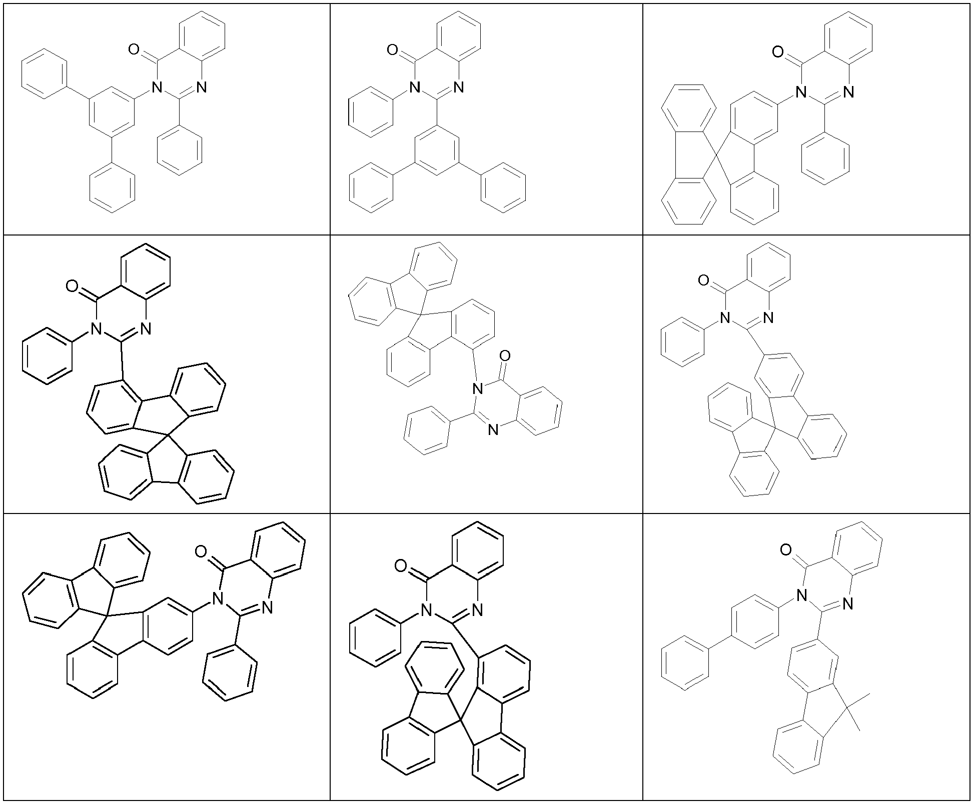

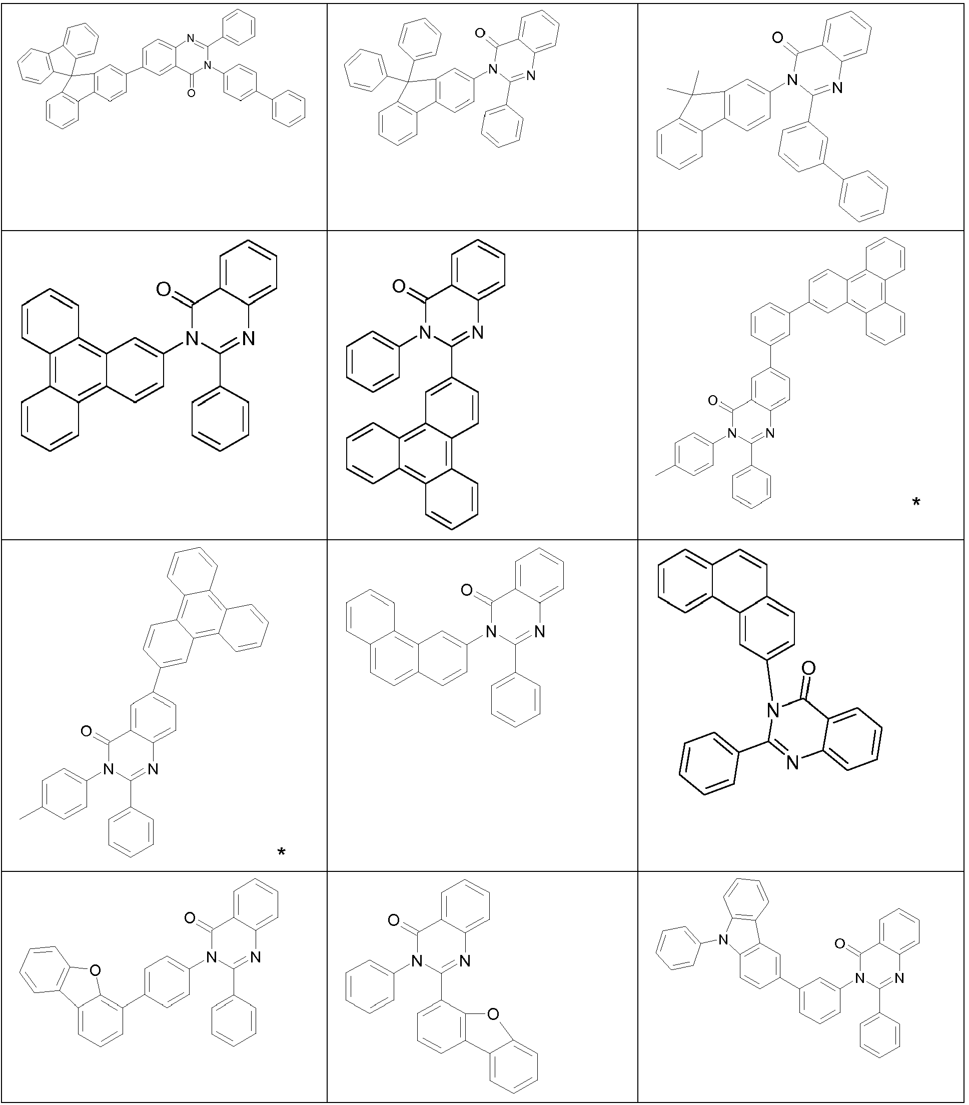

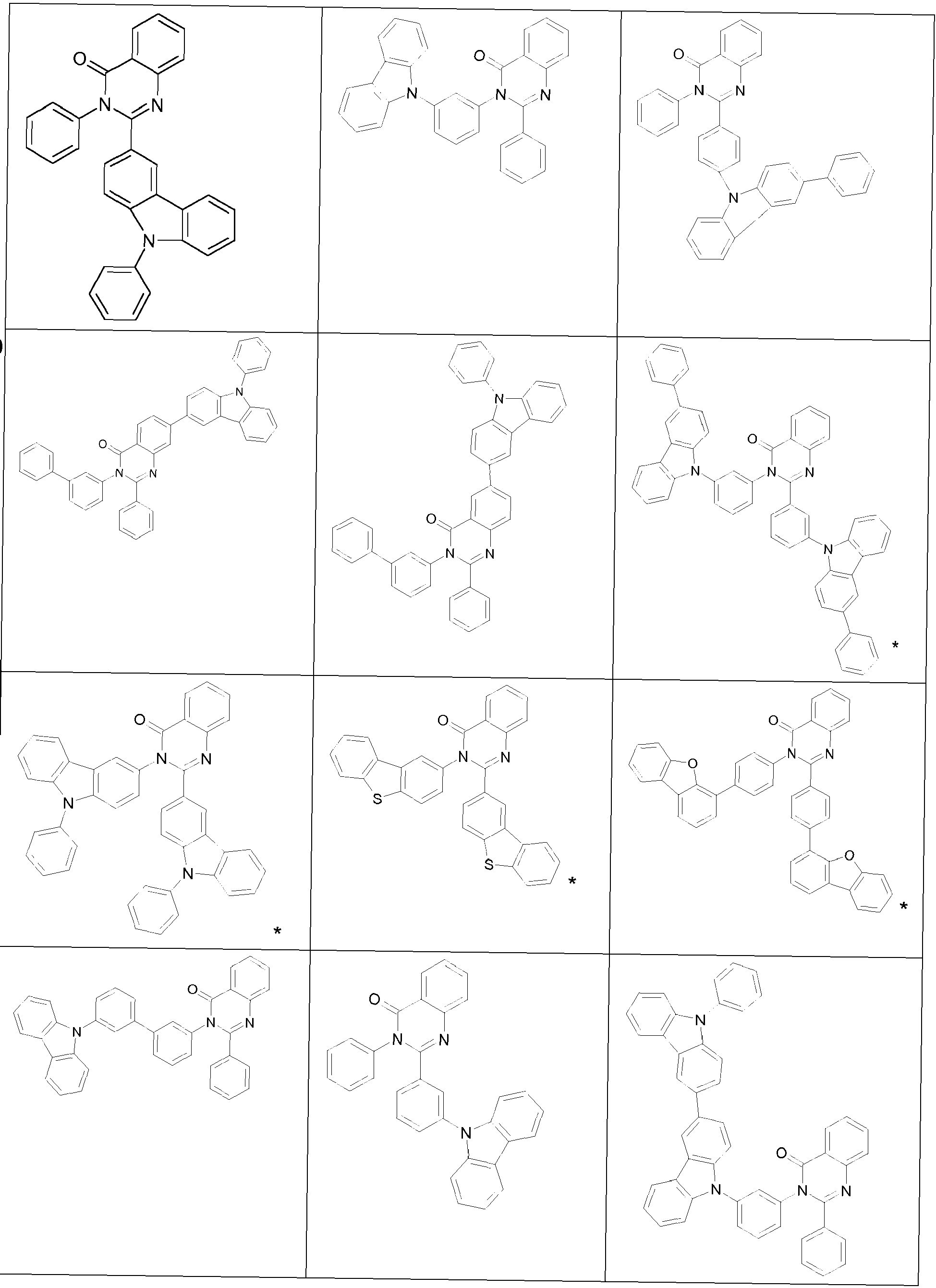

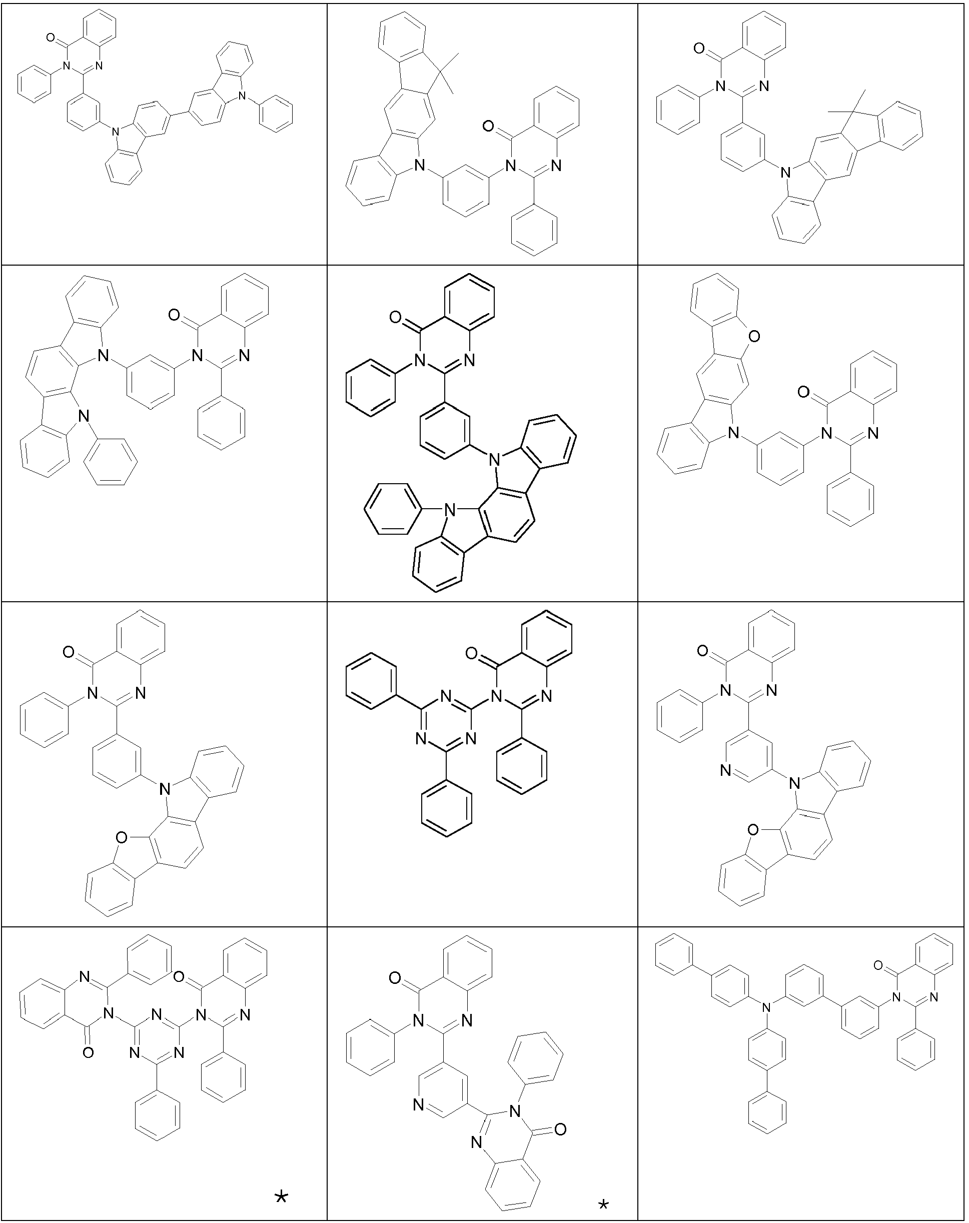

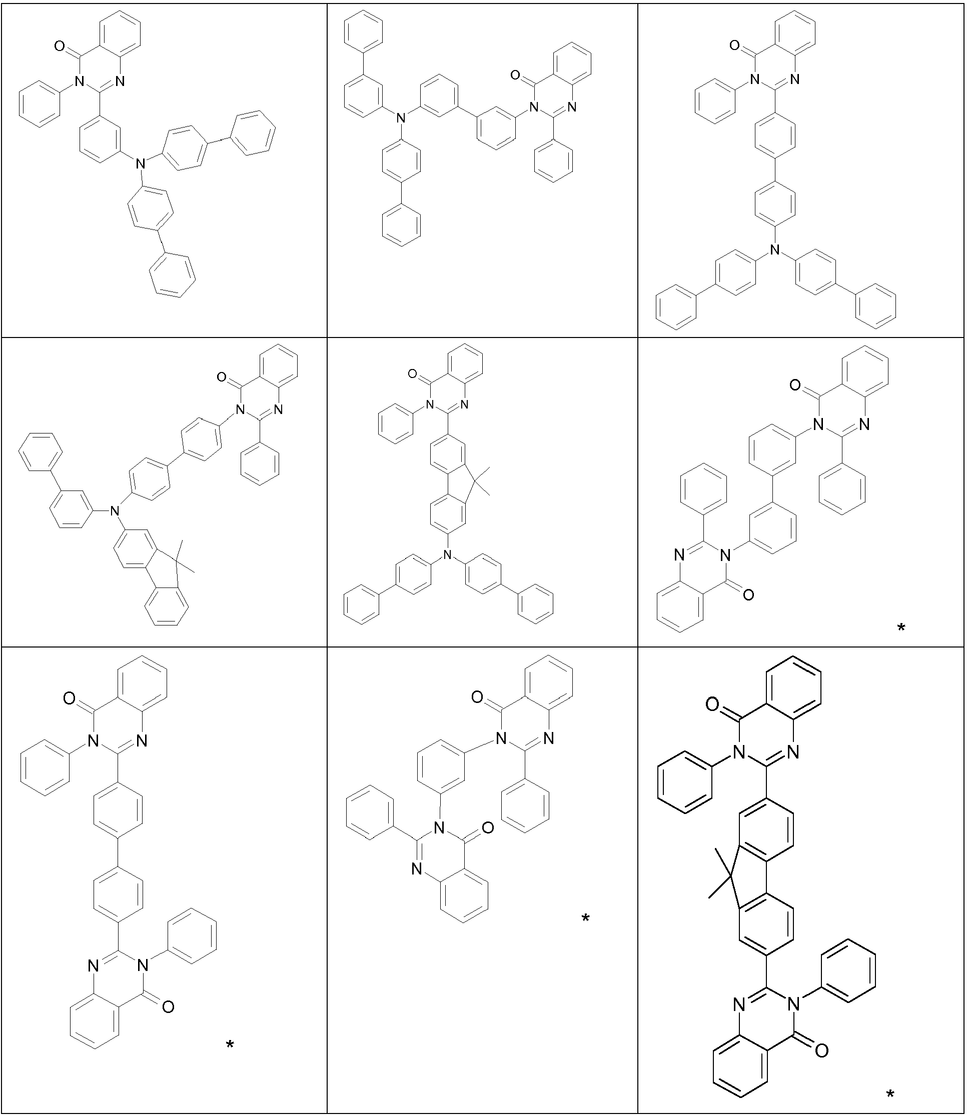

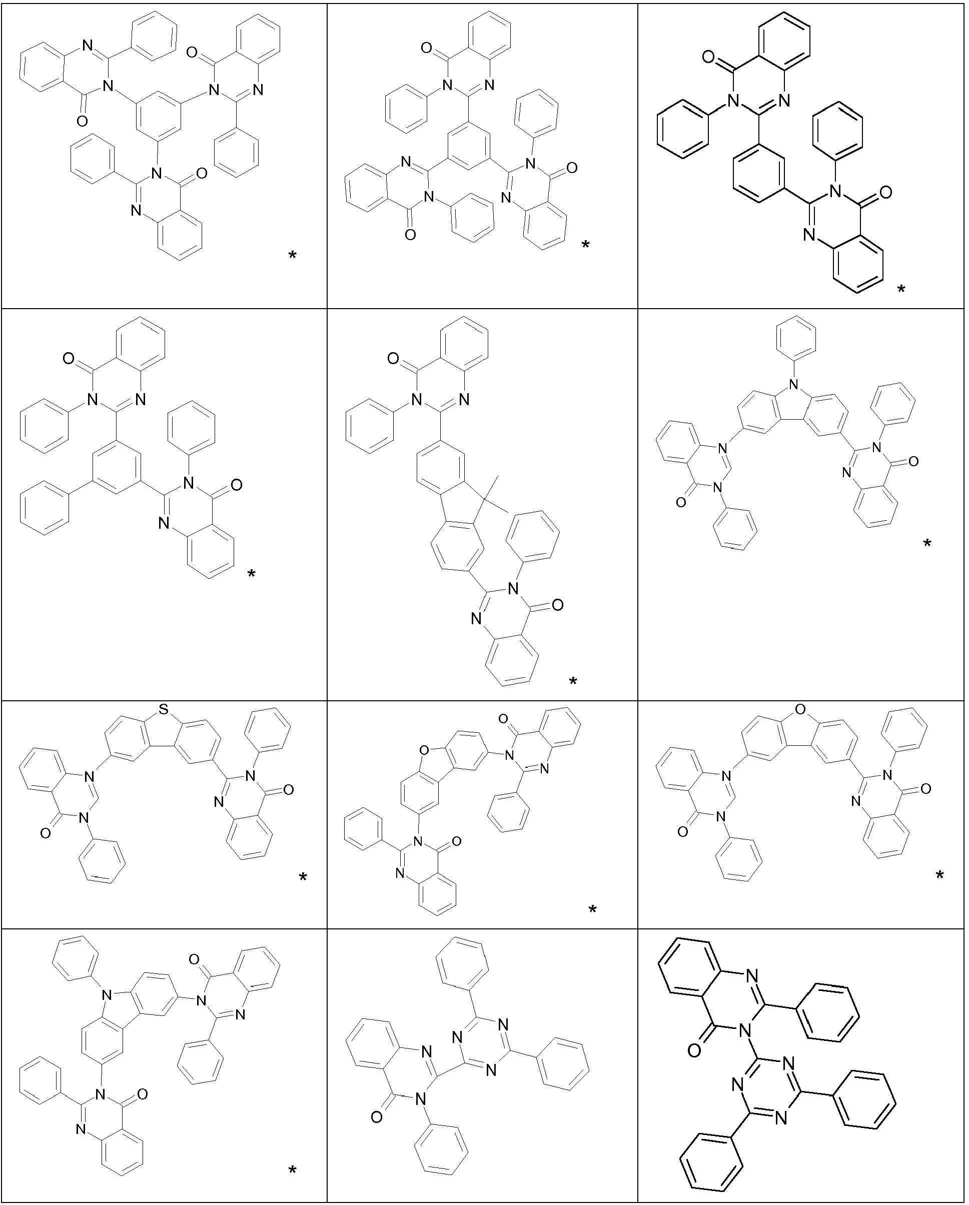

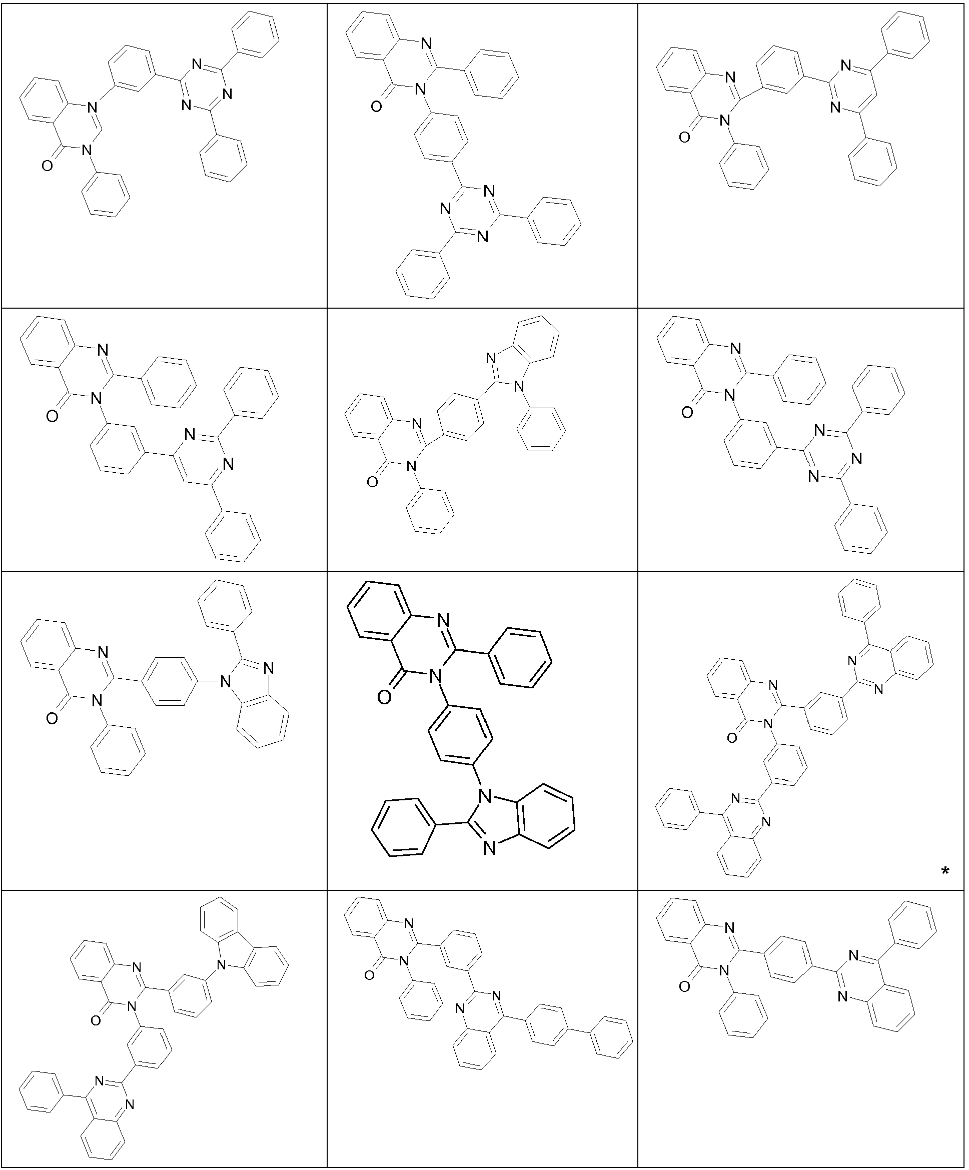

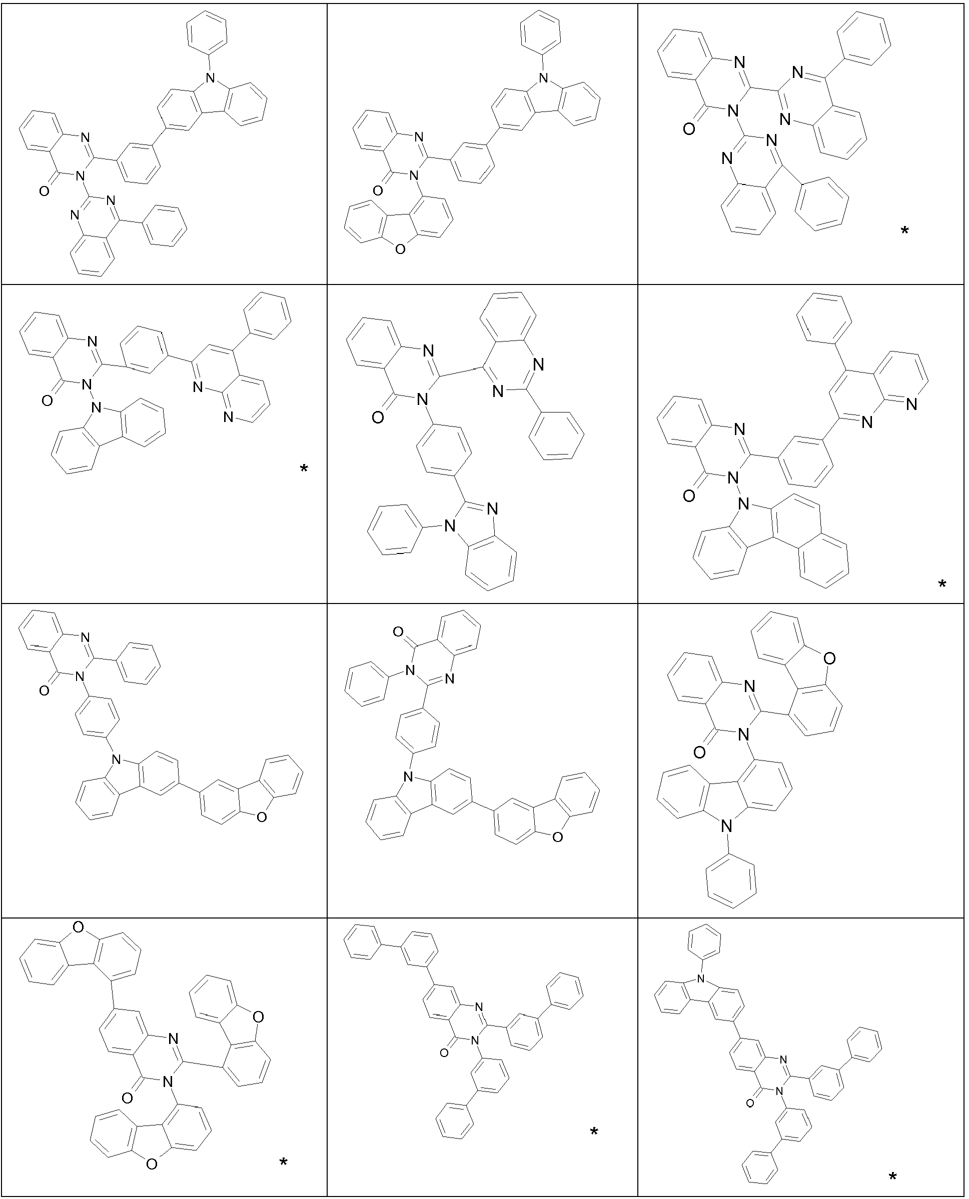

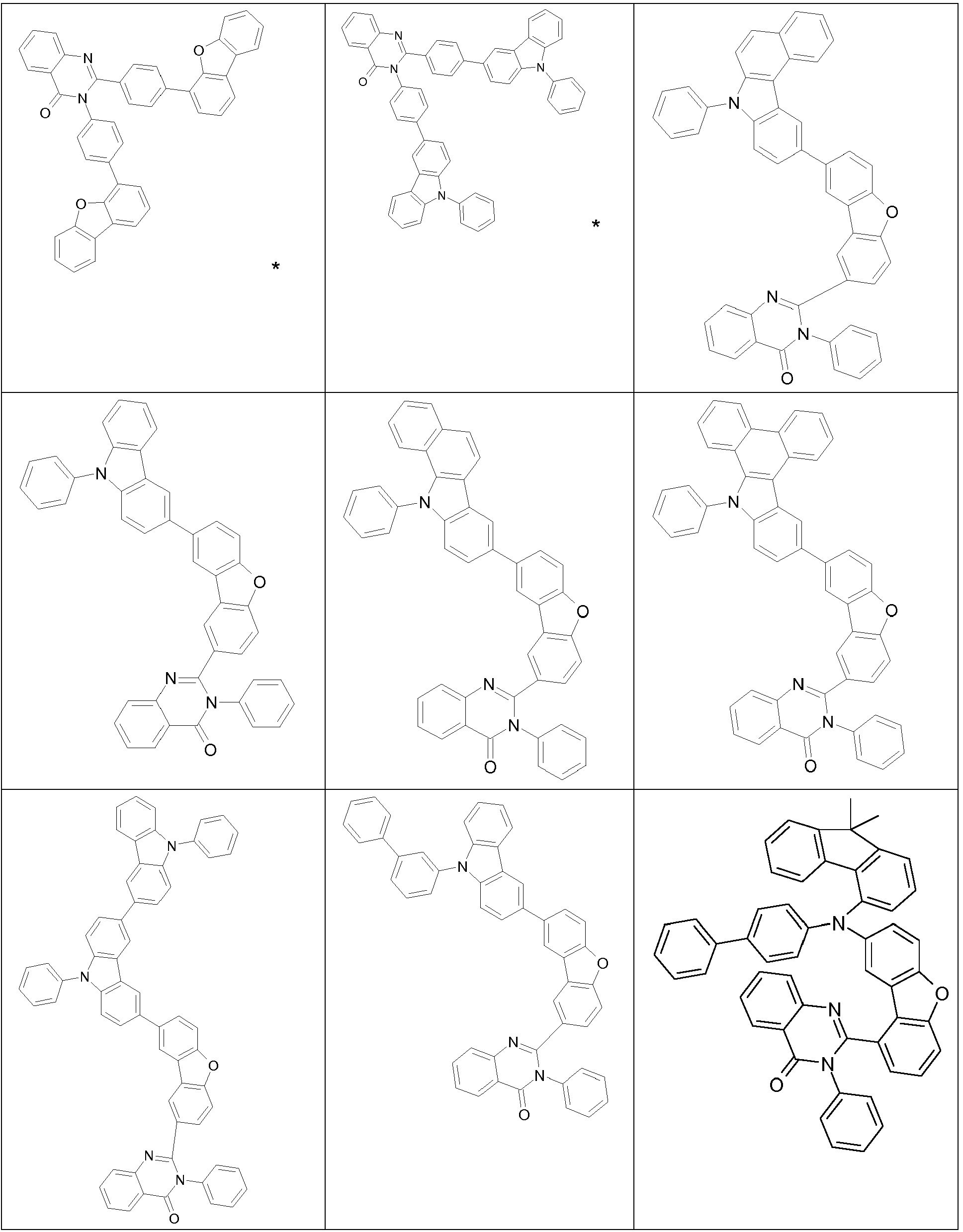

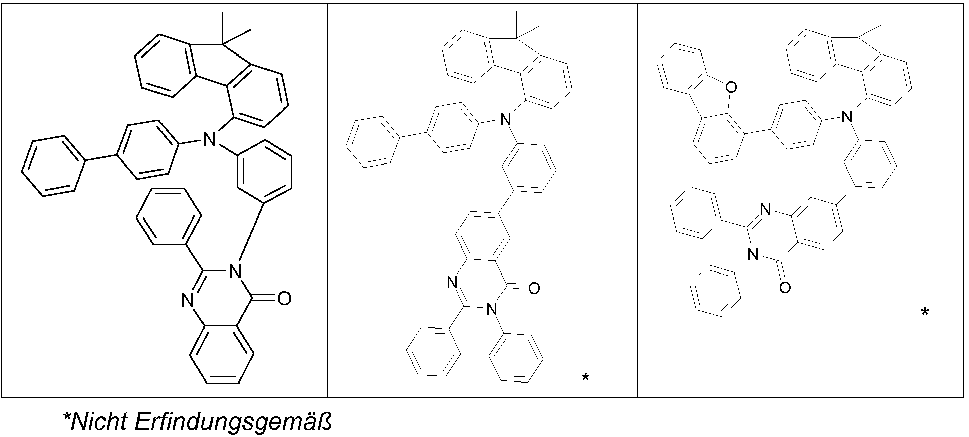

Die erfindungsgemäßen Verbindungen können nach dem Fachmann bekannten Syntheseschritten, wie z. B. Bromierung, Suzuki-Kupplung, Ullmann-Kupplung, Hartwig-Buchwald-Kupplung, etc., dargestellt werden.

Die Herstellung des Quinazolinon-Grundgerüsts erfolgt beispielsweise ausgehend von 4H-3,1-Benzoxazine-2,4(1*H*)-dion und Reaktion mit einem Amin und einem Aldehyd, bevorzugt mit einem aromatischen Amin und einem aromatischen Aldehyd. Danach wird die Verbindung zum Quinazolinon-Grundgerüst oxidiert. Dies kann mit üblichen Oxidationsmittel geschehen, wie Iod oder Kaliumpermanganat. Bei Verwendung einer Gruppe mit mehr als einer Amino- und/oder Aldehydgruppe können Verbindungen der Formel (2) erhalten werden.

Wenn die eingesetzten Verbindungen weitere geeignete Gruppen aufweisen, können Verbindungen einer der Formeln (3) durch eine oder mehrere Kupplungsreaktionen, Umlagerungen und/oder Zyklisierungen aufgebaut werden.

Ein weiterer Gegenstand der vorliegenden Erfindung ist daher ein Verfahren zur Herstellung einer Verbindung gemäß Formel (3) wobei die Verbindung der Formel (3) durch eine oder mehrere Kupplungsreaktionen, Umlagerungen und/oder Zyklisierungen aufgebaut wird.

Die oben gezeigten Syntheseverfahren haben exemplarischen Charakter und können vom Fachmann auf dem Gebiet der organischen Synthese in geeigneter Weise abgewandelt werden, wenn dies für die Synthese bestimmter Ausführungsformen von erfindungsgemäßen Verbindungen vorteilhaft ist.

Die oben beschriebenen erfindungsgemäßen Verbindungen, insbesondere Verbindungen, welche mit reaktiven Abgangsgruppen, wie Brom, Iod, Chlor, Boronsäure oder Boronsäureester, substituiert sind, können als Monomere zur Erzeugung entsprechender Oligomere, Dendrimere oder Polymere Verwendung finden. Geeignete reaktive Abgangsgruppen sind beispielsweise Brom, Iod, Chlor, Boronsäuren, Boronsäureester, Amine, Alkenyl- oder Alkinylgruppen mit endständiger C-C-Doppelbindung bzw. CC-Dreifachbindung, Oxirane, Oxetane, Gruppen, die eine Cycloaddition, beispielsweise eine 1,3-dipolare Cycloaddition, eingehen, wie beispielsweise Diene oder Azide, Carbonsäurederivate, Alkohole und Silane.

Weiterere Gegenstände der Erfindung sind daher Oligomere, Polymere oder Dendrimere enthaltend eine oder mehrere Verbindungen gemäß Formel (3), wobei die Bindung(en) zum Polymer, Oligomer oder Dendrimer an beliebigen freien Positionen in Formel (3) lokalisiert sein können. Je nach Verknüpfung der erfindungsgemäßen Verbindung ist die Verbindung Bestandteil einer Seitenkette des Oligomers oder Polymers oder Bestandteil der Hauptkette.

Unter einem Oligomer im Sinne dieser Erfindung wird eine Verbindung verstanden, welche aus mindestens drei Monomereinheiten aufgebaut ist. Unter einem Polymer im Sinne der Erfindung wird eine Verbindung verstanden, die aus mindestens zehn Monomereinheiten aufgebaut ist.

Die erfindungsgemäßen Polymere, Oligomere oder Dendrimere können konjugiert, teilkonjugiert oder nicht-konjugiert sein. Die erfindungsgemäßen Oligomere oder Polymere können linear, verzweigt oder dendritisch sein.

In den linear verknüpften Strukturen können die Einheiten gemäß Formel (3) direkt miteinander verknüpft sein oder sie können über eine bivalente Gruppe, beispielsweise über eine substituierte oder unsubstituierte Alkylengruppe, über ein Heteroatom oder über eine bivalente aromatische oder heteroaromatische Gruppe miteinander verknüpft sein.

In verzweigten und dendritischen Strukturen können beispielsweise 3, 5 oder mehrere Einheiten gemäß Formel (3) über eine trivalente oder höhervalente Gruppe, beispielsweise über eine trivalente oder höhervalente aromatische oder heteroaromatische Gruppe, zu einem verzweigten bzw. dendritischen Oligomer oder Polymer verknüpft sein.

Für die Wiederholeinheiten gemäß Formel (3) in Oligomeren, Dendrimeren und Polymeren gelten dieselben Bevorzugungen wie oben für die erfindungsgemäßen Verbindungen beschrieben.

Zur Herstellung der Oligomere oder Polymere werden die erfindungsgemäßen Monomere homopolymerisiert oder mit weiteren Monomeren copolymerisiert. Geeignete und bevorzugte Comonomere sind gewählt aus Fluorenen (z. B. gemäß EP 842208 oder WO 2000/22026), Spirobifluorenen (z. B. gemäß EP 707020, EP 894107 oder WO 2006/061181), Paraphenylenen (z. B. gemäß WO 1992/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689 oder WO 2007/006383), cis- und trans-Indenofluorenen (z. B. gemäß WO 2004/041901 oder WO 2004/113412), Ketonen (z. B. gemäß WO2005/040302), Phenanthrenen (z. B. gemäß WO 2005/104264 oder WO 2007/017066) oder auch mehreren dieser Einheiten. Die Polymere, Oligomere und Dendrimere enthalten üblicherweise noch weitere Einheiten, beispielsweise emittierende (fluoreszierende oder phosphoreszierende) Einheiten, wie z. B. Vinyltriarylamine (z. B. gemäß WO 2007/068325) oder phosphoreszierende Metallkomplexe (z. B. gemäß WO 2006/003000), und/oder Ladungstransporteinheiten, insbesondere solche basierend auf Triarylaminen.

Die erfindungsgemäßen Polymere, Oligomere und Dendrimere weisen vorteilhafte Eigenschaften, insbesondere hohe Lebensdauern, hohe Effizienzen und gute Farbkoordinaten auf.

Die erfindungsgemäßen Polymere und Oligomere werden in der Regel durch Polymerisation von einer oder mehreren Monomersorten hergestellt, von denen mindestens ein Monomer im Polymer zu Wiederholungseinheiten der Formel (3) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) SUZUKI-Polymerisation
(B) YAMAMOTO-Polymerisation
(C) STILLE-Polymerisation und
(D) HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in WO 2003/048225, WO 2004/037887 und WO 2004/037887, im Detail beschrieben.

Gegenstand der vorliegenden Erfindung ist somit auch ein Verfahren zur Herstellung der erfindungsgemäßen Polymere, Oligomere und Dendrimere, das dadurch gekennzeichnet ist, dass sie durch Polymerisation gemäß SUZUKI, Polymerisation gemäß YAMAMOTO, Polymerisation gemäß STILLE oder Polymerisation gemäß HARTWIG-BUCHWALD hergestellt werden. Die erfindungsgemäßen Dendrimere können durch dem Fachmann bekannte Verfahren oder in Analogie dazu hergestellt werden. Geeignete Verfahren sind in der Literatur beschrieben, wie z. B. in Frechet, Jean M. J.; Hawker, Craig J., "Hyperbranched polyphenylene and hyperbranched polyesters: new soluble, three-dimensional, reactive polymers", Reactive & Functional Polymers (1995), 26(1-3), 127-36; Janssen, H. M.; Meijer, E. W., "The synthesis and characterization of dendritic molecules", Materials Science and Technology (1999), 20 (Synthesis of Polymers), 403-458; Tomalia, Donald A., "Dendrimer molecules", Scientific American (1995), 272(5), 62-6; WO 2002/067343 A1 und WO 2005/026144 A1 .

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethyl-ether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösemittel.

Gegenstand der Erfindung ist daher weiterhin eine Formulierung, insbesondere eine Lösung, Dispersion oder Emulsion enthaltend mindestens eine Verbindung gemäß Formel (3) oder mindestens ein Polymer, Oligomer oder Dendrimer enthaltend mindestens eine Einheit gemäß Formel (3), sowie mindestens einem phosphoreszierenden Dotanden und sowie mindestens ein Lösungsmittel, bevorzugt ein organisches Lösungsmittel. Wie solche Lösungen hergestellt werden können, ist dem Fachmann bekannt und beispielsweise in WO 2002/072714, WO 2003/019694 und der darin zitierten Literatur beschrieben.

Die erfindungsgemäßen Mischungen eignen sich für die Verwendung in einer elektronischen Vorrichtung. Dabei wird unter einer elektronischen Vorrichtung eine Vorrichtung verstanden, welche mindestens eine Schicht enthält, die mindestens eine organische Verbindung enthält. Das Bauteil kann dabei aber auch anorganische Materialien enthalten oder auch Schichten, welche vollständig aus anorganischen Materialien aufgebaut sind.

Ein weiterer Gegenstand der vorliegenden Erfindung ist daher die Verwendung der erfindungsgemäßen Mischungen in einer elektronischen Vorrichtung, insbesondere in einer organischen Elektrolumineszenzvorrichtung.

Nochmals ein weiterer Gegenstand der vorliegenden Erfindung ist eine elektronische Vorrichtung enthaltend mindestens eine der oben ausgeführten erfindungsgemäßen Mischungen. Dabei gelten die oben für die Verbindung ausgeführten Bevorzugungen auch für die elektronischen Vorrichtungen.

Die elektronische Vorrichtung ist bevorzugt ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen farbstoff-sensibilisierten Solarzellen, organischen optischen Detektoren, organischen Photorezeptoren, organischen Feld-Quench-Devices (O-FQDs), lichtemittierenden elektrochemischen Zellen (LECs), organischen Laserdioden (O-Laser) und "organic plasmon emitting devices" (D. M. Koller et al., Nature Photonics 2008, 1-4), bevorzugt aus organischen Elektrolumineszenzvorrichtungen (OLEDs, PLEDs), insbesondere phosphoreszierenden OLEDs.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Ebenso können zwischen zwei emittierende Schichten Zwischenschichten (Interlayer) eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, sodass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen (für den prinzipiellen Aufbau siehe z. B. WO 2005/011013). Es kann sich dabei um fluoreszierende oder um phosphoreszierende Emissionsschichten handeln oder um Hybrid-Systeme, bei denen fluoreszierende und phosphoreszierende Emissionsschichten miteinander kombiniert werden.

Die erfindungsgemäße Mischung gemäß den oben aufgeführten Ausführungsformen kann dabei in unterschiedlichen Schichten eingesetzt werden, je nach genauer Struktur. Bevorzugt ist eine organische Elektrolumineszenzvorrichtung, umfassend eine erfindungsgemäßt Mischung oder eine Verbindung gemäß Formel (3) oder gemäß den bevorzugten Ausführungsformen als Matrixmaterial für phosphoreszierende Emitter. Dabei gelten die oben aufgeführten bevorzugten Ausführungsformen auch für die Verwendung der Materialien in organischen elektronischen Vorrichtungen.

In einer bevorzugten Ausführungsform der Erfindung wird die Verbindung gemäß Formel (3), bzw. gemäß den bevorzugten Ausführungsformen als Matrixmaterial für eine phosphoreszierende Verbindung in einer emittierenden Schicht eingesetzt. Dabei kann die organische Elektrolumineszenzvorrichtung eine emittierende Schicht enthalten, oder sie kann mehrere emittierende Schichten enthalten, wobei mindestens eine emittierende Schicht mindestens eine erfindungsgemäße Mischung oder eine Verbindung gemäß (3) als Matrixmaterial für eine phosphoreszierende Verbindung enthält.

Eine weitere bevorzugte Ausführungsform der vorliegenden Erfindung ist der Einsatz der Verbindung gemäß Formel (3) bzw. gemäß den bevorzugten Ausführungsformen als Matrixmaterial für einen phosphoreszierenden Emitter in Kombination mit einem weiteren Matrixmaterial. Besonders geeignete Matrixmaterialien, welche in Kombination mit den Verbindungen gemäß Formel (3) bzw. gemäß den bevorzugten Ausführungsformen eingesetzt werden können, sind aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl) oder die in WO 2005/039246, US 2005/0069729, JP 2004/288381, EP 1205527 oder WO 2008/086851 offenbarten Carbazolderivate, Indolocarbazolderivate, z. B. gemäß WO 2007/063754 oder WO 2008/056746, Indenocarbazolderivate, z. B. gemäß WO 2010/136109 und WO 2011/000455, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, überbrückte Carbazol-Derivate, z. B. gemäß US 2009/0136779, WO 2010/050778, WO 2011/042107, WO 2011/088877 oder WO 2012/143080, Triphenylenderivaten, z. B. gemäß WO 2012/048781, oder Lactame, z. B. gemäß WO 2011/116865 oder WO 2011/137951. Ebenso kann ein weiterer phosphoreszierender Emitter, welcher kürzerwellig als der eigentliche Emitter emittiert, als Co-Host in der Mischung vorhanden sein.

Die Mischung aus der Verbindung gemäß Formel (3) bzw. gemäß den bevorzugten Ausführungsformen und der emittierenden Verbindung enthält zwischen 99 und 1 Vol.-%, vorzugsweise zwischen 98 und 10 Vol.-%, besonders bevorzugt zwischen 97 und 60 Vol.-%, insbesondere zwischen 95 und 80 Vol.-% der Verbindung gemäß Formel (3) bzw. gemäß den bevorzugten Ausführungsformen bezogen auf die Gesamtmischung aus Emitter und Matrixmaterial. Entsprechend enthält die Mischung zwischen 1 und 99 Vol.-%, vorzugsweise zwischen 2 und 90 Vol.-%, besonders bevorzugt zwischen 3 und 40 Vol.-%, insbesondere zwischen 5 und 20 Vol.-% des Emitters bezogen auf die Gesamtmischung aus Emitter und Matrixmaterial.

Vom Begriff phosphoreszierende Dotanden (Emitter) sind typischerweise Verbindungen umfasst, bei denen die Lichtemission durch einen spinverbotenen Übergang erfolgt. Es sind Verbindungen, welche bei Raumtemperatur Lumineszenz aus einem angeregten Zustand mit Spinmultiplizität > 1 zeigen, beispielsweise durch einen Übergang aus einem angeregten Triplettzustand oder einem Zustand mit einer höheren Spinquantenzahl, beispielsweise einem Quintett-Zustand. Als phosphoreszierende Dotanden eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende Dotanden Verbindungen, die Kupfer, Molybdän, Wolfram, Rhenium, Ruthenium, Osmium, Rhodium, Iridium, Palladium, Platin, Silber, Gold und/oder Europium enthalten, verwendet, insbesondere Verbindungen, die Iridium, Platin oder Kupfer enthalten.

Dabei werden im Sinne der vorliegenden Erfindung alle lumineszierenden Iridium-, Platin- oder Kupferkomplexe als phosphoreszierende Verbindungen angesehen.

Besonders bevorzugte phosphoreszierende Dotanden sind Verbindungen ausgewählt aus den Formeln (D-1) bis (D-6), 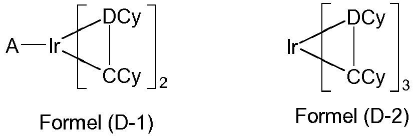 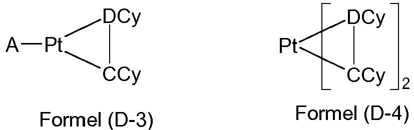 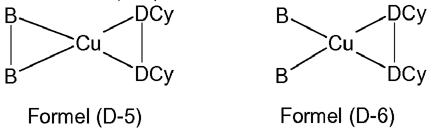 wobei R⁴ dieselbe Bedeutung hat, wie oben für Formel (3) beschrieben, und für die weiteren verwendeten Symbole gilt:
- DCy: ist gleich oder verschieden bei jedem Auftreten eine cyclische Gruppe, die mindestens ein Donoratom, bevorzugt Stickstoff, Kohlenstoff in Form eines Carbens oder Phosphor, enthält oder als Substituenten trägt, über welches die cyclische Gruppe an das Metall gebunden ist, und die wiederum einen oder mehrere Substituenten R⁴ tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R⁴ tragen kann;
- A: ist gleich oder verschieden bei jedem Auftreten ein mono-anionischer, zweizähnig chelatisierender Ligand, bevorzugt ein Diketonatiigand.
- B: ist gleich oder verschieden bei jedem Auftreten eine Verbindung umfassend mindestens ein Donoratom, bevorzugt Stickstoff, Kohlenstoff in Form eines Carbens oder Phosphor, welches an das Metall bindet.

Dabei kann durch Bildung von Ringsystemen zwischen mehreren Resten R⁴ auch eine Brücke zwischen den Gruppen DCy und CCy vorliegen. Weiterhin kann durch Bildung von Ringsystemen zwischen mehreren Resten R⁴ auch eine Brücke zwischen zwei oder drei Liganden CCy-DCy bzw. zwischen ein oder zwei Liganden CCy-DCy und dem Liganden A, bzw. den beiden Liganden DCy-DCy oder DCy-DCy und DCy vorliegen, so dass es sich um ein polydentates bzw. polypodales Ligandensystem handelt. Dies ist insbesondere bevorzugt bei den Pt-Komplexen der Formel (D-4), wobei die Brücke zwischen den beiden CCy-DCy-Liganden bevorzugt ausgewählt ist aus NR⁴ oder C(R⁴)₂.

Bevorzugt ist B ein Phosphanyl- oder Arsanylrest (P(R⁴)₂ oder As(R⁴)₂).

Bevorzugt sind Verbindungen gemäß einer der Fomeln (D-1) bis (D-4).

Die phosphoreszierende Dotanden können als Einzelverbindung oder gebunden an Polymere oder Oligomere vorliegen.

Beispiele für phosphoreszierende Dotanden können den Anmeldungen WO 2000/70655, WO 2001/41512, WO 2002/02714, WO 2002/15645, EP 1191613, EP 1191612, EP 1191614, WO 2004/081017, WO 2005/033244, WO 2005/042550, WO 2005/113563, WO 2006/008069, WO 2006/061182, WO 2006/081973, WO 2009/146770, WO 2005/019373 und US 2005/0258742 entnommen werden. Beispiele für phosphoreszierende Dotanden mit Kupfer finden sich in WO 2013/007707. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind, zur Verwendung in den erfindungsgemäßen Vorrichtungen. Auch kann der Fachmann ohne erfinderisches Zutun weitere phosphoreszierende Komplexe in Kombination mit den erfindungsgemäßen Verbindungen in OLEDs einsetzen.

Beispiele für geeignete phosphoreszierende Dotanden sind in der folgenden Tabelle aufgeführt.

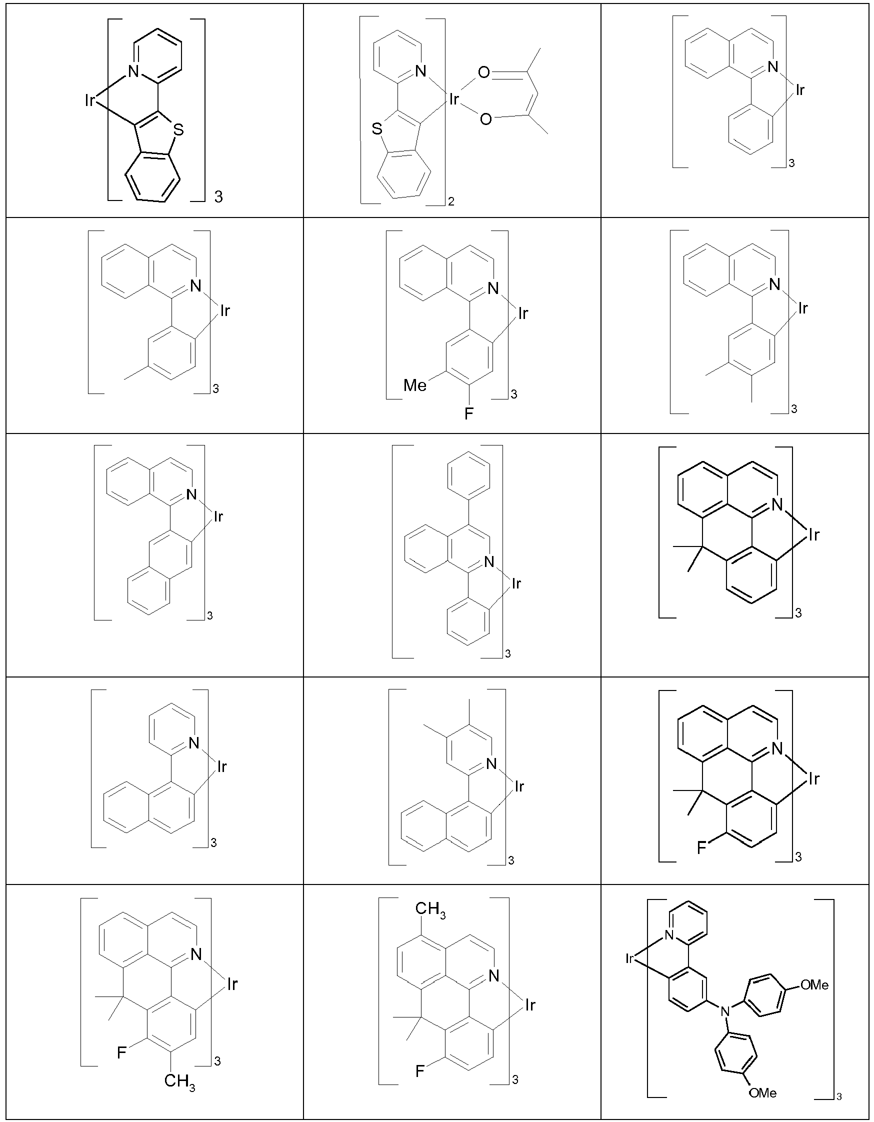

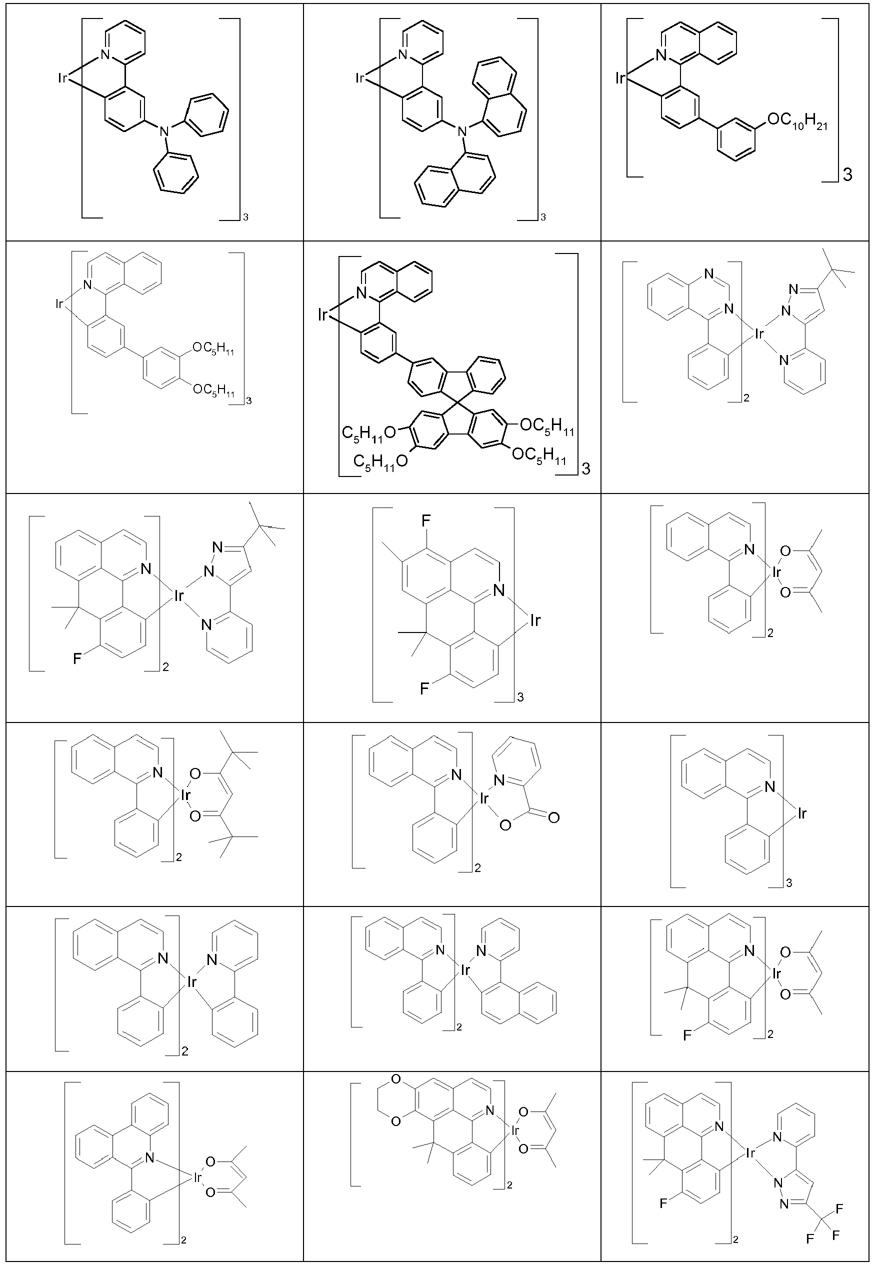

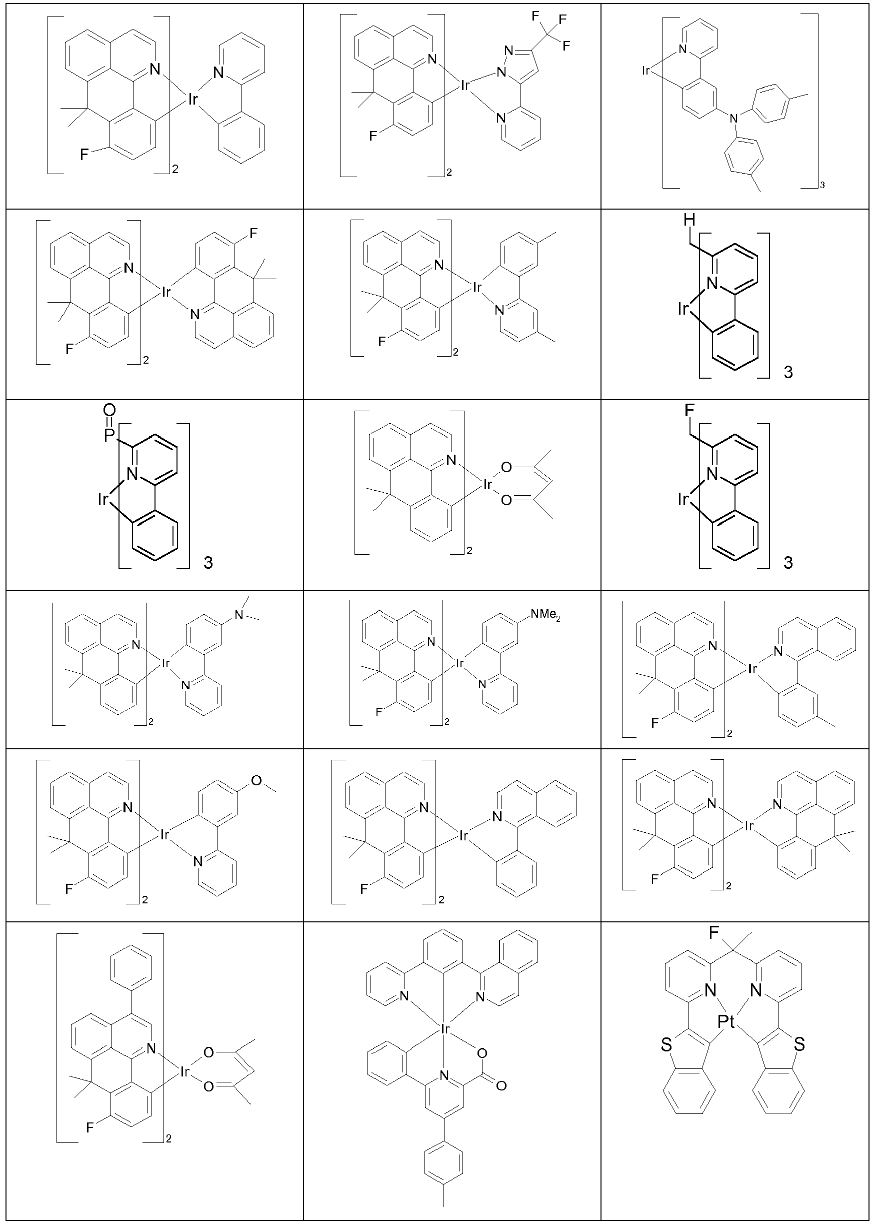

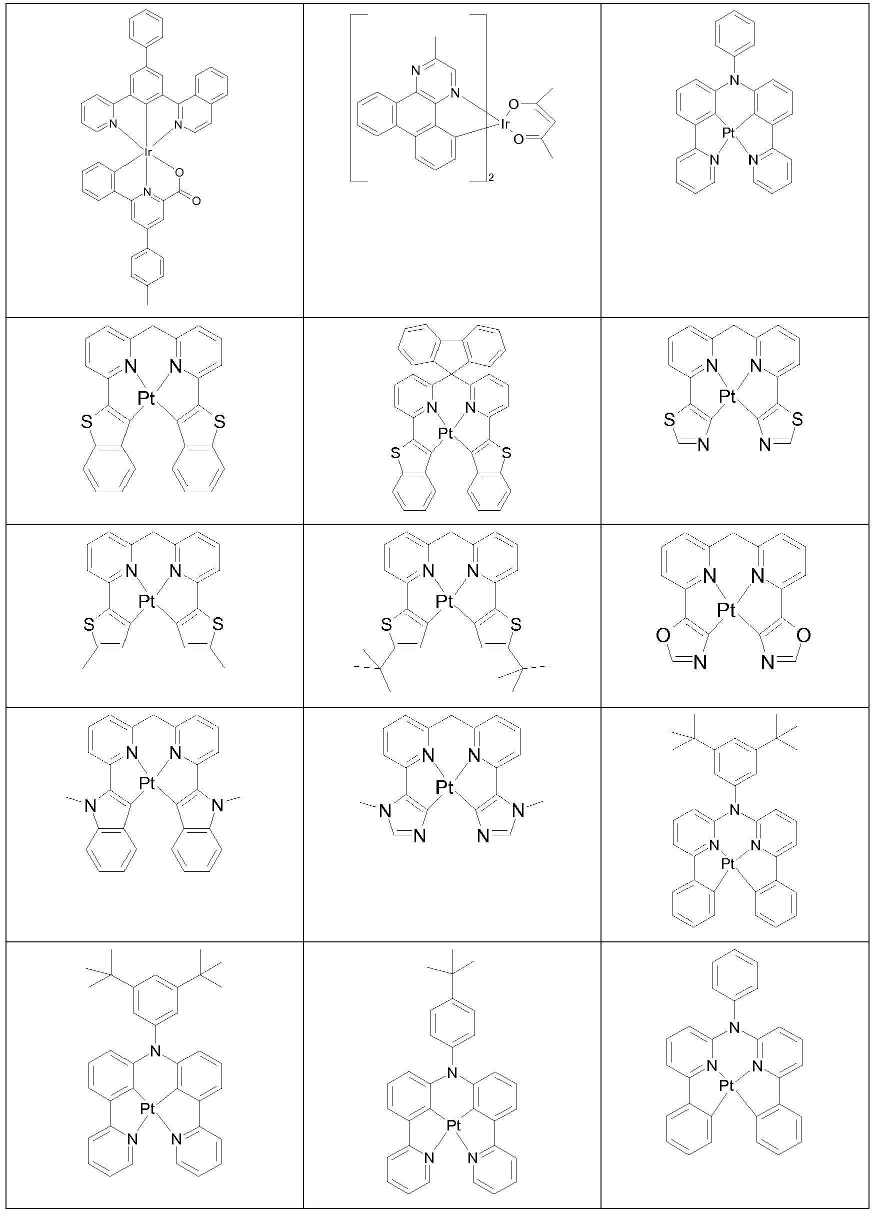

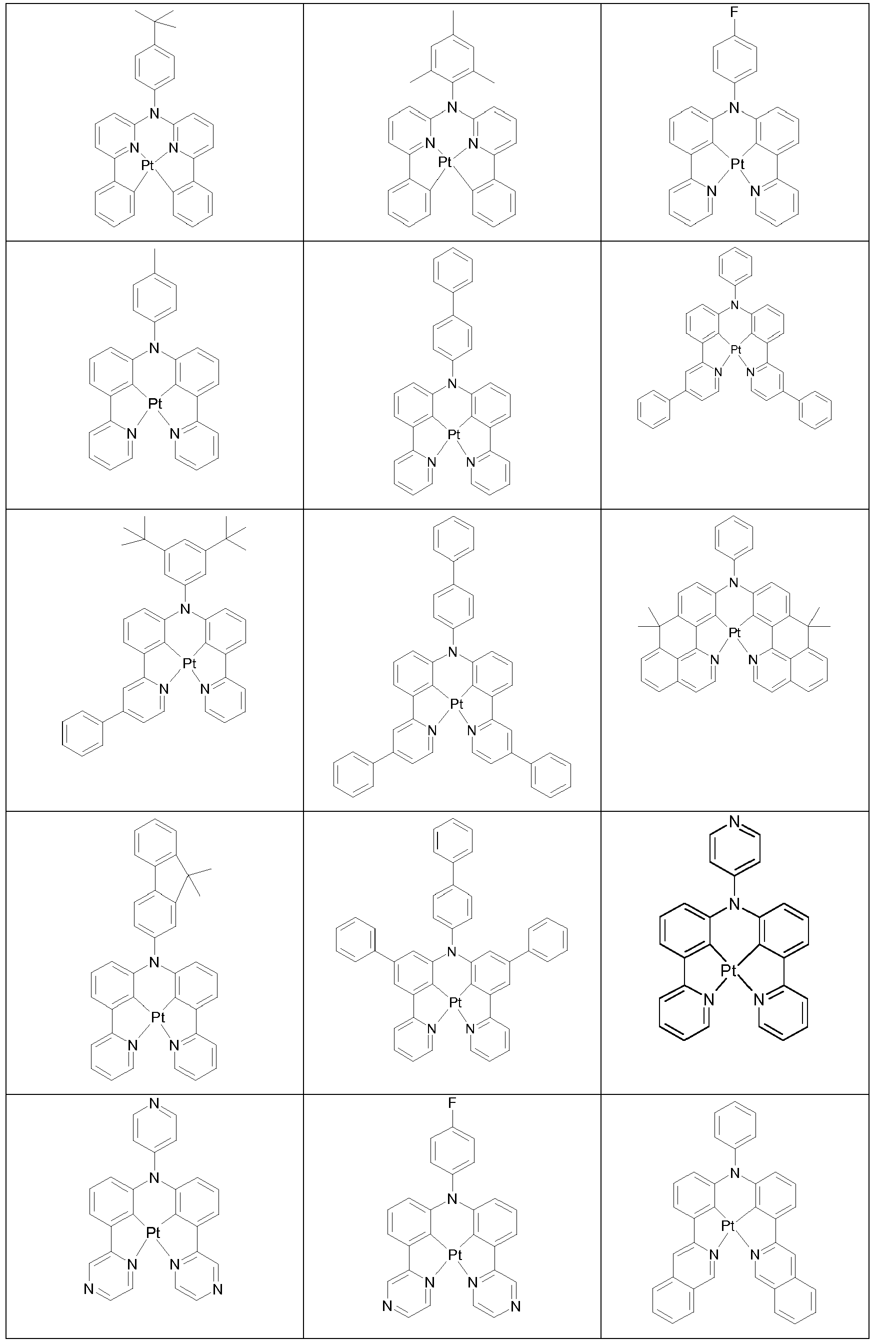

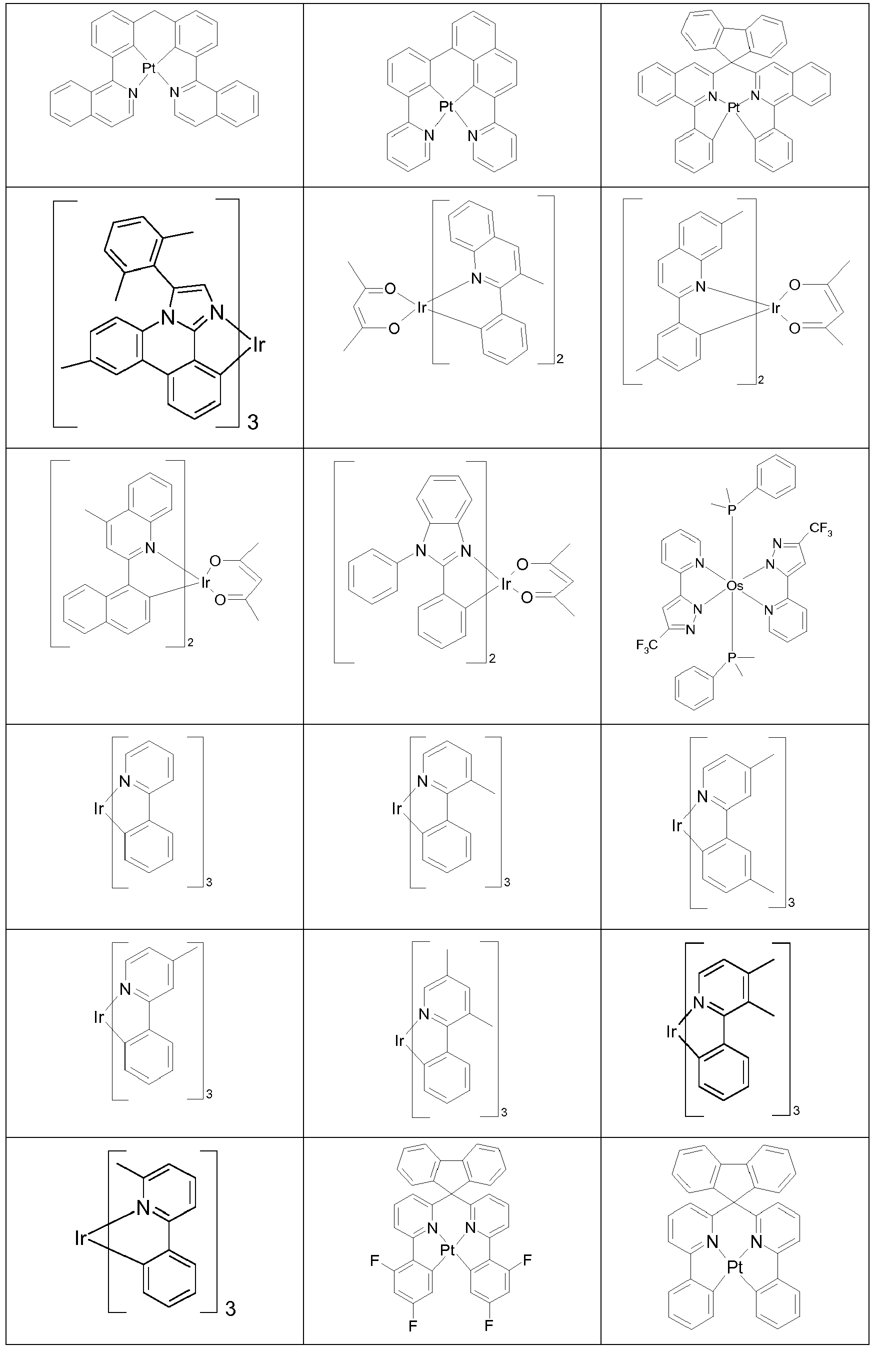

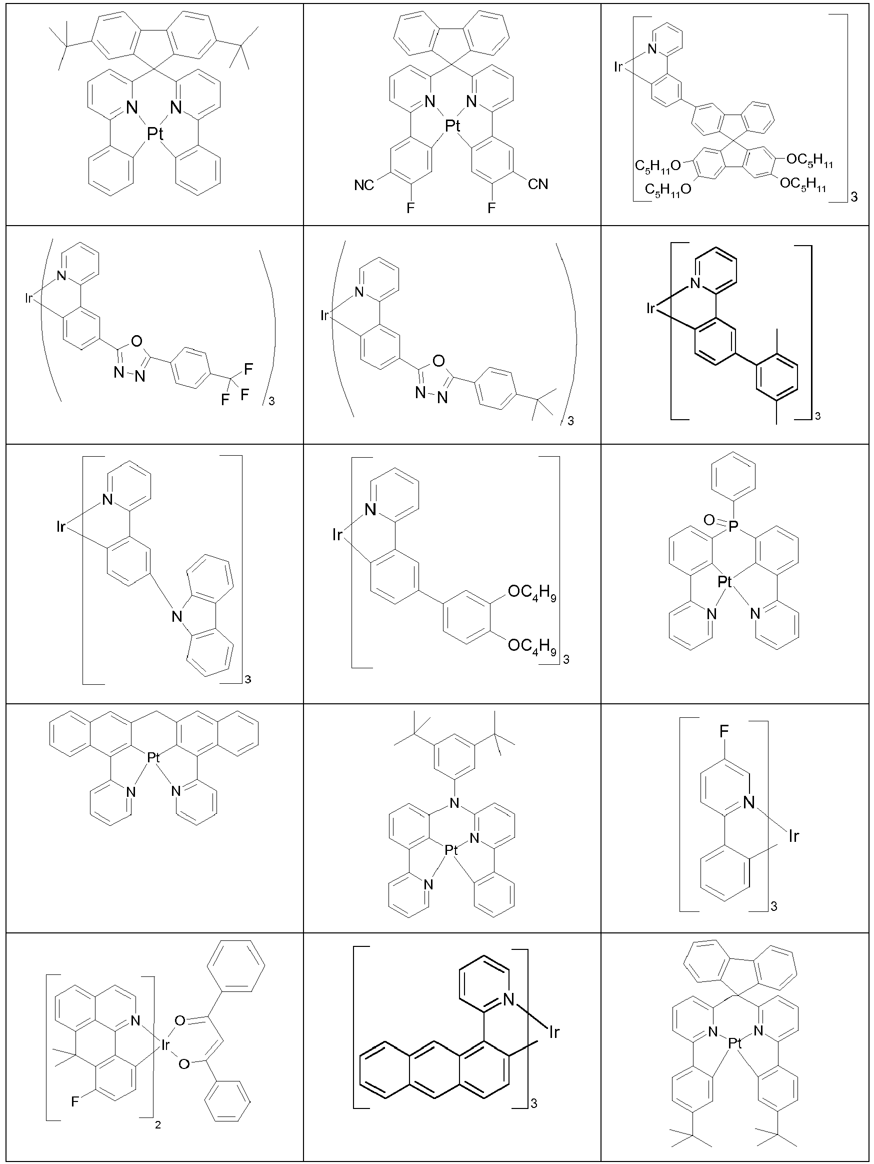

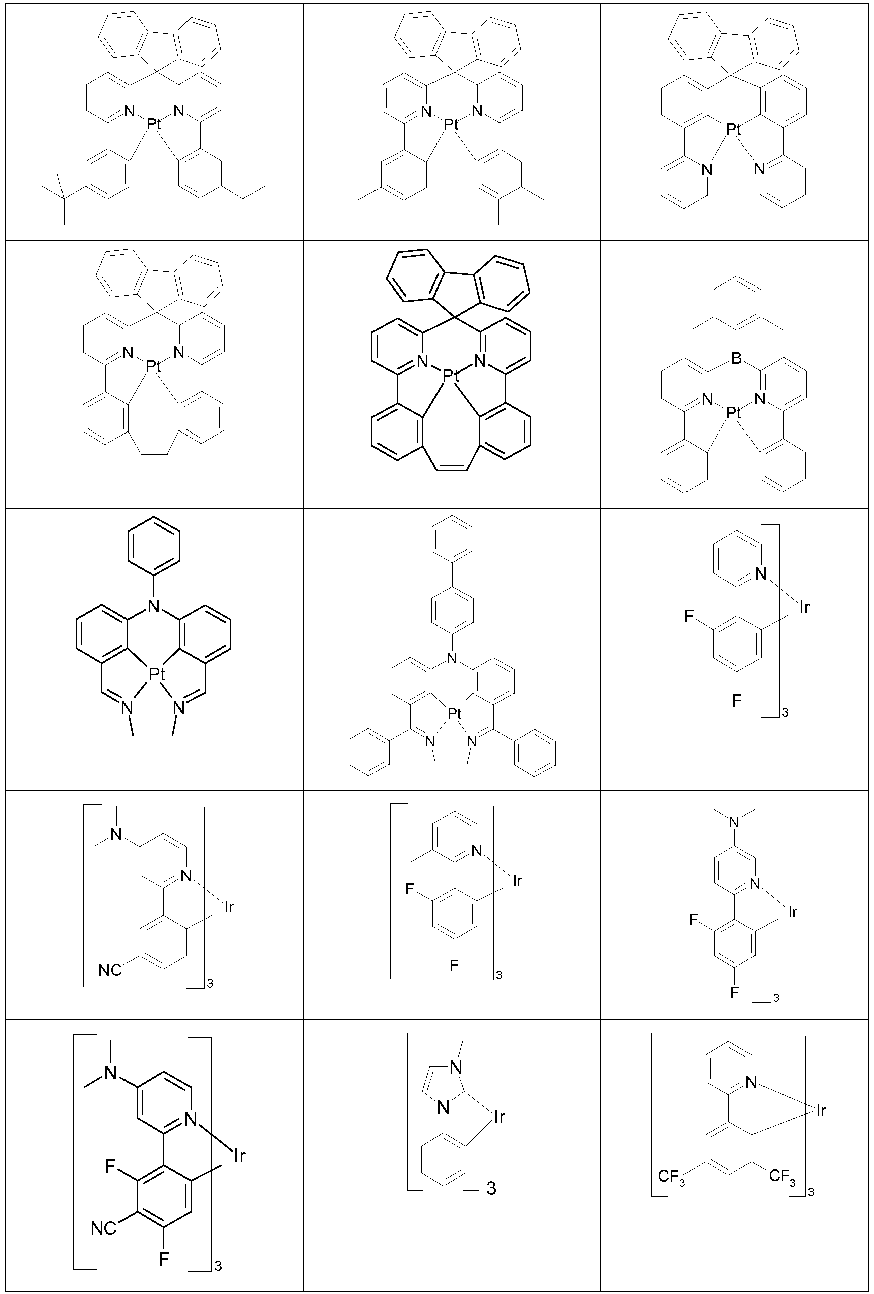

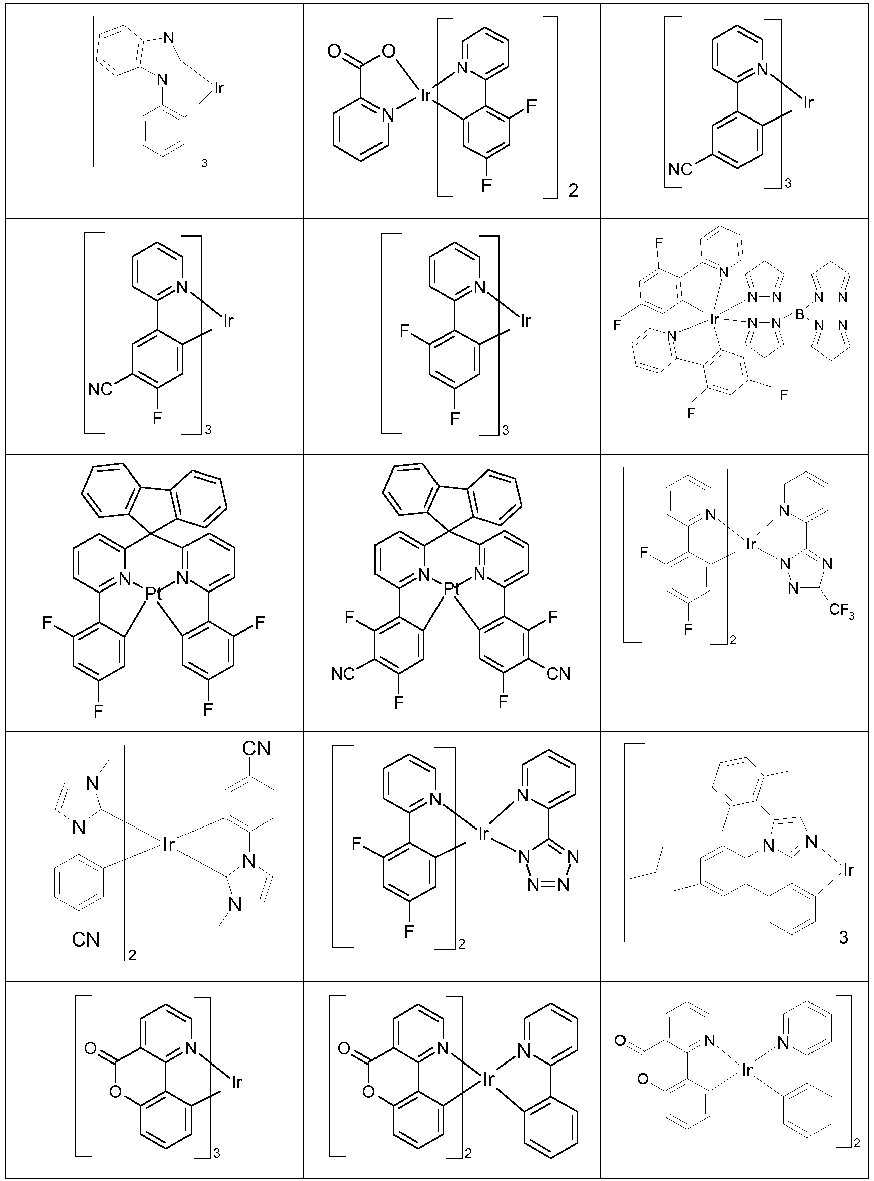

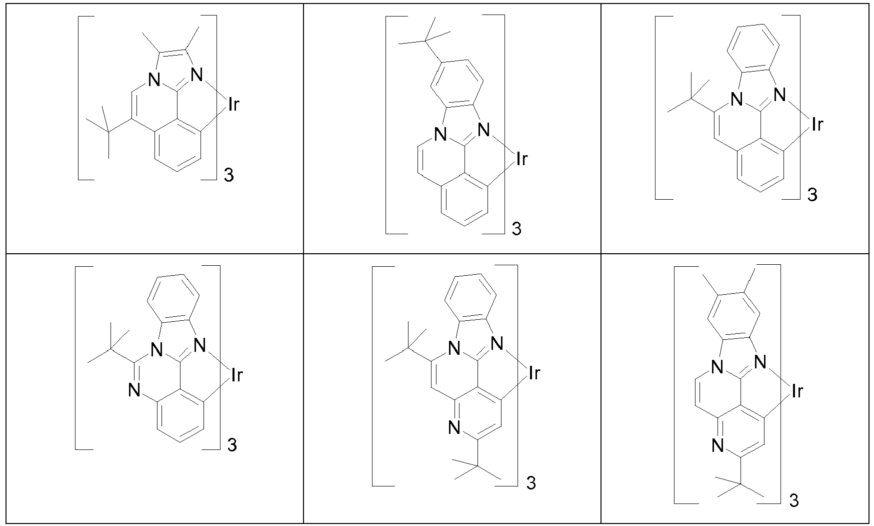

In einer weiteren Ausführungsform der Erfindung enthält die erfindungsgemäße organische Elektrolumineszenzvorrichtung keine separate Lochinjektionsschicht und/oder Lochtransportschicht und/oder Lochblockierschicht und/oder Elektronentransportschicht, d. h. die emittierende Schicht grenzt direkt an die Lochinjektionschicht oder die Anode an, und/ oder die emittierende Schicht grenzt direkt an die Elektronentransportschicht oder die Elektroneninjektionsschicht oder die Kathode an, wie zum Beispiel in WO 2005/053051 beschrieben. Weiterhin ist es möglich, einen Metallkomplex, der gleich oder ähnlich dem Metallkomplex in der emittierenden Schicht ist, direkt angrenzend an die emittierende Schicht als Lochtransport- bzw. Lochinjektionsmaterial zu verwenden, wie z. B. in WO 2009/030981 beschrieben.

In den weiteren Schichten der erfindungsgemäßen organischen Elektrolumineszenzvorrichtung können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit den erfindungsgemäßen Mischungen umfassend die Verbindungen gemäß Formel (3) bzw. gemäß den bevorzugten Ausführungsformen verwenden.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist aber auch möglich, dass der Anfangsdruck noch geringer oder höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Ink-Jet Druck (Tintenstrahldruck), LITI (Light Induced Thermal Imaging, Thermotransferdruck), Siebdruck, Flexodruck, Offsetdruck oder Nozzle-Printing hergestellt werden. Hierfür sind lösliche Verbindungen nötig, welche beispielsweise durch geeignete Substitution erhalten werden. Diese Verfahren eignen sich insbesondere auch für Oligomere, Dendrimere und Polymere.

Weiterhin sind Hybridverfahren möglich, bei denen beispielsweise eine oder mehrere Schichten aus Lösung aufgebracht werden und eine oder mehrere weitere Schichten aufgedampft werden. So ist es beispielsweise möglich, die emittierende Schicht aus Lösung aufzubringen und die Elektronentransportschicht aufzudampfen.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Die erfindungsgemäßen Mischungen weisen bei Verwendung in organischen Elektrolumineszenzvorrichtungen einen oder mehrere der folgenden überraschenden Vorteile gegenüber dem Stand der Technik auf:
1. Die Leistungseffizienz entsprechender Vorrichtungen wird höher im Vergleich zu Systemen gemäß dem Stand der Technik.
2. Die Stabilität entsprechender Vorrichtungen wird höher im Vergleich zu Systemen gemäß dem Stand der Technik, was sich vor allem in einer deutlich höheren Lebensdauer zeigt.
3. Die erfindungsgemäßen organische Elektrolumineszenzvorrichtungen weisen eine verringerte Betriebsspannung auf.
4. Wenn die erfindungsgemäßen Verbindungen als Matrixmaterial für phosphoreszierende Emitter verwendet werden, ist es möglich, mit nur einer geringen Emitterkonzentration im Bereich von weniger als 10 Vol.% bereits sehr gute Ergebnisse zu erzielen.
5. Die erfindungsgemäßen Verbindungen weisen eine sehr gute thermische Stabilität auf.

Die Erfindung wird nun durch die nachfolgenden Beispiele näher erläutert, ohne sie dadurch einschränken zu wollen.

### Ausführungsbeispiele

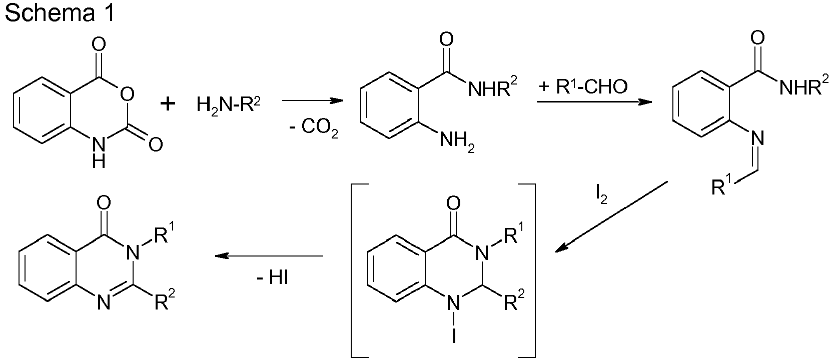

Schema 1 zeigt eine Synthese des Grundgerüsts analog zu Monatshefte fuer Chemie, 141 (8), 877-881; 2010.

Eine zweite Möglichkeit der Synthese zeigen die Schemata 2a, 2b und 2c:

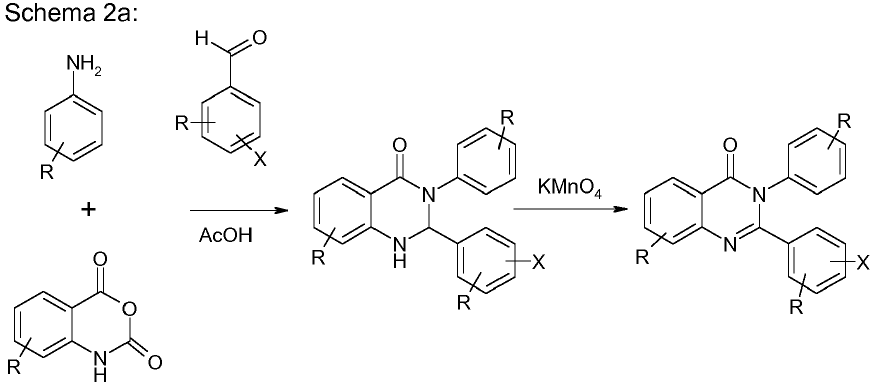

Dabei steht R für einen beliebigen Rest und X für eine Abgangsgruppe wie z. B. eine Halogenid oder Tosylat.

Zunächst wird ein 4H-3,1-Benzoxazine-2,4(1*H*)-dion mit einem Amin und einem Aldehyd unter Säurekatalyse umgesetzt. Man erhält das entsprechende 2,3-Dihydro-1 H-quinazolin-4-on. Dieses lässt sich mit Kaliumpermanganat zu dem Quinazolinon-Grundgerüst oxidieren. Aufgrund der milden Reaktionsbedingungen ist es möglich, substituierte Aromaten zu verwenden. Auf diese Weise lassen sich auf einfache Weise Gruppen einführen, welche weitere Kupplungsreaktionen erlauben.

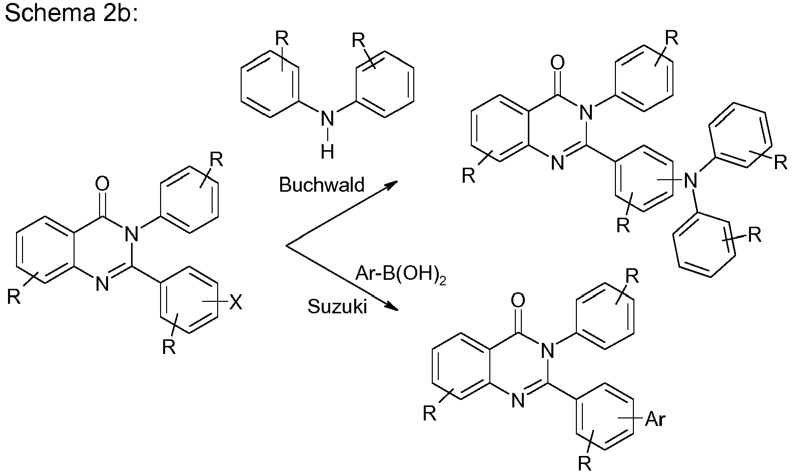

Die eingeführten Abgangsgruppen lassen sich beispielsweise durch metallorganische Kupplungsreaktionen umsetzen. In Schema 2b sind als Beispiel eine Buchwald- oder eine Suzuki-Kupplung angeführt.

Durch mehrfache Kupplungsreaktionen lassen sich die Verbindungen der Formel (2) aufbauen.

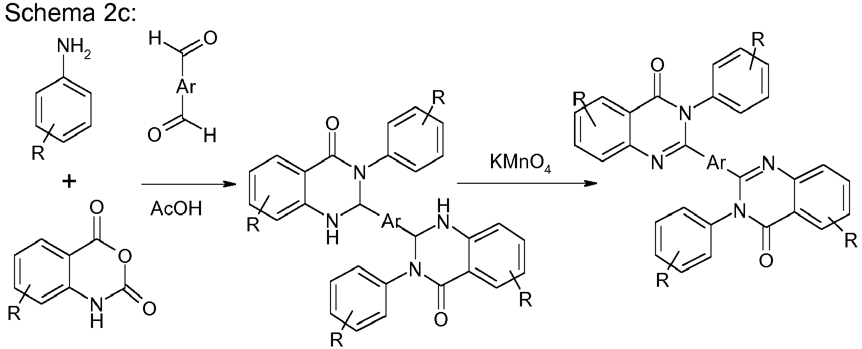

Der Aufbau von Verbindungen der Formel (2) ist auch über die in Schema 2c angegebenen Methode möglich. Dabei wird analog zu Schema 2a ein 4H-3,1-Benzoxazine-2,4(1*H*)-dion-Derivat mit einem Amin und einem Aldehyd unter Säurekatalyse umgesetzt, wobei das Amin und/oder das Aldehyd mindestens eine weitere Amino- und/oder Aldehydgruppe aufweist. Bevorzugt sind an aromatische oder heteroaromatische Ringsysteme gebundene Amino- oder Aldehydgruppen. Dadurch werden mehrere 4H-3,1-Benzoxazine-2,4(1*H*)-dion-Derivate miteinander verknüpft. Die erhaltene Verbindung lässt sich mit Kaliumpermanganat zur Verbindung nach Formel (2) oxidieren.

### Beispiel 1: 2-(4-Bromo-phenyl)-3-phenyl-2,3-dihydro-1H-quinazolin-4-on

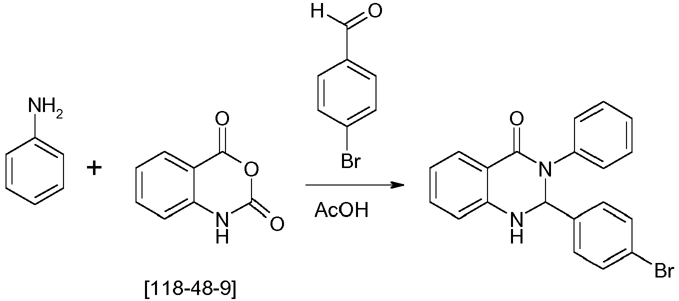

11 ml (121 mmol) Phenylamin und 18 g (110 mmol) 4H-3,1-Benzoxazine-2,4(1*H*)-dion werden im 500 ml Essigsäure refluxiert. Nach 45 min. wird 22,4 g (121 mmol) 4-Brombenzaldehyd gelöst in Essigsäure zugegeben und über Nacht weiter unter Rückfluss gerührt. Nach Abkühlung wird die Lösung mit Wasser/Eis verdünnt und abgesaugt. Der Rückstand wird Heptan und Ethanol ausgerührt. Die Ausbeute beträgt 36 g (95 mmol) 86 % der Theorie.

Analog können folgende Verbindungen erhalten werden:

| **Bsp.** | **Edukt 1** | **Edukt 2** | **Edukt 3** | **Produkt** | **Ausbeute [%]** |
|---|---|---|---|---|---|
| 1a | 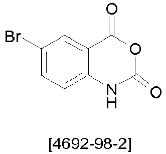 | 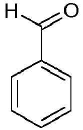 | 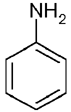 | 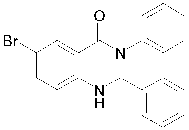 | 82 |
| 1b | 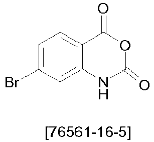 | 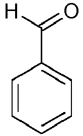 | 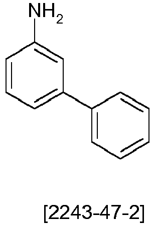 | 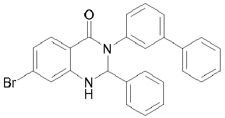 | 86 |
| 1c | 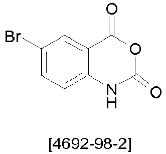 | 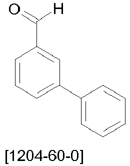 | 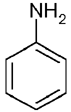 | 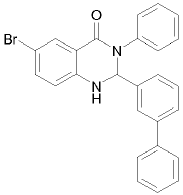 | 74 |
| 1d | 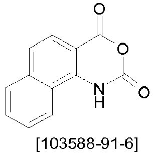 | 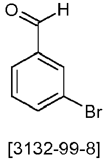 | 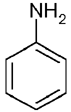 | 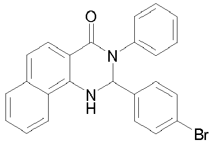 | 70 |
| 1e | 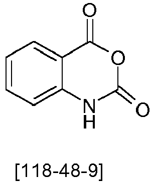 | 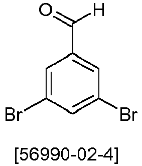 | 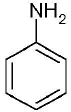 | 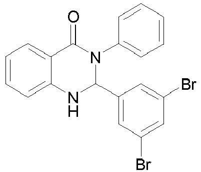 | 80 |
| 1f | 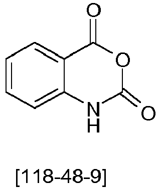 | 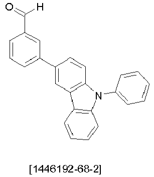 | 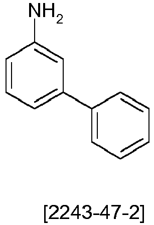 | 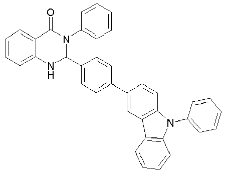 | 68 |
| 1g | 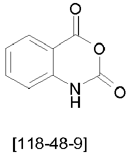 | 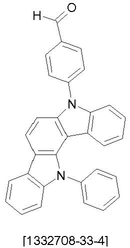 | 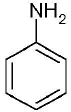 | 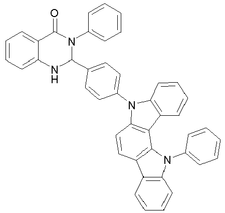 | 79 |
| 1h | 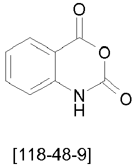 | 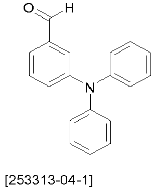 | 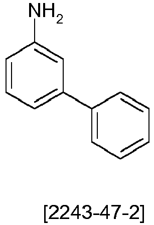 | 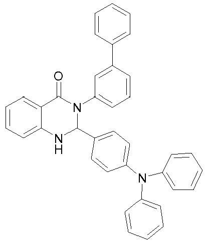 | 84 |
| 1j | 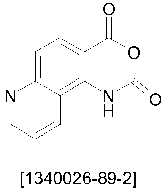 | 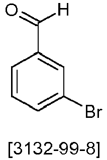 | 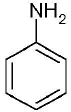 | 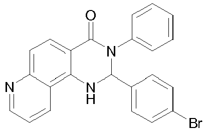 | 78 |
| 1i | 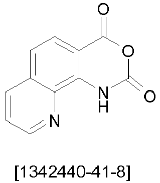 | 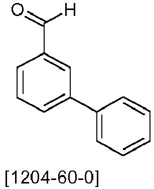 | 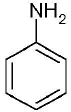 | 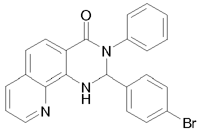 | 81 |
| 1k | 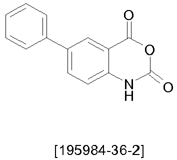 | 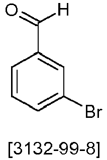 | 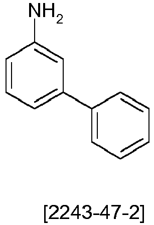 | 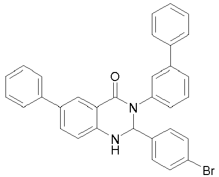 | 76 |
| 1l | 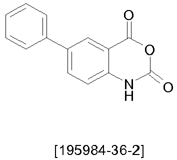 | 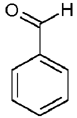 | 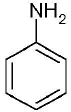 | 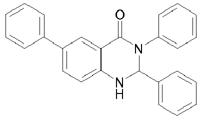 | 76 |
| 1m | 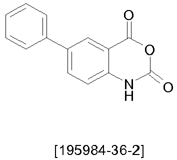 | 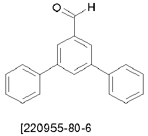 | 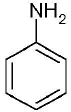 | 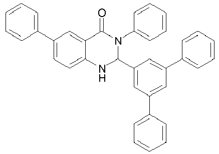 | 65 |
| 1n | 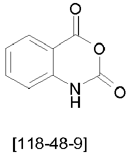 | 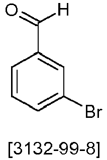 | 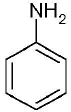 | 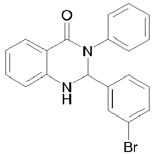 | 70 |
| 1o | 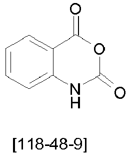 | 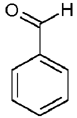 | 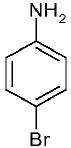 | 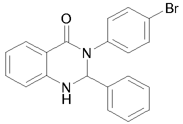 | 87 |

Analog können beim Einsatz bifunktionellen Gruppen folgende Verbindungen erhalten werden:

| **Bsp.** | **Edukt 1** | **Edukt 2** | **Edukt 3** | **Produkt** | **Ausbeute [%]** |
|---|---|---|---|---|---|
| 1p | 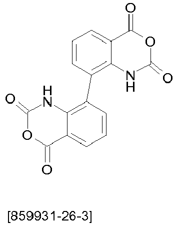 | 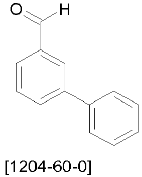 | 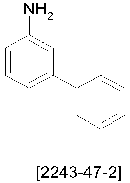 | 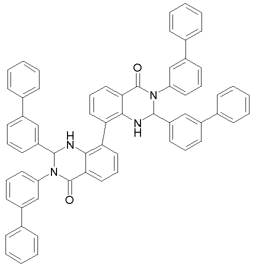 | 67 |
| 1q | 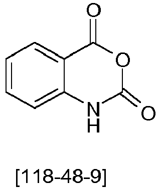 | 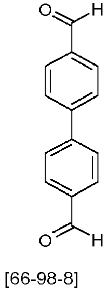 | 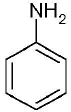 | 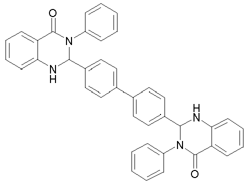 | 61 |
| 1r | 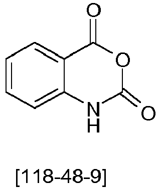 | 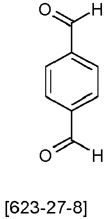 | 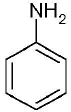 | 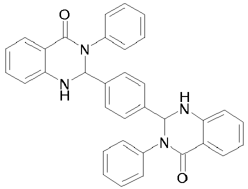 | 59 |
| 1s | 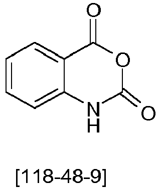 | 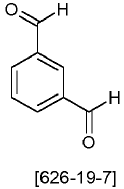 | 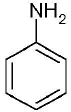 | 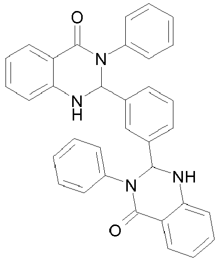 | 48 |
| 1t | 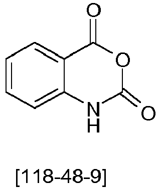 | 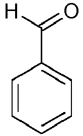 | 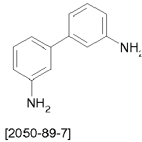 | 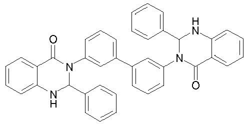 | 56 |

### Beispiel 2: 2-(4-Bromo-phenyl)-3-phenyl-3H-quinazolin-4-on

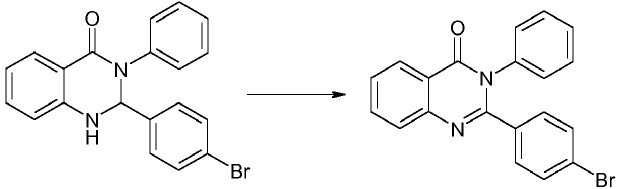

36 g (95 mmol) 2-(4-Bromo-phenyl)-3-phenyl-2,3-dihydro-1 H-quinazolin-4-on werden in 300 mL DMF gelöst. Zu dieser Lösung werden 15 g (95 mmol) Kaliumpermangenat portionsweise zugegeben und 3 Stunden bei Raumtemperatur gerührt. Nach dieser Zeit wird das restliche Kaliumpermangenat abfiltiert, die Lösung eingeengt und Chromatographisch gereinigt (Laufmittel: Heptan/Dichloromethan, 5:1). Der Rückstand wird aus Toluol und aus Dichlormethan / iso-Propanol umkristallisiert und abschließend im Hochvakuum sublimiert, Reinheit beträgt 99,9 %. Die Ausbeute beträgt 22 g (58 mmol) 61 % der Theorie.

Analog können folgende Verbindungen erhalten werden:

| **Bsp.** | **Edukt 3** | **Produkt** | **Ausbeute [%]** |
|---|---|---|---|
| 2a | 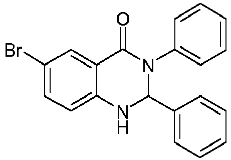 | 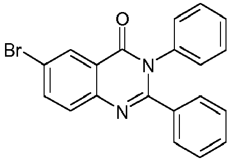 | 82 |
| 2b | 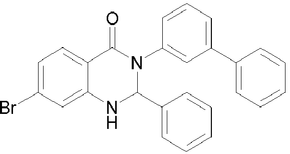 | 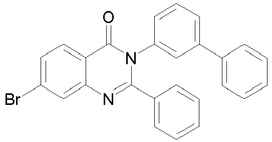 | 86 |
| 2c | 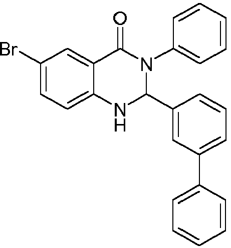 | 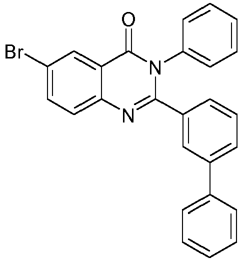 | 74 |
| 2d | 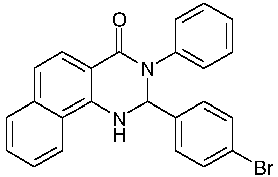 | 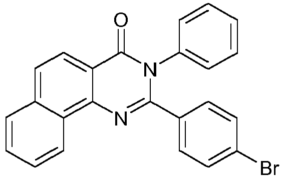 | 70 |
| 2e | 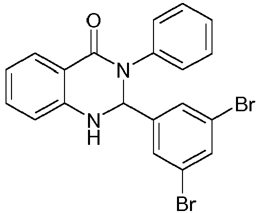 | 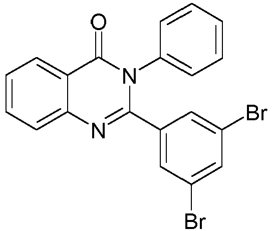 | 80 |
| 2f | 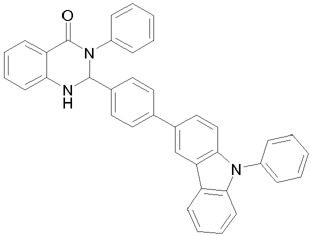 | 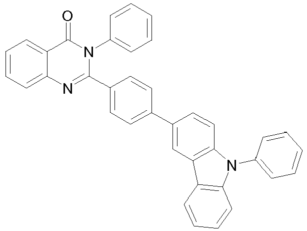 | 68 |
| 2g | 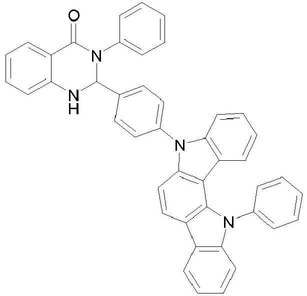 | 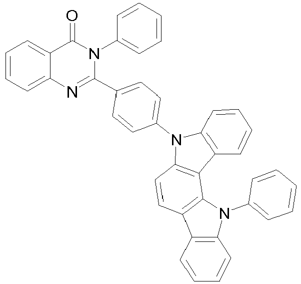 | 79 |
| 2h | 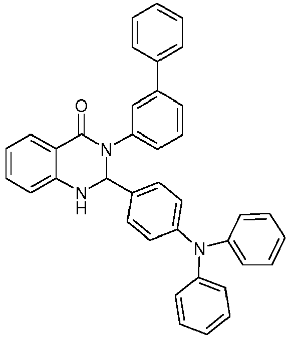 | 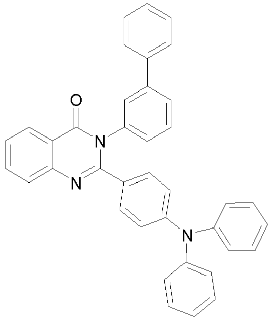 | 84 |
| 2j | 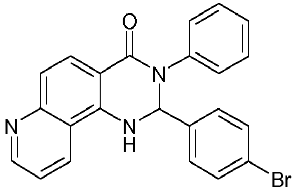 | 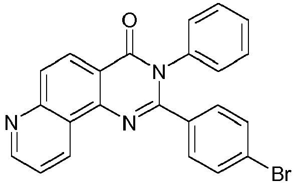 | 78 |
| 2i | 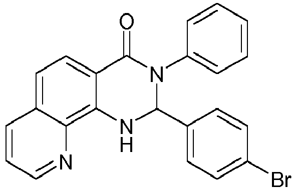 | 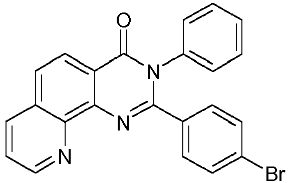 | 81 |
| 2k | 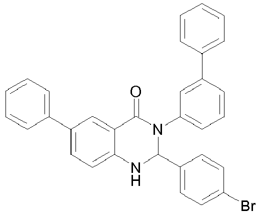 | 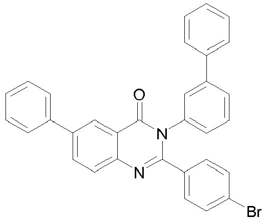 | 76 |
| 2l | 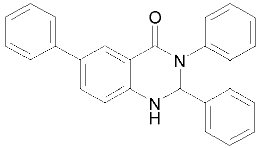 | 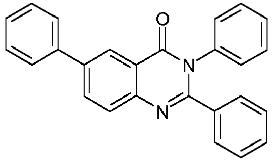 | 82 |
| 2m | 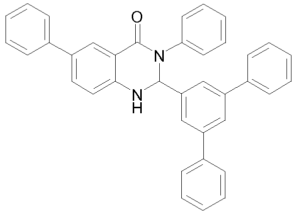 | 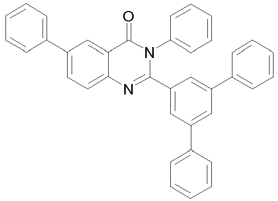 | 79 |
| 2n | 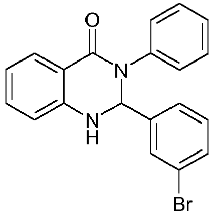 | 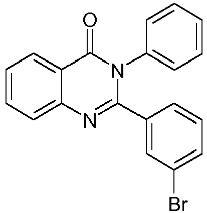 | 81 |
| 2o | 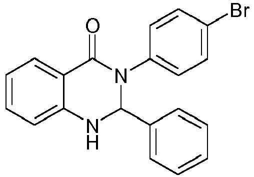 | 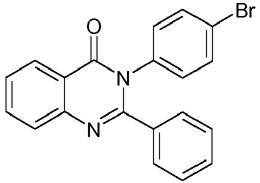 | 83 |

Analog können beim Einsatz von 2 eq. KMnO₄ folgende Verbindungen erhalten werden:

| **Bsp.** | **Edukt 1** | **Produkt** | **Ausbeute [%]** |
|---|---|---|---|
| 2p | 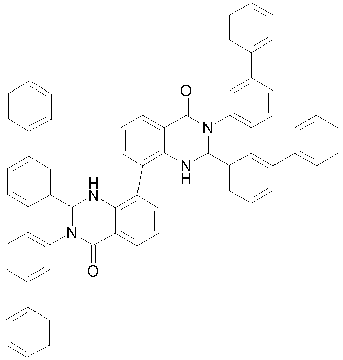 | 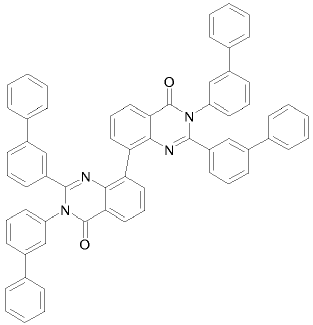 | 67 |
| 2q | 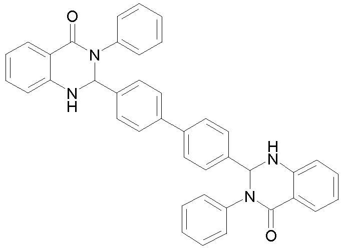 | 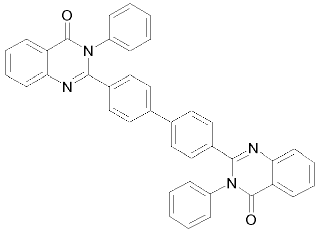 | 61 |
| 2r | 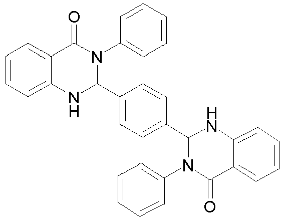 | 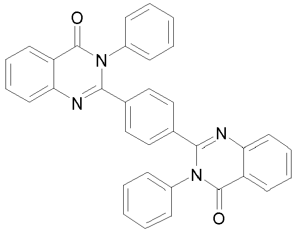 | 59 |
| 2s | 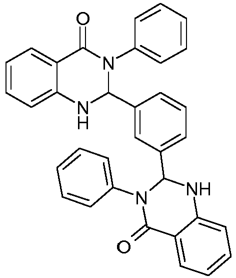 | 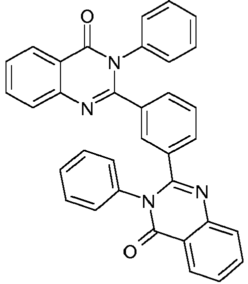 | 48 |
| 2t | 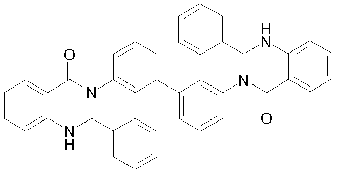 | 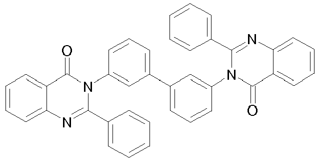 | 56 |

### Beispiel 3: 2-(4-Dibenzofuran-4-yl-phenyl)-3-phenyl-3H-quinazolin-4-on

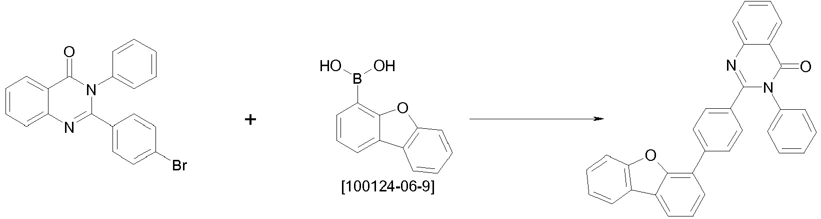

41,3 g (110,0 mmol) 4-dibenzofuranboronsäure, 41 g (110,0 mmol) 2-(4-Bromo-phenyl)-3-phenyl-3H-quinazolin-4-on und 44,6 g (210,0 mmol) Trikaliumphosphat werden in 500 mL Toulol, 500 mL Dioxan und 500 mL Wasser suspendiert. Zu dieser Suspension werden 913 mg (3,0 mmol) Trio-tolylphosphin und dann 112 mg (0,5 mmol) Palladium(ll)acetat gegeben, und die Reaktionsmischung wird 16 h unter Rückfluss erhitzt. Nach Erkalten wird die organische Phase abgetrennt, über Kieselgel filtriert, dreimal mit 200 mL Wasser gewaschen und anschließend zur Trockne eingeengt. Der Rückstand wird aus Toluol und aus Dichlormethan / iso-Propanol umkristallisiert und abschließend im Hochvakuum sublimiert, Reinheit beträgt 99,9 %. Die Ausbeute beträgt 41 g (90 mmol), entsprechend 82% der Theorie.

Analog werden folgende Verbindungen erhalten:

| **Bsp.** | **Edukt 1** | **Edukt 2** | **Produkt** | **Ausbeute [%]** |
|---|---|---|---|---|
| 3a | 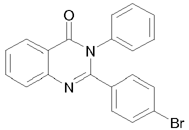 | 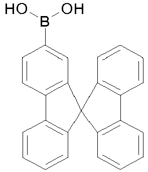 | 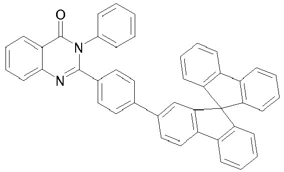 | 83 |
| 3b | 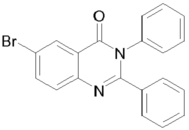 | 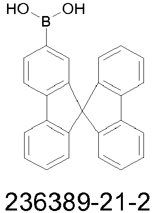 | 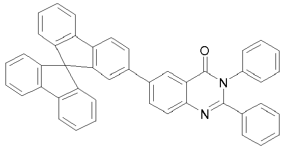 | 82 |
| 3c | 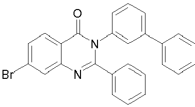 | 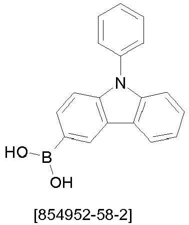 | 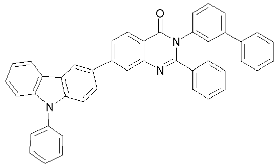 | 81 |
| 3d | 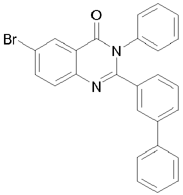 | 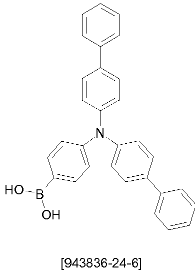 | 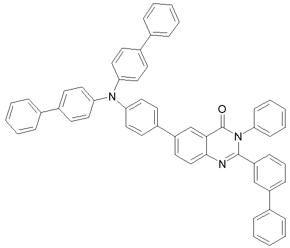 | 83 |
| 3e | 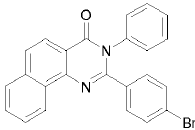 | 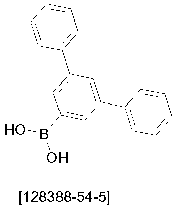 | 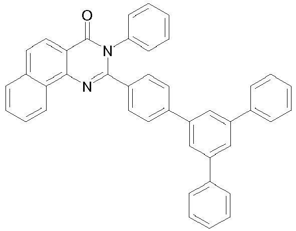 | 88 |
| 3f | 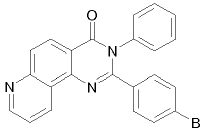 | 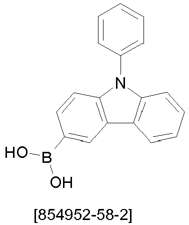 | 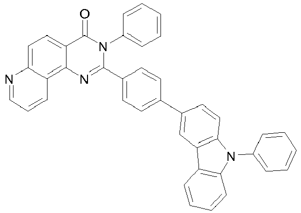 | 68 |
| 3g | 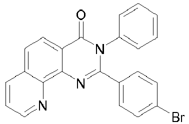 | 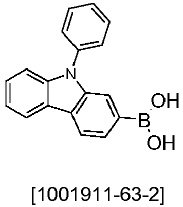 | 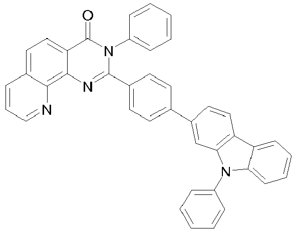 | 75 |
| 3h | 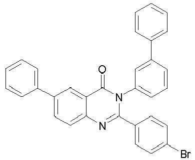 | 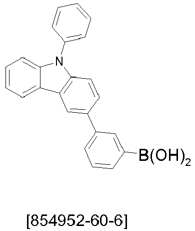 | 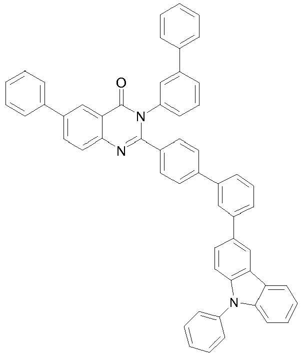 | 76 |
| 3j | 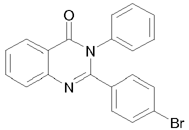 | 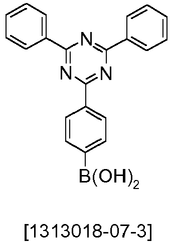 | 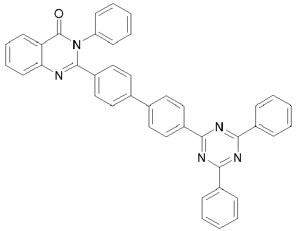 | 83 |
| 3i | 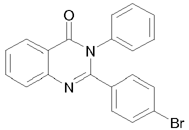 | 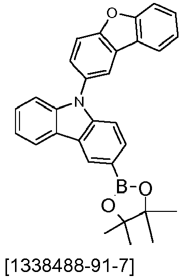 | 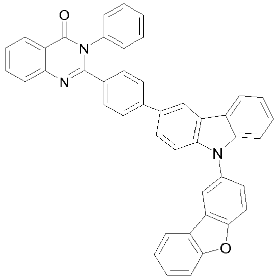 | 85 |
| 3k | 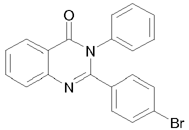 | 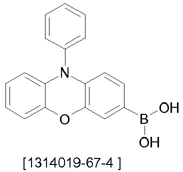 | 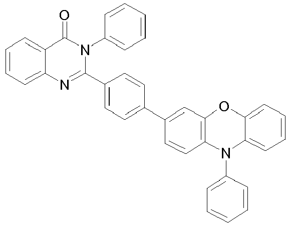 | 88 |
| 3l | 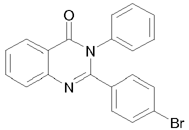 | 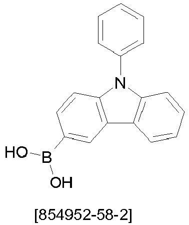 | 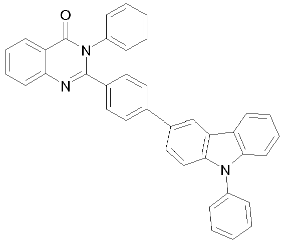 | 86 |
| 3m | 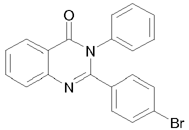 | 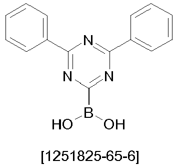 | 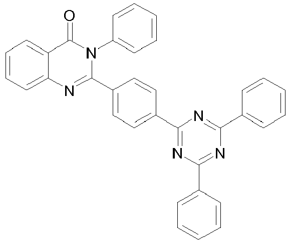 | 76 |
| 3n | 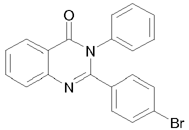 | 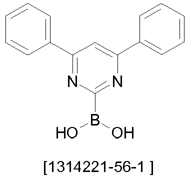 | 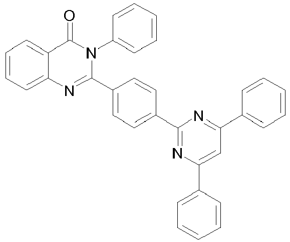 | 86 |
| 3o | 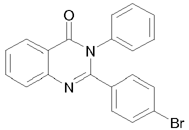 | 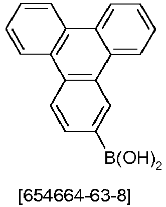 | 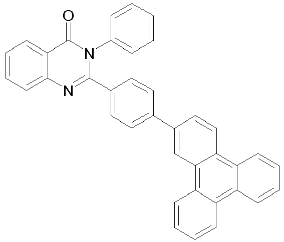 | 67 |
| 3p | 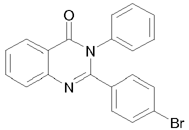 | 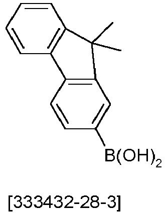 | 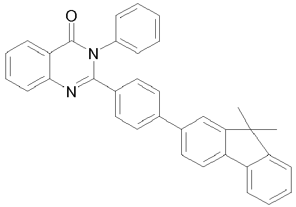 | 82 |

Analog werden folgende Verbindungen mit 0,5 eq. Bor-Verbindung erhalten:

| **Bsp.** | **Edukt 1** | **Edukt 2** | **Produkt** | **Ausbeute [%]** |
|---|---|---|---|---|
| 3q | 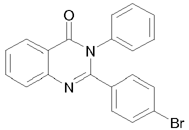 | 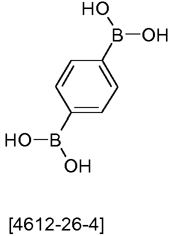 | 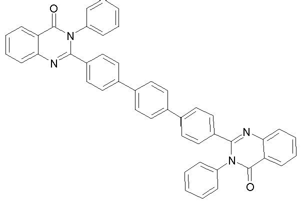 | 86 |
| 3r | 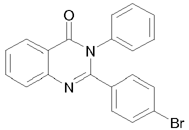 | 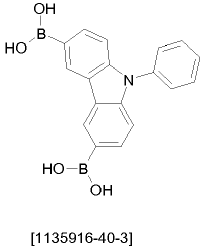 | 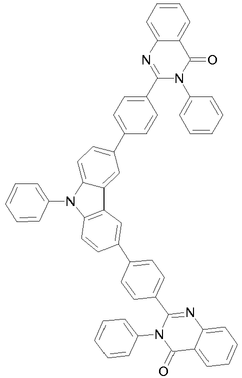 | 81 |
| 3s | 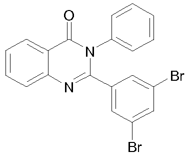 | 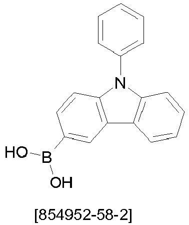 | 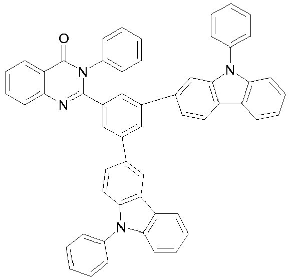 | 83 |

### Beispiel 4 : 2-[4-(3,6-Diphenyl-carbazol-9-yl)-phenyl]-3-phenyl-3H-quinazolin-4-on+

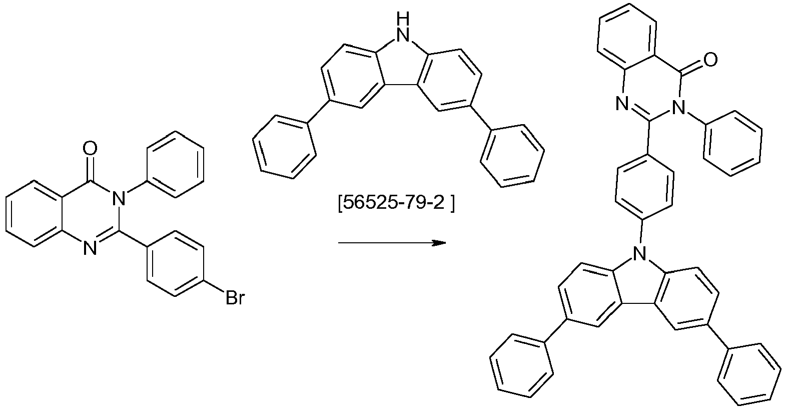

32 g (102,4 mmol) 3,6-Diphenyl-9H-carbazol, 42 g (112 mmol) 2-(4-Bromo-phenyl)-3-phenyl-3H-quinazolin-4-on und 2,3 g (10,2 mmol) 1,3-Di[2-pyridyl]-1,3-propandion, 28,3 g (204 mmol) Kaliumcarbonat und 1,9 g (10,2 mmol) Kupferiodid werden im 1000 ml DMF unter Rückfluss 90 h gerührt. Die Lösung wird mit Wasser verdünnt und mit Essigester zweimal extrahiert, die vereinigten organischen Phasen über Na₂SO₄ getrocknet und einrotiert und chromatographisch (EtOAc/Hexan: 2/3) gereinigt. Der Rückstand wird aus Toluol und aus Dichlormethan umkristallisiert und abschließend im Hochvakuum sublimiert, Reinheit beträgt 99,9 %. Die Ausbeute beträgt 47 g (77 mmol), entsprechend 69% der Theorie.

Analog werden folgende Verbindungen erhalten:

| **Bsp.** | **Edukt 1** | **Edukt 2** | **Produkt** | Ausbeute **[%]** |
|---|---|---|---|---|
| 4a | 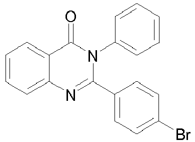 | 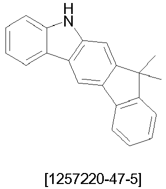 | 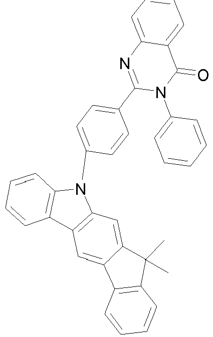 | 65 |
| 4b | 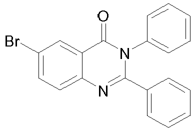 | 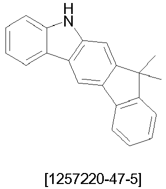 | 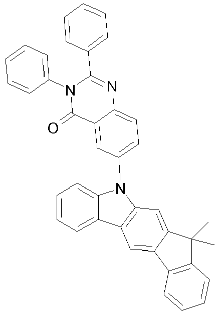 | 66 |
| 4c | 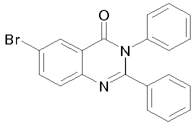 | 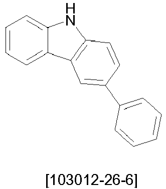 | 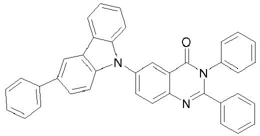 | 74 |
| 4d | 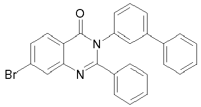 | 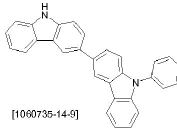 | 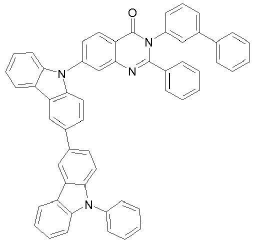 | 71 |
| 4e | 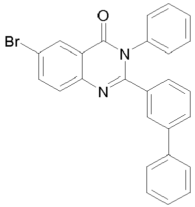 | 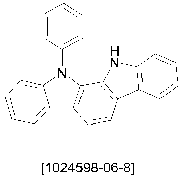 | 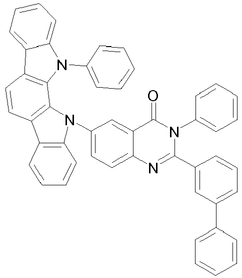 | 70 |
| 4f | 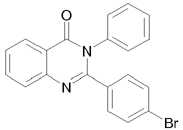 | 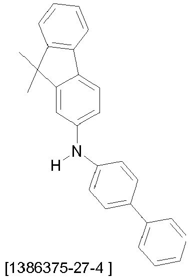 | 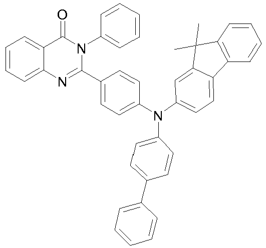 | 65 |
| 4g | 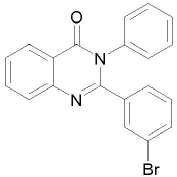 | 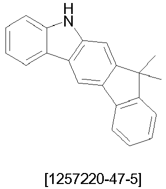 | 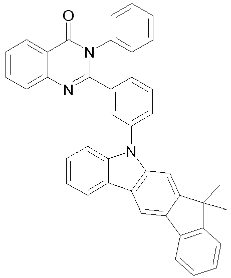 | 69 |
| 4h | 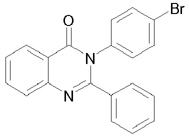 | 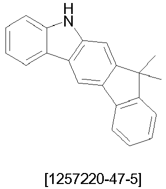 | 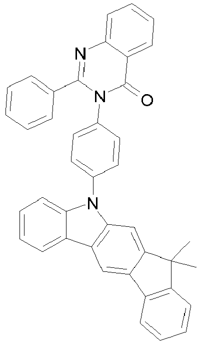 | 72 |

### Beispiel 5: Herstellung der OLEDs

In den folgenden Beispielen E1 bis E15 (siehe Tabellen 1 und 2) werden die Daten verschiedener OLEDs vorgestellt. Gereinigte Glasplättchen (Reinigung in Laborspülmaschine, Reiniger Merck Extran), die mit strukturiertem ITO (Indium Zinn Oxid) der Dicke 50 nm beschichtet sind werden 25 Minuten mit UV-Ozon vorbehandelt (UV-Ozon Generator PR-100, Firma UVP) und innerhalb 20min zur verbesserten Prozessierung mit 20nm PEDOT:PSS beschichtet (Poly(3,4-ethylenedioxythiophene) poly(styrenesulfonate), bezogen als CLEVIOS™ P VP AI 4083 von Heraeus Precious Metals GmbH Deutschland, aus wässriger Lösung aufge¬schleudert) und anschließend bei 180°C 10min lang ausgeheizt. Diese beschichteten Glasplättchen bilden die Substrate, auf welche die OLEDs aufgebracht werden.

Die OLEDs haben prinzipiell folgenden Schichtaufbau: Substrat / Lochtransportschicht (HTL) / Zwischenschicht (IL) / Elektronenblockierschicht (EBL) / Emissionsschicht (EML) / Optionale Lochblockierschicht (HBL) / Elektronentransportschicht (ETL) und abschließend eine Kathode. Die Kathode wird durch eine 100 nm dicke Aluminiumschicht gebildet. Der genaue Aufbau der OLEDs ist Tabelle 1 zu entnehmen. Eine Bezeichnung wie "4a" in der Tabelle bezieht sich auf die in den Tabellen zu den Beispielen gezeigten Materialien. Die weiteren zur Herstellung der OLEDs benötigten Materialien sind in Tabelle 3 gezeigt.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie 4a:BIC1 :TEG1 (30%:60%:10%) bedeutet hierbei, dass das Material 4a in einem Volumenanteil von 30%, BIC1 in einem Anteil von 60% und TEG1 in einem Anteil von 10% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Die Angabe U1000 in Tabelle 2 bezeichnet die Spannung, die für eine Leuchtdichte von 1000 cd/m² benötigt wird. SE1000 und LE1000 bezeichnen die Strom- bzw. Leistungseffizienz, die bei 1000 cd/m² erreicht werden. EQE1000 schließlich bezeichnet die externe Quanteneffizienz bei einer Betriebsleuchtdichte von 1000 cd/m².

Die Daten der verschiedenen OLEDs sind in Tabelle 2 zusammengefasst.

**Tabelle 1: Aufbau der OLEDs**

| Bsp. | HTL | IL | EBL | EML | HBL | ETL |
|---|---|---|---|---|---|---|
| | Dicke | Dicke | Dicke | Dicke | Dicke | Dicke |
| E1* | SpA1 | HATC | SpMA1 | 2q:TEG1 (85%:15%) | IC1 | ST1:LiQ (50%:50%) |
| | 70nm | N 5nm | 90nm | 30nm | 10nm | 30nm |
| E2* | SpA1 | HATC | SpMA1 | 2r:TEG1 (85%:15%) | IC1 | ST1:LiQ (50%:50%) |
| | 70nm | N 5nm | 90nm | 30nm | 10nm | 30nm |
| E3* | SpA1 | HATC | SpMA1 | 2s:TEG1 (85%:15%) | IC1 | ST1:LiQ (50%:50%) |
| | 70nm | N 5nm | 90nm | 30nm | 10nm | 30nm |
| E4* | SpA1 | HATC | SpMA1 | 2s:TEG1 (90%:10%) | IC1 | ST1:LiQ (50%:50%) |
| | 70nm | N 5nm | 90nm | 30nm | 10nm | 30nm |
| E5* | SpA1 | HATC | SpMA1 | 2s:IC1:TEG1 (42%:42%:16%) | IC1 | ST1:LiQ (50%:50%) |
| | 70nm | N 5nm | 90nm | 30nm | 10nm | 30nm |
| E6 | SpA1 | HATC | SpMA1 | 2f:TEG1 (90%:15%) | IC1 | ST1:LiQ (50%:50%) |
| | 70nm | N 5nm | 90nm | 30nm | 10nm | 30nm |
| E7 | SpA1 | HATC | SpMA1 | 4:TEG1(90%:15%) | IC1 | ST1:LiQ (50%:50%) |
| | 70nm | N 5nm | 90nm | 30nm | 10nm | 30nm |
| E8 | SpA1 | HATC | SpMA1 | 3d:TER1 (92%:8%) | --- | ST1:LiQ (50%:50%) |
| | 90nm | N 5nm | 130nm | 40nm | | 40nm |
| E9 | SpA1 | HATC | SpMA1 | 3m:TEG1 (90%:15%) | IC1 | ST1:LiQ (50%:50%) |
| | 70nm | N 5nm | 90nm | 30nm | 10nm | 30nm |
| E10 | SpA1 | HATC | SpMA1 | 4a:TEG1 (90%:10%) | IC1 | ST1:LiQ (50%:50%) |
| | 70nm | N 5nm | 90nm | 30nm | 10nm | 30nm |
| E11 | SpA1 | HATC | SpMA1 | 4a:IC1:TEG1 (45%:45%:10%) | IC1 | ST1:LiQ (50%:50%) |
| | 70nm | N 5nm | 90nm | 30nm | 10nm | 30nm |
| E12 | SpA1 | HATC | SpMA1 | 4a:BIC1 :TEG1 (30%:60%:10%) | IC1 | ST1:LiQ (50%:50%) |
| | 70nm | N 5nm | 90nm | 30nm | 10nm | 30nm |
| E13 | SpA1 | HATC | SpMA1 | 4h:TEG1 (90%:10%) | IC1 | ST1:LiQ (50%:50%) |
| | 70nm | N 5nm | 90nm | 30nm | 10nm | 30nm |
| E14 | SpA1 | HATC | SpMA1 | 4h:BIC1:TEG1 (60%:30%:10%) | IC1 | ST1:LiQ (50%:50%) |
| | 70nm | N 5nm | 90nm | 30nm | 10nm | 30nm |
| E15 | SpA1 | HATC | SpMA1 | 4h:TEG2 (90%:15%) | IC1 | ST1:LiQ (50%:50%) |
| | 70nm | N 5nm | 90nm | 30nm | 10nm | 30nm |

| | | | | | | |
|---|---|---|---|---|---|---|
| *Nicht erfindungsgemäß | | | | | | |

**Tabelle 2: Daten der OLEDs**

| Bsp. | U1000 | SE1000 | LE1000 | EQE | CIE x/y bei |
|---|---|---|---|---|---|
| | (V) | (cd/A) | (lm/W) | 1000 | 1000 cd/m² |
| E1 | 3.8 | 57 | 48 | 15.8% | 0.32/0.63 |
| E2 | 3.7 | 56 | 47 | 15.7% | 0.33/0.62 |
| E3 | 3.7 | 59 | 50 | 16.5% | 0.32/0.62 |
| E4 | 3.9 | 61 | 50 | 16.6% | 0.32/0.63 |
| E5 | 3.2 | 63 | 62 | 17.1% | 0.33/0.63 |
| E6 | 3.6 | 62 | 56 | 17.8% | 0.32/0.62 |
| E7 | 3.7 | 60 | 50 | 16.8% | 0.32/0.63 |
| E8 | 4.9 | 10.3 | 6.6 | 11.0% | 0.67/0.33 |
| E9 | 3.4 | 61 | 57 | 17.4% | 0.34/0.62 |
| E10 | 3.6 | 49 | 43 | 13.7% | 0.34/0.62 |
| E11 | 3.1 | 52 | 54 | 14.7% | 0.33/0.62 |
| E12 | 3.6 | 47 | 41 | 13.1% | 0.32/0.63 |
| E13 | 3.9 | 58 | 48 | 16.3% | 0.32/0.63 |
| E14 | 3.9 | 54 | 43 | 15.1% | 0.33/0.62 |
| E15 | 3.8 | 57 | 47 | 16.1% | 0.34/0.61 |

**Tabelle 3: Strukturformeln der Materialien für die OLEDs**

| | |
|---|---|
| 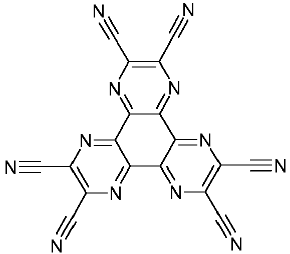 | 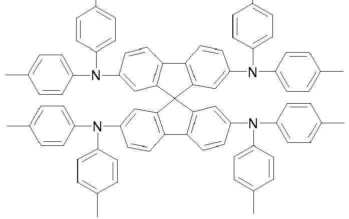 |
| HATCN | SpA1 |
| 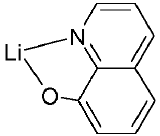 | 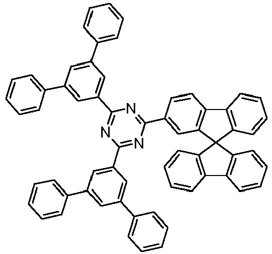 |
| LiQ | ST1 |
| 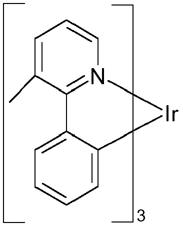 | 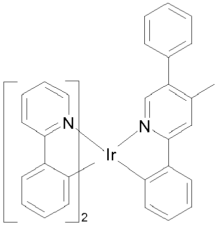 |
| TEG1 | TEG2 |
| 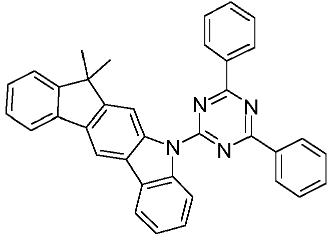 | 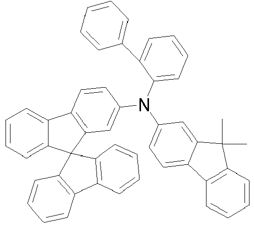 |
| IC1 | SpMA1 |
| 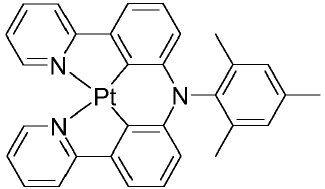 | 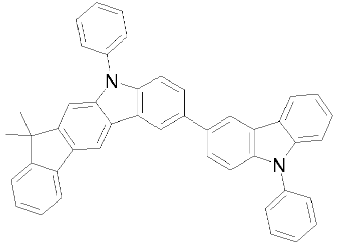 |
| TER1 | BIC1 |
| 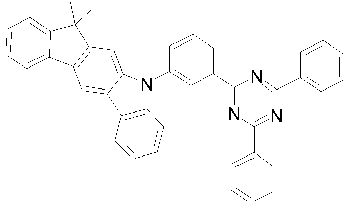 | |
| IC1 | |
| 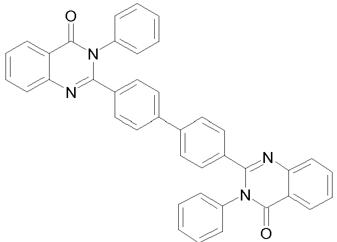 | 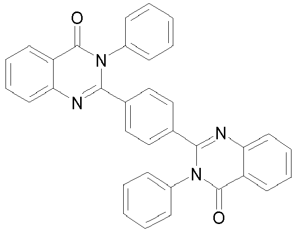 |
| 2q* | 2r* |
| 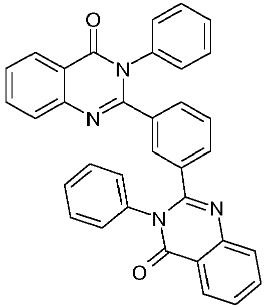 | 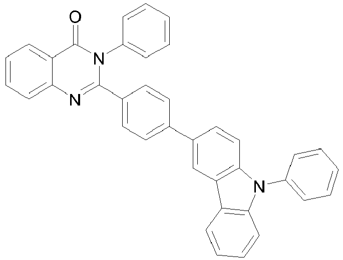 |
| 2s* | 2f |
| 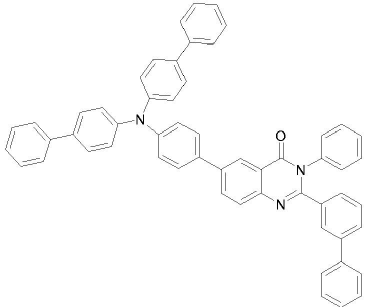 | 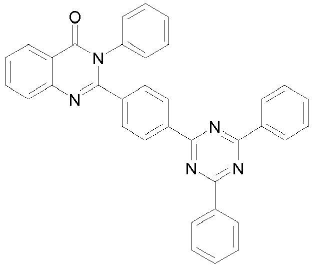 |
| 3d | 3m |
| 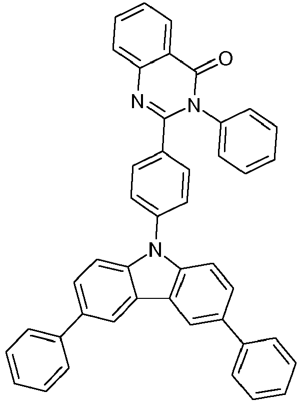 | 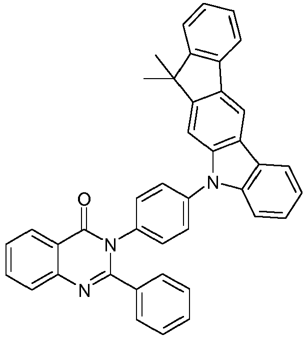 |
| 4 | 4a |
| 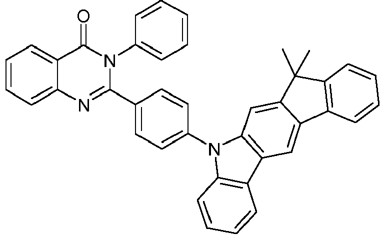 | |
| 4h | |

| | |
|---|---|
| *Nicht erfindungsgemäß | |

## Patentansprüche

1. Mischung umfassend mindestens einen phosphoreszierenden Dotanden, welche Kupfer, Molybdän, Wolfram, Rhenium, Ruthenium, Osmium, Rhodium, Iridium, Palladium, Platin, Silber, Gold und/oder Europium enthält, und mindestens eine Verbindung gemäß der Formel (3): 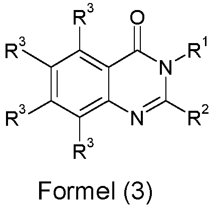 wobei für die verwendeten Symbole und Indizes gilt:
R¹, R² sind bei jedem Auftreten verschieden ausgewählt aus den Gruppen mit den folgenden Formeln (Ar-1) bis (Ar-27) 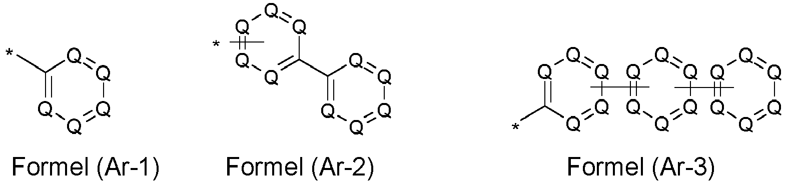 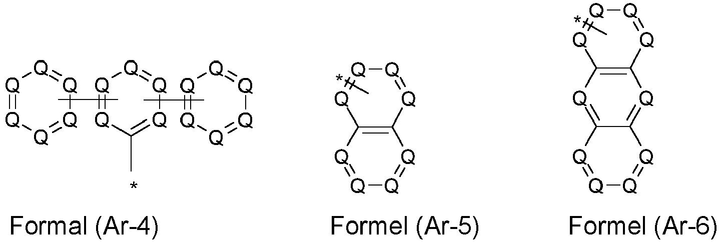 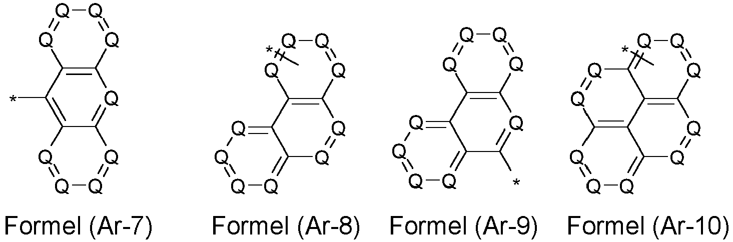 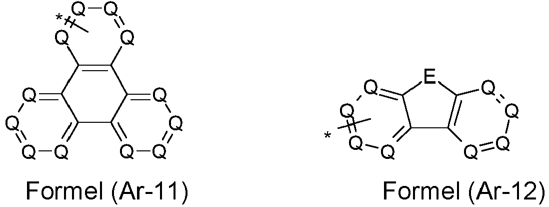 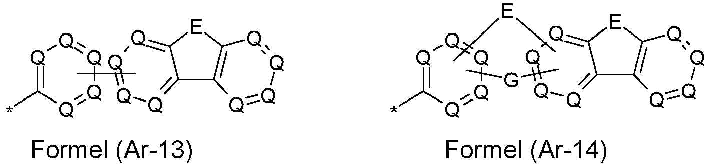 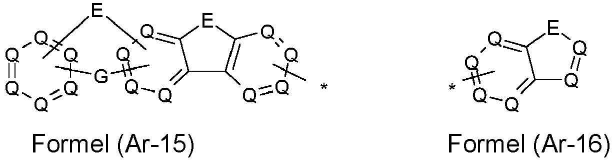 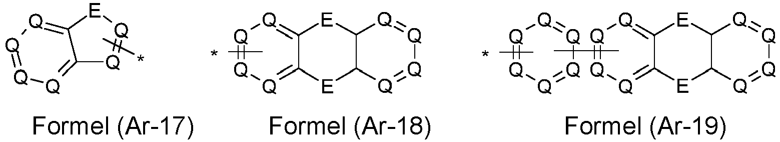 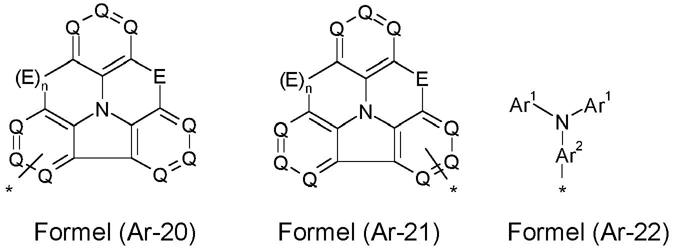 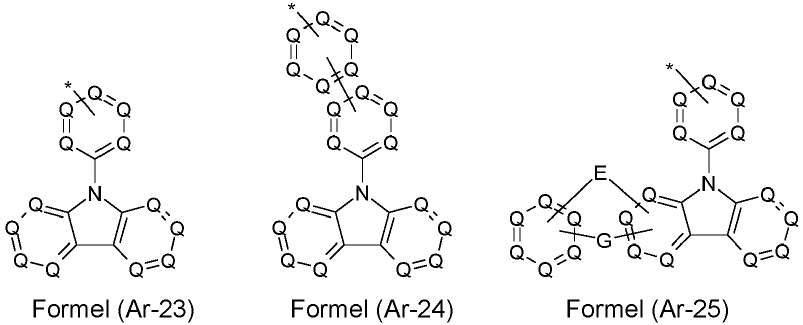 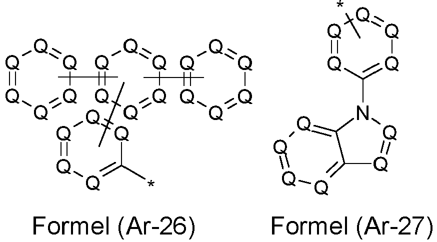
wobei:
Q ist bei jedem Auftreten gleich oder verschieden CR⁴ oder N, wobei maximal 3 Symbole Q pro Cyclus für N stehen;
E ist bei jedem Auftreten gleich oder verschieden (CR⁴)₂, NR⁴, O, S oder C=O;
G ist bei jedem Auftreten eine Einfachbindung, (CR⁴)₂, NR⁴, O, S oder C=O;
Ar² ist bei jedem Auftreten gleich oder verschieden ein bivalentes aromatisches oder heteroaromatisches Ringsystem mit 5 bis 60 aromatischen Ringatomen, welches durch einen oder mehrere Reste R⁴ substituiert sein kann;
Ar¹ sind bei jedem Auftreten gleich oder verschieden ein aromatisches oder heteroaromatisches Ringsystem mit 6 bis 60 aromatischen Ringatomen, das jeweils auch mit einem oder mehreren Reste R⁴ substituiert sein kann, wobei beide Ar¹ und/oder Ar¹ mit Ar² über je mindestens eine Brücke K verbunden sein können;
K ist bei jedem Auftreten gleich oder verschieden gleich eine Einfachbindung oder eine bivalente Brücke, ausgewählt aus N(R⁴), B(R⁴), O,C=O, C(R⁴)₂, Si(R⁴)₂, und S; und
* die Bindung zum Quinazolinon-Grundgerüst darstellt.
R³ ist bei jedem Auftreten gleich oder verschieden H, D, F, eine geradkettige Alkylgruppe mit 1 bis 10 C-Atomen oder eine verzweigte oder cyclische Alkylgruppe mit 3 bis 10 C-Atomen, die jeweils mit einem oder mehreren Resten R⁴ substituiert sein kann, oder ein aromatisches oder heteroaromatisches Ringsystem mit 6 bis 60 aromatischen Ringatomen, das jeweils durch einen oder mehrere Reste R⁴ substituiert sein kann;
Ar ist bei jedem Auftreten gleich oder verschieden, ein aromatisches oder heteroaromatisches Ringsystem mit 6 bis 60 aromatischen Ringatomen, das jeweils auch mit einem oder mehreren Resten R⁴ substituiert sein kann,
R⁴ ist bei jedem Auftreten gleich oder verschieden H, D, F, Cl, Br, I, CHO, C(=O)R⁵, P(=O)(R⁵)₂, S(=O)R⁵, S(=O)₂R⁵, CN, NO₂, Si(R⁵)₃, B(OR⁵)₂, OSO₂R⁵, N(R⁵)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁵ substituiert sein kann, wobei eine oder mehrere nicht benachbarte CH₂-Gruppen durch C≡C , Si(R⁵)₂, Ge(R⁵)₂, Sn(R⁵)₂, C=O, C=S, C=Se, P(=O)(R⁵), SO, SO₂, O, S oder CONR⁵ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁵ substituiert sein kann, oder eine Aryloxy- oder Heteroaryloxygruppe mit 5 bis 60 aromatischen Ringatomen, die durch einen oder mehrere Reste R⁵ substituiert sein kann, oder eine Kombination dieser Systeme; dabei können zwei oder mehrere benachbarte Substituenten R⁴ auch miteinander ein mono- oder polycyclisches, aliphatisches oder aromatisches Ringsystem bilden;
R⁵ ist bei jedem Auftreten gleich oder verschieden H, D, F, Cl, Br, I, N(R⁶)₂, C(=O)R⁶, P(=O)(R⁶)₂, S(=O)R⁶, S(=O)₂R⁶, CR⁶=C(R⁶)₂, CN, NO₂, Si(R⁶)₃, B(OR⁶)₂, OSO₂R⁶, N(R⁶)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁶ substituiert sein kann, wobei eine oder mehrere nicht benachbarte CH₂-Gruppen durch R⁶C=CR⁶, C≡C, Si(R⁶)₂, C=O, C=NR⁶, P(=O)(R⁶), SO, SO₂, NR⁶, O, S oder CONR⁶ ersetzt sein können und wobei ein oder mehrere H Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁶ substituiert sein kann, oder eine Aryloxy- oder Heteroaryloxy-gruppe mit 5 bis 60 aromatischen Ringatomen, die durch einen oder mehrere Reste R⁶ substituiert sein kann, oder eine Aralkyl- oder Heteroaralkylgruppe mit 5 bis 60 aromatischen Ringatomen, die durch einen oder mehrere Reste R⁶ substituiert sein kann, oder eine Kombination dieser Systeme; dabei können zwei oder mehrere benachbarte Substituenten R⁵ auch miteinander ein mono- oder polycyclisches, aliphatisches oder aromatisches Ringsystem bilden.

2. Mischung nach Anspruch 1, **dadurch gekennzeichnet, dass** der mindestens eine phosphoreszierende Dotand eine Verbindung umfasst ausgewählt aus den Formeln (D-1) bis (D-6), 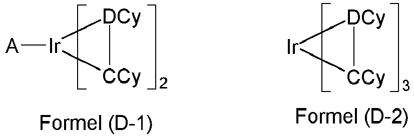 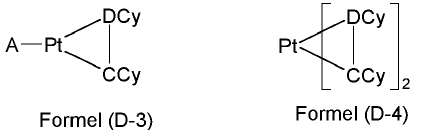 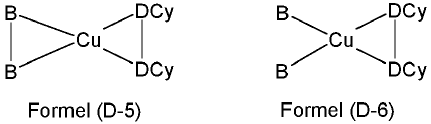 wobei R⁴ dieselbe Bedeutung hat, wie oben für Formel (3) beschrieben, und für die weiteren verwendeten Symbole gilt:
DCy ist gleich oder verschieden bei jedem Auftreten eine cyclische Gruppe, die mindestens ein Donoratom enthält oder als Substituenten trägt, über welches die cyclische Gruppe an das Metall gebunden ist, und die wiederum einen oder mehrere Substituenten R⁴ tragen kann; die Gruppen DCy und CCy sind über eine kovalente Bindung miteinander verbunden;
CCy ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R⁴ tragen kann;
A ist gleich oder verschieden bei jedem Auftreten ein monoanionischer, zweizähnig chelatisierender Ligand.
B ist gleich oder verschieden bei jedem Auftreten eine Verbindung umfassend mindestens ein Donoratom, welches an das Metall bindet.

3. Verfahren zur Herstellung einer Mischung nach Anspruch 1 oder 2, **dadurch gekennzeichnet, dass** die Verbindung der Formel (3) durch eine oder mehrere Kupplungsreaktionen und/oder Zyklisierungen aufgebaut wird.

4. Formulierung, insbesondere eine Lösung, eine Suspension oder eine Miniemulsion, enthaltend mindestens eine Mischung nach Anspruch 1 oder 2 und ein oder mehrere Lösemittel.

5. Verwendung einer Mischung nach Anspruch 1 oder 2 in einer elektronischen Vorrichtung.

6. Verwendung einer Verbindung nach der Formel (3) gemäß Anspruch 1 als Matrixmaterial für eine phosphoreszierende Verbindung.

7. Elektronische Vorrichtung, insbesondere ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen farbstoffsensibilisierten Solarzellen, organischen optischen Detektoren, organischen Photorezeptoren, organischen Feld-Quench-Devices, lichtemittierenden elektrochemischen Zellen, organischen Laserdioden und "organic plasmon emitting devices", enthaltend mindestens eine Mischung nach Anspruch 1 oder 2 .

8. Elektronische Vorrichtung nach Anspruch 7, **dadurch gekennzeichnet, dass** es sich um eine organische Elektrolumineszenzvorrichtung handelt und die Mischung in einer emittierenden Schicht eingesetzt wird.

## Claims

1. Mixture comprising at least one phosphorescent dopant containing copper, molybdenum, tungsten, rhenium, ruthenium, osmium, rhodium, iridium, palladium, platinum, silver, gold and/or europium. and at least one compound of the formula (3): 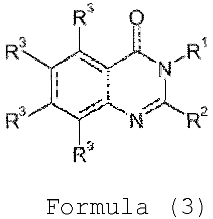 where the symbols and indices used are as follows:
R¹, R² are different and selected at each instance from the groups having the following formulae (Ar-1) to (Ar-27): 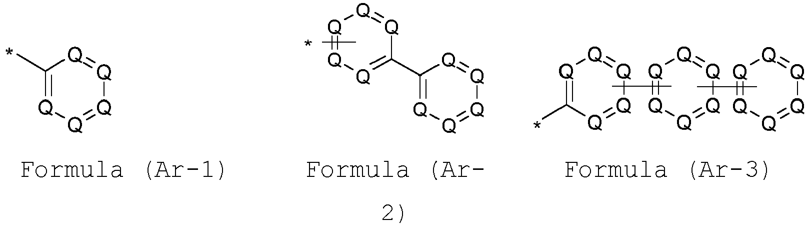 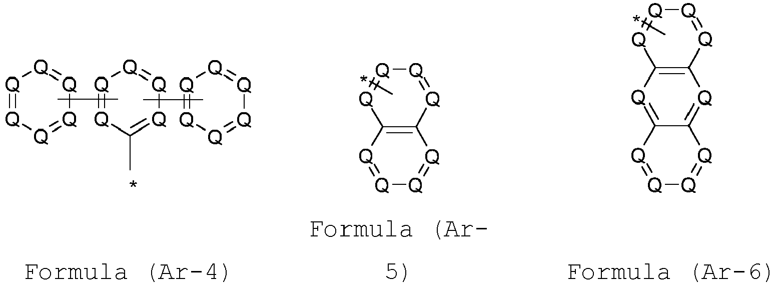 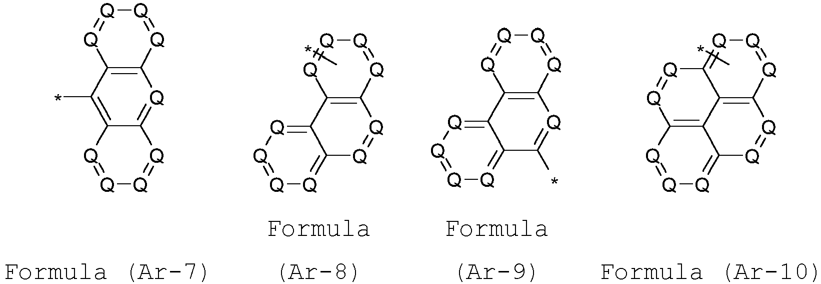 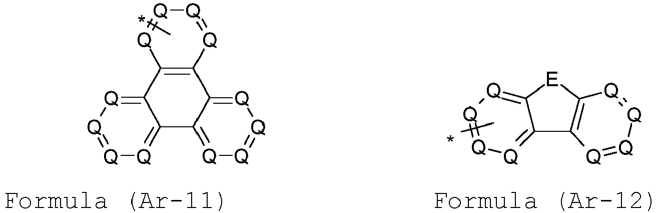 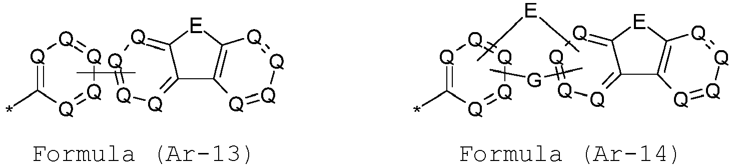 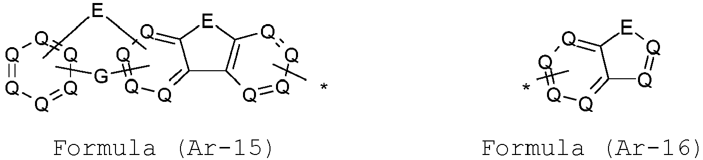 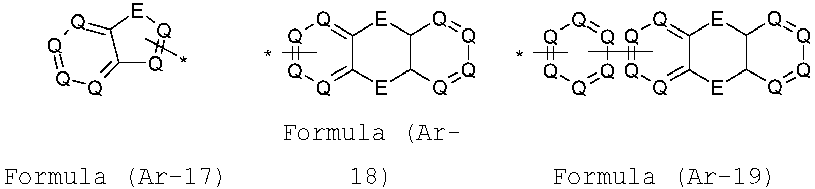 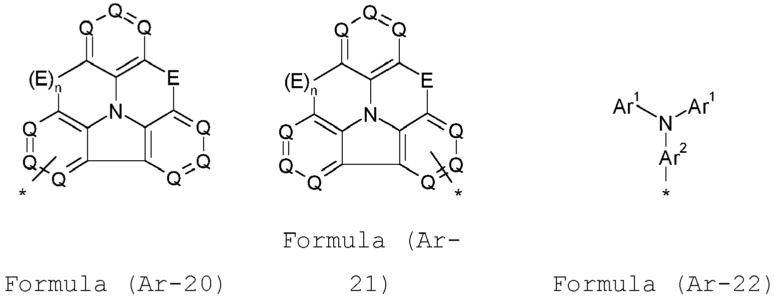 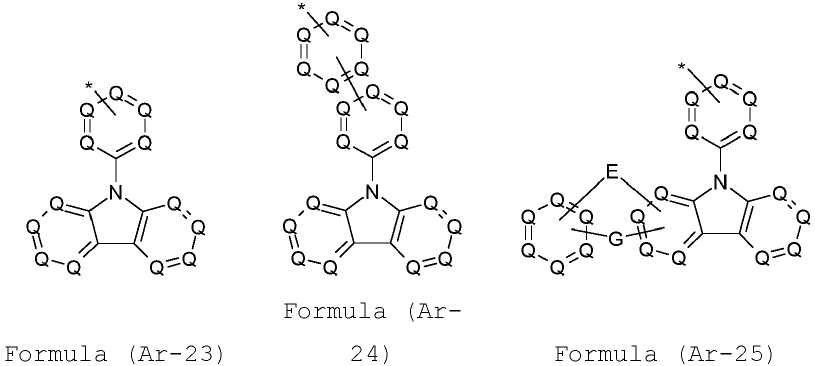 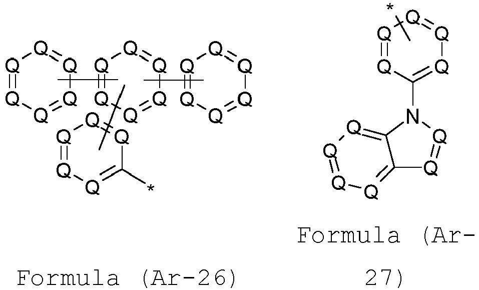 where:
Q is the same or different at each instance and is CR⁴ or N, where not more than 3 Q symbols per cycle are N;
E is the same or different at each instance and is (CR⁴) ₂, NR⁴, O, S or C=O;
G at each instance is a single bond, (CR⁴)₂, NR⁴, O, S or C=O;
Ar² is the same or different at each instance and is a bivalent aromatic or heteroaromatic ring system which has 5 to 60 aromatic ring atoms and may be substituted by one or more R⁴ radicals;
Ar¹ are the same or different at each instance and are an aromatic or heteroaromatic ring system which has 6 to 60 aromatic ring atoms and may in each case also be substituted by one or more R⁴ radicals; where the two Ar¹ may be joined and/or Ar¹ may be joined to Ar² via at least one bridge K in each case;
K is the same or different at each instance and is a single bond or a divalent bridge selected from N(R⁴), B(R⁴), O, C=O, C(R⁴)₂, Si(R⁴)₂ and S; and
* represents the bond to the quinazolinone base skeleton,
R³ is the same or different at each instance and is H, D, F, a straight-chain alkyl group having 1 to 10 carbon atoms or a branched or cyclic alkyl group having 3 to 10 carbon atoms, each of which may be substituted by one or more R⁴ radicals, or an aromatic or heteroaromatic ring system which has 6 to 60 aromatic ring atoms and may be substituted in each case by one or more R⁴ radicals;
Ar is the same or different at each instance and is an aromatic or heteroaromatic ring system which has 6 to 60 aromatic ring atoms and may also be substituted in each case by one or more R⁴ radicals,
R⁴ is the same or different at each instance and is H, D, F, Cl, Br, I, CHO, C(=O)R⁵, P(=O) (R⁵)₂, S(=O)R⁵, S(=O)₂R⁵, CN, NO₂, Si(R⁵)₃, B(OR⁵)₂, OSO₂R⁵, N(R⁵)₂, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more R⁵ radicals, where one or more nonadjacent CH₂ groups may be replaced by C≡C, Si(R⁵)₂, Ge(R⁵)₂, Sn(R⁵)₂, C=O, C=S, C=Se, P (=O) (R⁵) , SO, SO₂, O, S or CONR⁵ and where one or more hydrogen atoms may be replaced by D, F, Cl, Br, I, CN or NO₂, or an aromatic or heteroaromatic ring system which has 5 to 60 aromatic ring atoms, each of which may be substituted by one or more R⁵ radicals, or an aryloxy or heteroaryloxy group which has 5 to 60 aromatic ring atoms and may be substituted by one or more R⁵ radicals, or a combination of these systems; at the same time, two or more adjacent R⁴ substituents may also form a mono- or polycyclic, aliphatic or aromatic ring system with one another;
R⁵ is the same or different at each instance and is H, D, F, Cl, Br, I, N(R⁶)₂, C(=O)R⁶, P(=O)(R⁶)₂, S(=O) R⁶, S(=O)₂R⁶, CR⁶=C(R⁶)₂, CN, NO₂, Si(R⁶)₃, B(OR⁶)₂, OSO₂R⁶, N(R⁶) ₂, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more R⁶ radicals, where one or more nonadjacent CH₂ groups may be replaced by R⁶C=CR⁶, C≡C, Si(R⁶)₂, C=O, C=NR⁶, P(=O)(R⁶) , SO, SO₂, NR⁶, O, S or CONR⁶ and where one or more hydrogen atoms may be replaced by D, F, Cl, Br, I, CN or NO₂, or an aromatic or heteroaromatic ring system which has 5 to 60 aromatic ring atoms, each of which may be substituted by one or more R⁶ radicals, or an aryloxy or heteroaryloxy group which has 5 to 60 aromatic ring atoms and may be substituted by one or more R⁶ radicals, or an aralkyl or heteroaralkyl group which has 5 to 60 aromatic ring atoms and may be substituted by one or more R⁶ radicals, or a combination of these systems; at the same time, two or more adjacent R⁵ substituents together may also form a mono- or polycyclic, aliphatic or aromatic ring system.

2. Mixture according to Claim 1, **characterized in that** the at least one phosphorescent dopant comprises a compound selected from the formulae (D-1) to (D-6) 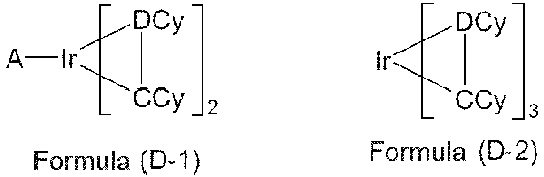 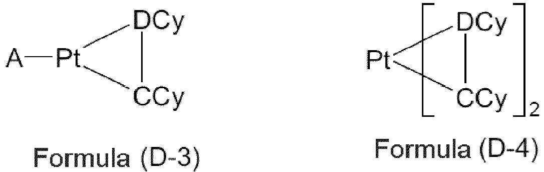 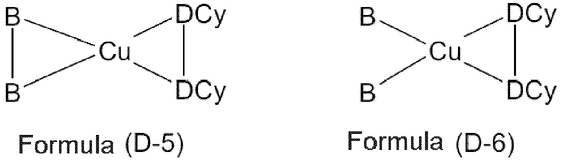 where R⁴ has the same definition as described above for formula (3), and the further symbols used are as follows:
DCy is the same or different at each instance and is a cyclic group which contains at least one donor atom or bears it as a substituent via which the cyclic group is bonded to the metal, and which may in turn bear one or more R⁴ substituents; the DCy and CCy groups are joined to one another via a covalent bond;
CCy is the same or different at each instance and is a cyclic group which contains a carbon atom via which the cyclic group is bonded to the metal, and which may in turn bear one or more R⁴ substituents;
A is the same or different at each instance and is a monoanionic ligand with bidentate chelation,
B is the same or different at each instance and is a compound comprising at least one donor atom which binds to the metal.

3. Process for producing a mixture according to Claims 1 or 2, **characterized in that** the compound of the formula (3) is formed by one or more coupling reactions and/or cyclizations.

4. Formulation, especially a solution, a suspension or a miniemulsion, comprising at least one mixture according to Claim 1 or 2 and one or more solvents.

5. Use of a mixture according to Claim 1 or 2 in an electronic device.

6. Use of a compound of the formula (3) according to Claim 1 as matrix material for a phosphorescent compound.

7. Electronic device, especially selected from the group consisting of organic electroluminescent devices, organic integrated circuits, organic field-effect transistors, organic thin-film transistors, organic light-emitting transistors, organic solar cells, organic dye-sensitized solar cells, organic optical detectors, organic photoreceptors, organic field-quench devices, light-emitting electrochemical cells, organic laser diodes and organic plasmon emitting devices, comprising at least one mixture according to Claim 1 or 2.

8. Electronic device according to Claim 7, **characterized in that** it is an organic electroluminescent device and the mixture is used in an emitting layer.

## Revendications

1. Mélange comprenant au moins un dopant phosphorescent, qui contient du cuivre, du molybdène, du tungstène, du rhénium, du ruthénium, de l'osmium, du rhodium, de l'iridium, du palladium, du platine, de l'argent, de l'or et/ou de l'europium, et au moins un composé selon la formule (3) : 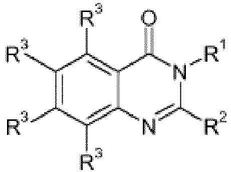 formule (3)
ce qui suit s'appliquant pour les symboles et indices utilisés :
R¹, R² sont différents en chaque occurrence et sont choisis dans les groupes comportant les formules suivantes (Ar-1) à (Ar-27) 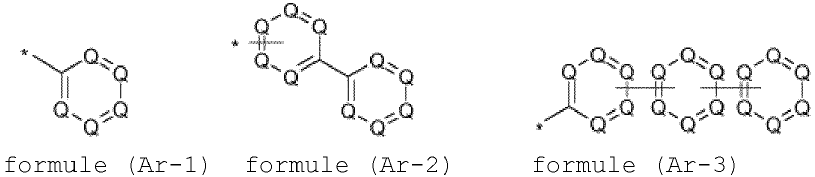 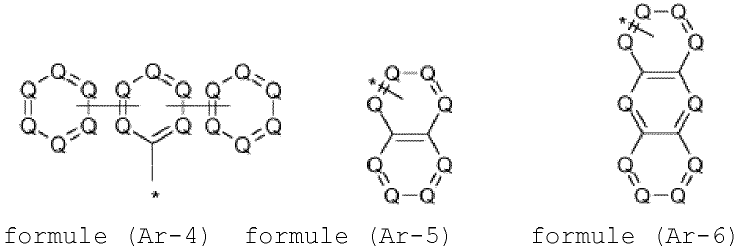 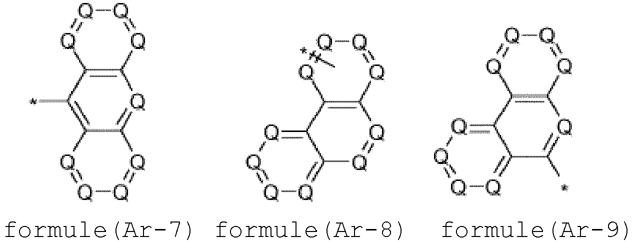 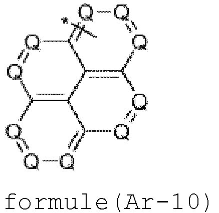 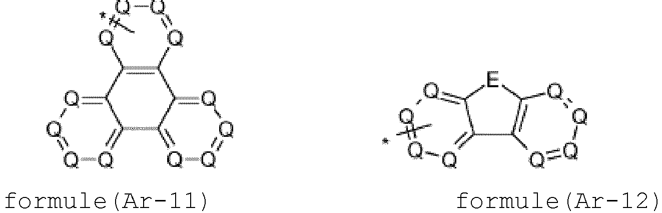 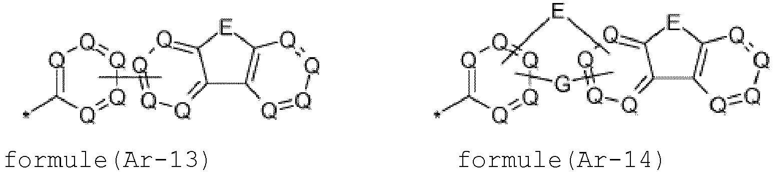 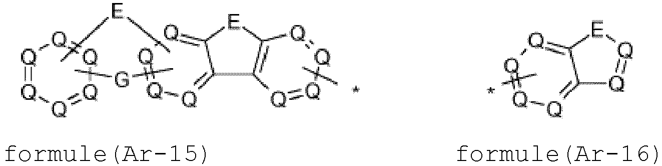 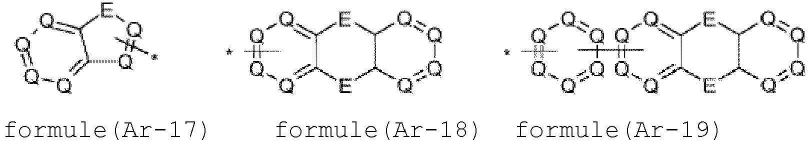 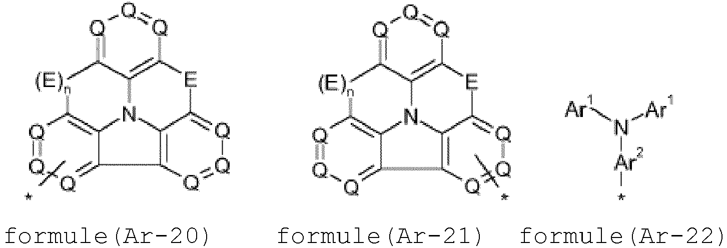 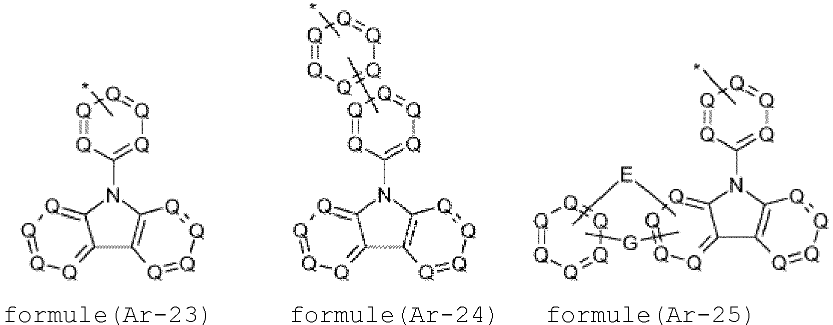 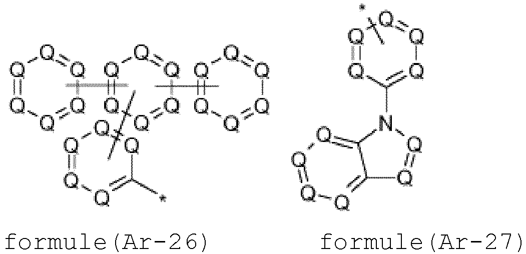
Q identique ou différent en chaque occurrence, étant CR⁴ ou N, au maximum 3 symboles Q par cycle représentant N ;
E identique ou différent en chaque occurrence, étant (CR⁴) ₂, NR⁴, O, S ou C=O ;
G étant en chaque occurrence une simple liaison, (CR⁴) ₂, NR⁴, O, S ou C=O ;
Ar² identique ou différent en chaque occurrence, étant un système cyclique divalent aromatique ou hétéroaromatique comportant 5 à 60 atomes de cycle aromatiques, qui peut être substitué par un ou plusieurs radicaux R⁴ ;
Ar¹ identique ou différent en chaque occurrence, étant un système cyclique aromatique ou hétéroaromatique comportant 6 à 60 atomes de cycle aromatiques, qui peut également à chaque fois être substitué par un ou plusieurs radicaux R⁴, les deux Ar¹ et/ou Ar¹ et Ar² pouvant être reliés par l'intermédiaire de respectivement au moins un pont K ;
K identique ou différent en chaque occurrence, étant une simple liaison ou un pont divalent, choisi parmi N(R⁴), B(R⁴), O, C=O, C(R⁴)₂, Si(R⁴)₂, et S ; et
* indiquant la liaison au squelette de base quinazolinone ;
R³ identique ou différent en chaque occurrence, étant H, D, F, un groupe alkyle linéaire comportant 1 à 10 atome (s) de C ou un groupe alkyle ramifié ou cyclique comportant 3 à 10 atomes de C, qui peut à chaque fois être substitué par un ou plusieurs radicaux R⁴, ou un système cyclique aromatique ou hétéroaromatique comportant 6 à 60 atomes de cycle aromatiques, qui peut à chaque fois être substitué par un ou plusieurs radicaux R⁴ ;
Ar identique ou différent en chaque occurrence, étant un système cyclique aromatique ou hétéroaromatique comportant 6 à 60 atomes de cycle aromatiques, qui peut également à chaque fois être substitué par un ou plusieurs radicaux R⁴,
R⁴ identique ou différent en chaque occurrence, étant H, D, F, Cl, Br, I, CHO, C(=O) R⁵, P(=O) (R⁵) ₂, S(=O) R⁵, S(=O)₂R⁵, CN, NO₂, Si(R⁵)₃, B(OR⁵)₂, OSO₂R⁵, N(R⁵) ₂, un groupe alkyle, alcoxy ou thioalcoxy linéaire comportant 1 à 40 atome(s) de C ou un groupe alkyle, alcoxy ou thioalcoxy ramifié ou cyclique comportant 3 à 40 atomes de C, qui peut à chaque fois être substitué par un ou plusieurs radicaux R⁵, un ou plusieurs groupes CH₂ non voisins pouvant être remplacés par C=C, Si(R⁵)₂, Ge(R⁵)₂, Sn(R⁵)₂, C=O, C=S, C=Se, P(=O) (R⁵) , SO, SO₂, O, S ou CONR⁵ et un ou plusieurs atomes de H pouvant être remplacés par D, F, Cl, Br, I, CN ou NO₂, ou un système cyclique aromatique ou hétéroaromatique comportant 5 à 60 atomes de cycle aromatiques, qui à chaque fois peut être substitué par un ou plusieurs radicaux R⁵, ou un groupe aryloxy ou hétéroaryloxy comportant 5 à 60 atomes de cycle aromatiques, qui peut être substitué par un ou plusieurs radicaux R⁵, ou une combinaison de ces systèmes ; à cet effet deux substituants R⁴ voisins ou plus pouvant aussi former ensemble un système cyclique monocyclique ou polycyclique, aliphatique ou aromatique ;
R⁵ identique ou différent en chaque occurrence, étant H, D, F, Cl, Br, I, N(R⁶)₂, C(=O)R⁶, P(=O)(R⁶)₂, S(=O)R⁶, S(=O)₂R⁶, CR⁶=C(R⁶)₂ CN, NO₂, Si(R⁶)₃, B(OR⁶)₂, OSO₂R⁶, N(R⁶) ₂, un groupe alkyle, alcoxy ou thioalcoxy linéaire comportant 1 à 40 atome (s) de C ou un groupe alkyle, alcoxy ou thioalcoxy ramifié ou cyclique comportant 3 à 40 atomes de C, qui peut à chaque fois être substitué par un ou plusieurs radicaux R⁶, un ou plusieurs groupes CH₂ non voisins pouvant être remplacés par R⁶C=CR⁶, C=C, Si(R⁶)₂, C=O, C=NR⁶, P(=O) (R⁶), SO, SO₂, NR⁶, O, S ou CONR⁶ et un ou plusieurs atomes de H pouvant être remplacés par D, F, Cl, Br, I, CN ou NO₂, ou un système cyclique aromatique ou hétéroaromatique comportant 5 à 60 atomes de cycle aromatiques, qui à chaque fois peut être substitué par un ou plusieurs radicaux R⁶, ou un groupe aryloxy ou hétéroaryloxy comportant 5 à 60 atomes de cycle aromatiques, qui peut être substitué par un ou plusieurs radicaux R⁶, ou un groupe aralkyle ou hétéroalkyle comportant 5 à 60 atomes de cycle aromatiques, qui peut être substitué par un ou plusieurs radicaux R⁶, ou une combinaison de ces systèmes ; à cet effet deux substituants R⁵ voisins ou plus pouvant aussi former ensemble un système cyclique monocyclique ou polycyclique, aliphatique ou aromatique.

2. Mélange selon la revendication 1, **caractérisé en ce que** l'au moins un dopant phosphorescent comprend un composé choisi parmi les formules (D-1) à (D-6), 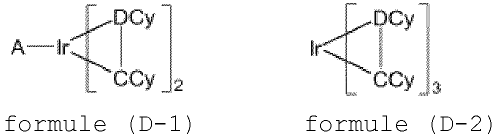 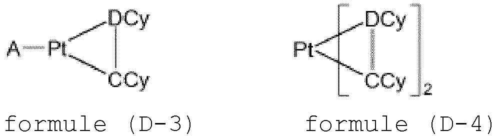 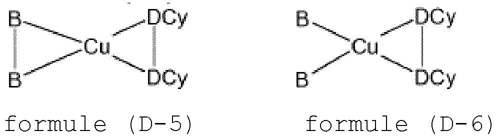 R⁴ possédant la même signification que décrit ci-dessus pour la formule (3), et ce qui suit s'appliquant pour les autres symboles utilisés :
DCy identique ou différent en chaque occurrence, étant un groupe cyclique qui contient ou porte en tant que substituants au moins un atome donneur, par l'intermédiaire duquel le groupe cyclique est lié au métal, et qui à son tour peut porter un ou plusieurs substituants R⁴ ; les groupes DCy et CCy étant reliés l'un à l'autre par l'intermédiaire d'une liaison covalente ;
CCy identique ou différent en chaque occurrence, étant un groupe cyclique qui contient un atome de carbone, par l'intermédiaire duquel le groupe cyclique est lié au métal, et qui à son tour peut porter un ou plusieurs substituants R⁴ ;
A identique ou différent en chaque occurrence, étant un ligand monoanionique, bidentate chélatant ;
B identique ou différent en chaque occurrence, étant un composé comprenant au moins un atome donneur, qui se lie au métal.

3. Procédé pour la préparation d'un mélange selon la revendication 1 ou 2, **caractérisé en ce que** le composé de formule (3) est construit par l'intermédiaire d'une ou plusieurs réactions de couplage et/ou cyclisations.

4. Formulation, en particulier solution, suspension ou miniémulsion, contenant au moins un mélange selon la revendication 1 ou 2 et un ou plusieurs solvants.

5. Utilisation d'un mélange selon la revendication 1 ou 2 dans un dispositif électronique.

6. Utilisation d'un composé de formule (3) selon la revendication 1 en tant que matériau de matrice pour un composé phosphorescent.

7. Dispositif électronique, en particulier choisi dans le groupe constitué par des dispositifs organiques électroluminescents, des circuits intégrés organiques, des transistors organiques à effet de champ, des transistors organiques à film mince, des transistors organiques luminescents, des cellules solaires organiques, des cellules solaires organiques sensibilisées par un colorant, des détecteurs optiques organiques, des photorécepteurs organiques, les dispositifs organiques d'extinction de champ, des cellules électrochimiques luminescentes, des diodes laser organiques et des « organic plasmon emitting devices » (dispositifs organiques émetteurs de plasmon), contenant au moins un mélange selon la revendication 1 ou 2.

8. Dispositif électronique selon la revendication 7, **caractérisé en ce que** c'est un dispositif électroluminescent organique et le mélange est utilisé dans une couche émettrice.
